# EUROPEAN PATENT SPECIFICATION

(11) **EP 4 119 633 B1**
(45) Date of publication and mention of the grant of the patent: **12.11.2025**
(21) Application number: 22184315.4
(22) Date of filing: 12.07.2022
(51) Int. Cl.: C09K 11/06, H10K 85/30, H10K 85/60, C07F 15/00

(54) **ORGANOMETALLIC COMPOUND AND ORGANIC LIGHT-EMITTING DEVICE INCLUDING ORGANOMETALLIC COMPOUND**
ORGANOMETALLISCHE VERBINDUNG UND ORGANISCHE LICHTEMITTIERENDE VORRICHTUNG MIT DER ORGANOMETALLISCHEN VERBINDUNG
COMPOSÉ ORGANOMÉTALLIQUE ET DISPOSITIF ORGANIQUE ÉLECTROLUMINESCENT INCLUANT UN COMPOSÉ ORGANOMÉTALLIQUE

(30) Priority: 15.07.2021 KR 20210093136
(43) Date of publication of application: 18.01.2023
(73) Proprietor: Samsung Display Co., Ltd., Yongin-si, Gyeonggi-do 17113 (KR)
(72) Inventor: BAE, Hyejin, 16678 Suwon-si (KR); KIM, Hwangsuk, 16678 Suwon-si (KR); MIN, Minsik, 16678 Suwon-si (KR); PARK, Sangho, 16678 Suwon-si (KR); JEON, Soonok, 16678 Suwon-si (KR); CHUNG, Yeonsook, 16678 Suwon-si (KR); CHOI, Hyesung, 16678 Suwon-si (KR); KIM, Jong Soo, 16678 Suwon-si (KR); CHWAE, Jun, 16678 Suwon-si (KR); CHOI, Hyeonho, 16678 Suwon-si (KR)
(74) Representative: Elkington and Fife LLP

(56) References cited:
- EP-A1- 3 828 190
- US-A1- 2022 081 457

## Description

### FIELD OF THE INVENTION

One or more embodiments relate to an organometallic compound and an organic light-emitting device including the same.

### BACKGROUND OF THE INVENTION

Organic light-emitting devices (OLEDs) are self-emissive devices that, as compared with devices of the related art, have wide viewing angles, high contrast ratios, short response times, and excellent brightness, driving voltage, and response speed characteristics, and produce full-color images.

OLEDs include an anode, a cathode, and an organic layer located between the anode and the cathode, and including an emission layer. A hole transport region may be located between the anode and the emission layer, and an electron transport region may be located between the emission layer and the cathode. Holes provided from the anode may move towards the emission layer through the hole transport region, and electrons provided from the cathode may move towards the emission layer through the electron transport region. The holes and the electrons recombine in the emission layer to produce excitons. The excitons may transition from an excited state to a ground state, thus generating light.

EP 3 828 190 discloses an organometallic compound, an organic light-emitting device including the same and an electronic apparatus including the organic light-emitting device.

### SUMMARY OF THE INVENTION

Provided are an organometallic compound and an organic light-emitting device including the organometallic compound.

Additional aspects will be set forth in part in the detailed description which follows and, in part, will be apparent from the detailed description, or may be learned by practice of the exemplary embodiments of the disclosure.

According to the invention, an organometallic compound is provided in accordance with claim 1.

According to an embodiment, an organic light-emitting device includes a first electrode, a second electrode, and an organic layer located between the first electrode and the second electrode, wherein the organic layer includes an emission layer, and wherein the organic layer further includes at least one organometallic compound.

Another embodiment provides an electronic apparatus including the organic light-emitting device.

### BRIEF DESCRIPTION OF THE DRAWINGS

The above and other aspects and features of one or more exemplary embodiments of the disclosure will be more apparent from the following detailed description taken in conjunction with the accompanying drawings, in which:
FIG. 1 is a schematic cross-sectional view according to one or more embodiments and shows an organic light-emitting device;
FIG. 2 is a graph of wavelength (nanometers (nm)) versus intensity (arbitrary units, a.u.) showing photoluminescence (PL) spectra of organometallic compounds according to one or more exemplary embodiments and Comparative Compounds as described herein; and
FIG. 3 is a graph of wavelength (nm) versus intensity (a.u.) showing electroluminescence (EL) spectra of organometallic devices of Examples 3, 4 and 7 and Comparative Example 1.

### DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the present exemplary embodiments may have different forms and should not be construed as being limited to the detailed descriptions set forth herein. Accordingly, the exemplary embodiments are merely described in further detail below, and by referring to the figures, to explain certain aspects.

The terminology used herein is for the purpose of describing one or more exemplary embodiments only and is not intended to be limiting. As used herein, the singular forms "a," "an," and "the" are intended to include the plural forms as well, unless the context clearly indicates otherwise. As used herein, the term "and/or" includes any and all combinations of one or more of the associated listed items. Expressions such as "at least one of," when preceding a list of elements, modify the entire list of elements and do not modify the individual elements of the list. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

The invention provides an organometallic compound represented by Formula 1: 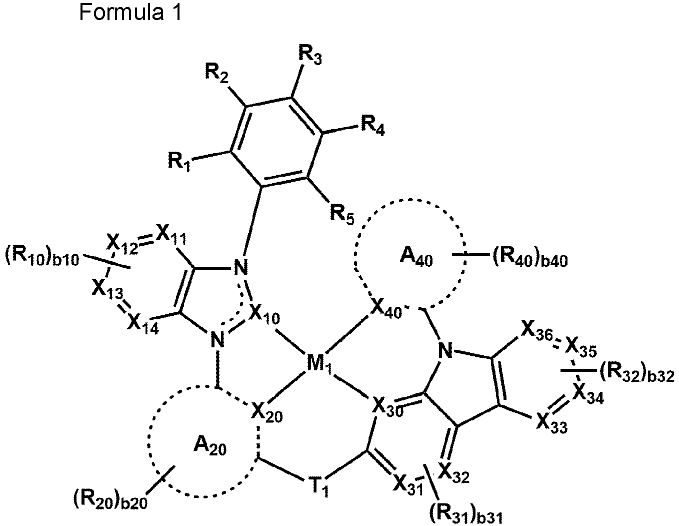 wherein, in Formula 1, M₁ is iridium (Ir), platinum (Pt), osmium (Os), titanium (Ti), zirconium (Zr), hafnium (Hf), europium (Eu), terbium (Tb), thulium (Tm), rhodium (Rh), palladium (Pd), or gold (Au).

In one or more embodiments, M₁ may be platinum (Pt), palladium (Pd), or gold (Au).

In Formula 1, X₁₀ is carbon (C), and X₁₁ to X₁₄, X₂₀, X₃₀ to X₃₆, and X₄₀ are each independently C or nitrogen (N).

In one or more embodiments, X₁₁ to X₁₄ may each be C.

In one or more embodiments, X₂₀ and X₃₀ may each be C, and X₄₀ may be N.

In one or more embodiments, X₃₁ to X₃₆ may each be C.

In Formula 1, two bonds of a bond between X₁₀ and M₁, a bond between X₂₀ and M₁, a bond between X₃₀ and M₁, and a bond between X₄₀ and M₁ may each be a coordinate bond, and the other of two bonds of a bond between X₁₀ and M₁, a bond between X₂₀ and M₁, a bond between X₃₀ and M₁, and a bond between X₄₀ and M₁ may each be a covalent bond. Thus, the organometallic compound represented by Formula 1 may be electrically neutral.

In one or more embodiments, in Formula 1, a bond between X₁₀ and M₁ may be a coordinate bond.

In one or more embodiments, in Formula 1, one bond of a bond between X₂₀ and M₁, a bond between X₃₀ and M₁, and a bond between X₄₀ and M₁ may be a coordinate bond, and the other two bonds of a bond between X₂₀ and M₁, a bond between X₃₀ and M₁, and a bond between X₄₀ and M₁ may each be a covalent bond.

In one or more embodiments, X₂₀ and X₃₀ may each be C, X₄₀ may be N, a bond between X₂₀ and M₁ and a bond between X₃₀ and M₁ may each be a covalent bond, and a bond between X₄₀ and M₁ may be a coordinate bond.

In one or more embodiments, a moiety represented by 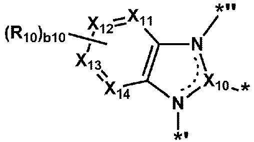
in Formula 1 may be represented by one of Formulae A10-1 to A10-16: 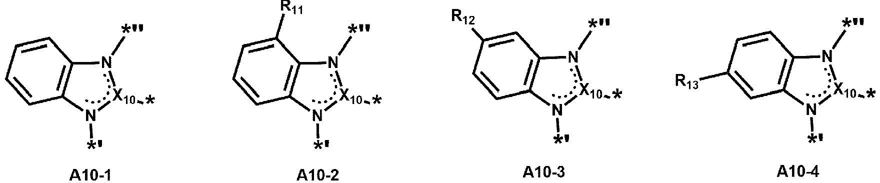 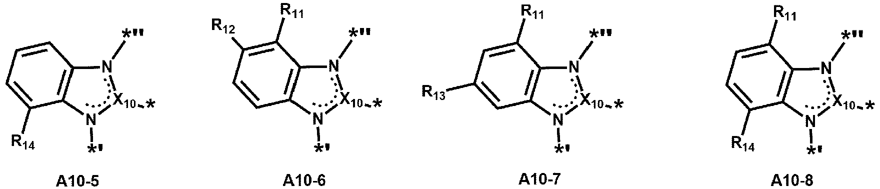 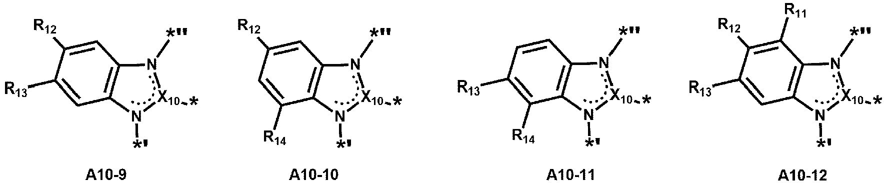 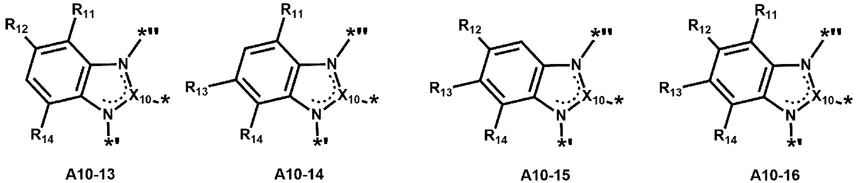
wherein in Formulae A10-1 to A10-16,
   X₁₀ may be understood by referring to the description of X₁₀ provided herein,
   R₁₁ to R₁₄ may each be understood by referring to the description of R₁₀ provided herein, and R₁₁ to R₁₄ may not each be hydrogen,
   * indicates a binding site to M₁ in Formula 1,
   *' indicates a binding site to ring A₂₀ in Formula 1, and
   *" indicates a binding site to a phenyl group in Formula 1.

In Formula 1, ring A₂₀ and ring A₄₀ are each independently a C₅-C₃₀ carbocyclic group or a C₁-C₃₀ heterocyclic group.

For example, ring A₂₀ and ring A₄₀ may each independently be i) a first ring, ii) a second ring, iii) a condensed ring in which at least two first rings are condensed, iv) a condensed ring in which at least two second rings are condensed, or v) a condensed ring in which at least one first ring and at least one second ring are condensed,
the first ring may be a cyclopentane group, a cyclopentadiene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a cyclohexadiene group, a benzene group, a pyridine group, a pyrimidine group, a pyrazine group, a pyridazine group, a triazine group, an oxazine group, a thiazine group, a dihydropyrazine group, a dihydropyridine group, or a dihydroazasilole group.

In one or more embodiments, ring A₂₀ and ring A₄₀ in Formula 1 may each independently be a cyclopentane group, a cyclopentene group, a cyclohexane group, a cyclohexene group, a cyclohexadiene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophenegroup, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, in Formula 1, ring A₂₀ and ring A₄₀ may each independently be a benzene group, a naphthalene group, a carbazole group, a fluorene group, a dibenzosilole group, a dibenzothiophene group, a dibenzofuran group, an azacarbazole group, an azafluorene group, an azadibenzosilole group, an azadibenzothiophene group, an azadibenzofuran group, a pyridine group, a pyrimidine group, a pyrazine group, a pyridazine group, a triazine group, a quinoline group, an isoquinoline group, a quinoxaline group, a quinazoline group, a 5,6,7,8-tetrahydroisoquinoline group, or a 5,6,7,8-tetrahydroquinoline group.

In one or more embodiments, in Formula 1, ring A₂₀ may be represented by one of Formulae A20(1) to A20(15): 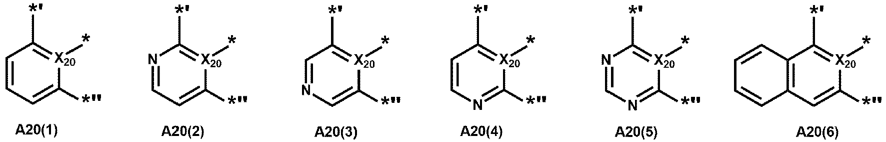 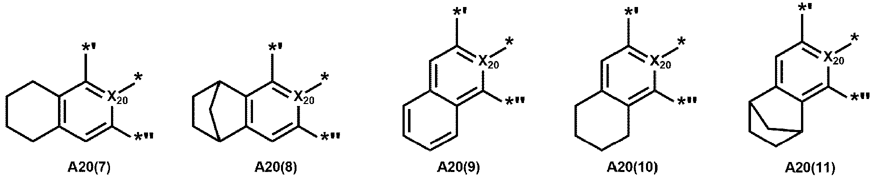 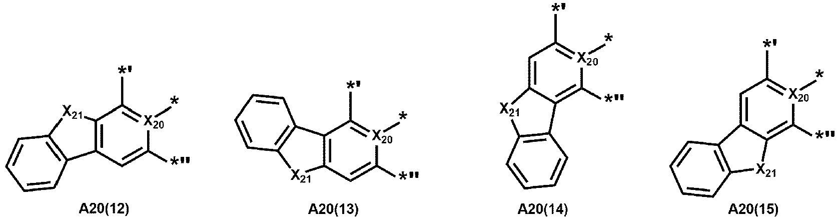 wherein, in Formulae A20(1) to A20(15),
X₂₀ may be C or N,
X₂₁ may be O, S, N(R₂₁), C(R₂₁)(R₂₂), or Si(R₂₁)(R₂₂),
R₂₁ and R₂₂ may each be understood by referring to the description of R₂₀ provided herein,
* indicates a binding site to M₁ in Formula 1,
*' indicates a binding site to N in Formula 1, and
*" indicates a binding site to T₁ in Formula 1.

In one or more embodiments, in Formula 1, ring A₄₀ may be represented by one of Formulae A40(1) to A40(34): 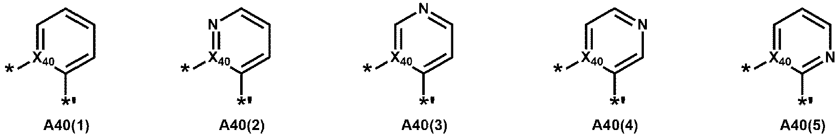 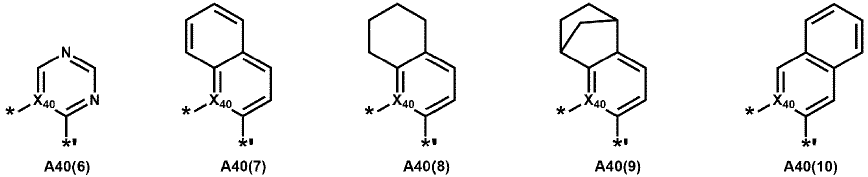 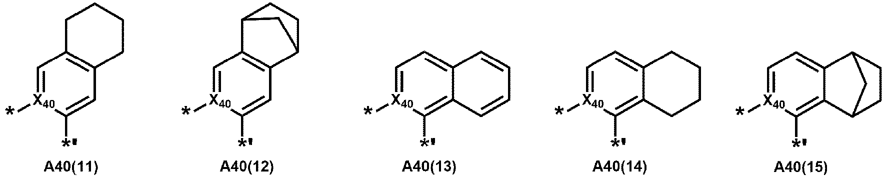 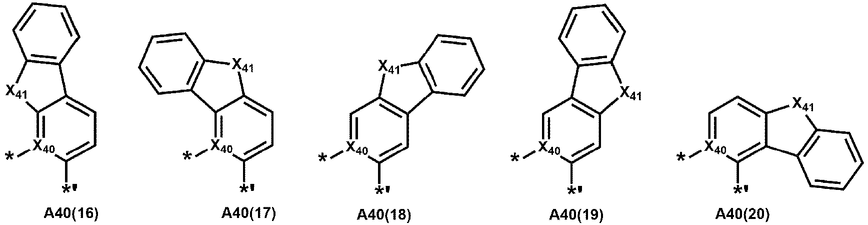 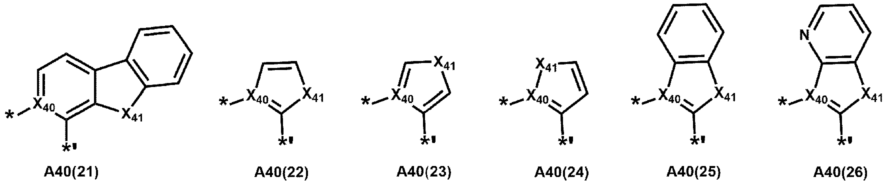 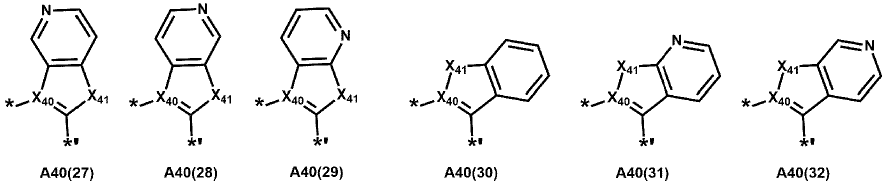 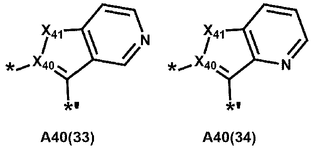 wherein, in Formulae A40(1) to A40(34),
X₄₀ may be C or N,
X₄₁ may be O, S, N(R₄₁), C(R₄₁)(R₄₂), or Si(R₄₁)(R₄₂),
R₄₁ and R₄₂ may each be understood by referring to the description of R₄₀ provided herein,
* indicates a binding site to M₁ in Formula 1, and
*' indicates a binding site to N in Formula 1.

In Formula 1, T₁ is *-N(R₅₁)-*', *-B(R₅₁)-*', *-P(R₅₁)-*', *-C(R₅₁)(R₅₂)-*', *-Si(R₅₁)(R₅₂)-*', *-Ge(R₅₁)(R₅₂)-*', *-S-*', *-Se-*', *-O-*', *-C(=O)-*', *-S(=O)-*', *-S(=O)₂-*', *-C(R₅₁)=C(R₅₂)-*', *-C(=S)-*', or *-C=C-*', wherein * and *' each indicated a binding site to an adjacent atom.

In Formula 1, R₂ and R₄ are each independently a substituted or unsubstituted C₁-C₆₀ alkyl group or a substituted or unsubstituted C₆-C₆₀ aryl group.

In one or more embodiments, R₂ may be:
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a naphthyl group, a fluorenyl group, a phenanthrenyl group, an anthracenyl group, a fluoranthenyl group, a triphenylenyl group, a pyrenyl group, a chrysenyl group, or a combination thereof. In one or more embodiments, a group represented by 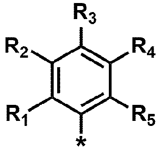
in Formula 1 may be represented by one of Formulae PH-1 to PH-16: 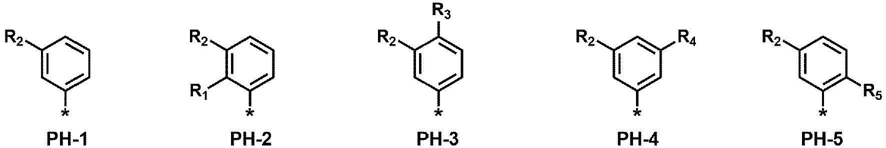 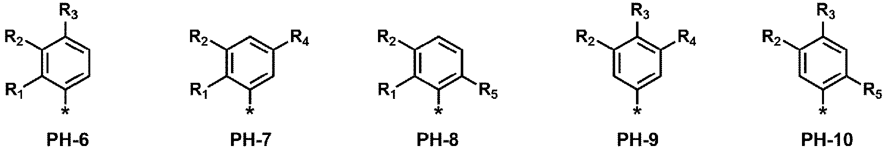 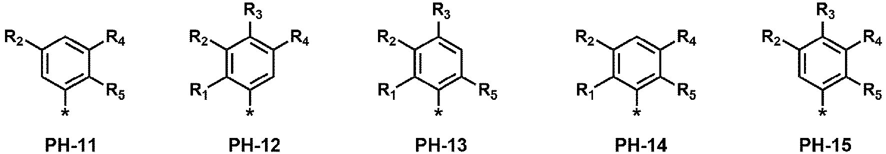 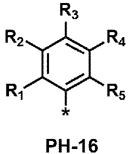
wherein in Formulae PH-1 to PH-16,
   R₂ may be understood by referring to the description of R₂ provided herein,
   R₁ and R₃ to R₅ may respectively be understood by referring to the descriptions of R₁ and R₃ to R₅ provided herein, and R₁ and R₃ to R₅ may each not be hydrogen, and
   * indicates a binding site to an adjacent atom.

In one or more embodiments, a group represented by 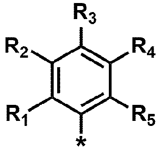 may be represented by Formula PH-1, PH-4, or PH-9, as provided hereinabove.

In one or more embodiments, in Formulae PH-1 to PH-16, R₁ and R₃ to R₅ may each independently be:
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with at least one of deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a naphthyl group, a fluorenyl group, a phenanthrenyl group, an anthracenyl group, a fluoranthenyl group, a triphenylenyl group, a pyrenyl group, a chrysenyl group, or a combination thereof.

In one or more embodiments, in Formula 1, i) R₄ may be hydrogen, or ii) R₄ may be a substituted or unsubstituted C₁-C₆₀ alkyl group or a substituted or unsubstituted C₆-C₆₀ aryl group.

In one or more embodiments, in Formula 1,
i) R₁ and R₃ to R₅ may each be hydrogen,
ii) R₁, R₃, and R₅ may each be hydrogen, and
   R₄ may be:
   a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
   a phenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a naphthyl group, a fluorenyl group, a phenanthrenyl group, an anthracenyl group, a fluoranthenyl group, a triphenylenyl group, a pyrenyl group, a chrysenyl group, or a combination thereof, or
iii) R₁ and R₅ may each be hydrogen, and
   R₃ and R₄ may each independently be:
   a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
   a phenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a naphthyl group, a fluorenyl group, a phenanthrenyl group, an anthracenyl group, a fluoranthenyl group, a triphenylenyl group, a pyrenyl group, a chrysenyl group, or a combination thereof.

In Formula 1, R₁, R₃, R₅, R₁₀, R₂₀, R₃₁, R₃₂, R₄₀, R₅₁, and R₅₂ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), -P(Q₃)(Q₉), or -P(=O)(Q₈)(Q₉).

In Formula 1, two or more of R₁₀, R₂₀, R₃₁, R₃₂, R₄₀, R₅₁, and R₅₂ are optionally bonded to each other to form a substituted or unsubstituted C₅-C₃₀ carbocyclic group or a substituted or unsubstituted C₁-C₃₀ heterocyclic group.

In Formula 1, b10 and b32 indicate the number of R₁₀(s) and R₃₂(s), respectively, and b10 and b32 are each independently an integer from 1 to 4. When b10 is 2 or greater, at least two R₁₀(s) may be identical to or different from each other. When b32 is 2 or greater, at least two R₃₂(s) may be identical to or different from each other.

In Formula 1, b20 and b40 indicate the number of R₂₀(s) and R₄₀(s), respectively, and b20 and b40 are each an integer from 1 to 10. When b20 is 2 or greater, at least two R₂₀(s) may be identical to different from each other. When b40 is 2 or greater, at least two R₄₀(s) may be identical to different from each other.

b31 in Formula 1 indicates the number of R₃₁(s), and b31 is 1 or 2. When b31 is 2, two R₃₁(s) may be identical to or different from each other.

In one or more embodiments, R₁, R₃, R₅, R₁₀, R₂₀, R₃₁, R₃₂, R₄₀, R₃₁, and R₅₂ may each independently be:
hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group or a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each unsubstituted or substituted with at least one of deuterium, -F, -Cl, -Br, -I, - SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, -Si(Q₃₃)(Q₃₄)(Q₃₅), or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, - Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, -Si(Q₃₃)(Q₃₄)(Q₃₅) or a combination thereof; or
-Si(Q₃)(Q₄)(Q₅),
wherein Q₃ to Q₅ and Q₃₃ to Q₃₅ may each independently be a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof.

In Formula 1, at least one of:
R₃₁(s) in the number of b31, or
R₃₂(s) in the number of b32
is:
-F, a cyano group, -CF₃, -CF₂H, -CFH₂, -Si(Q₃)(Q₄)(Q₅), or a group represented by one of Formulae 3-1 to 3-55,
wherein Q₃ to Q₅ are independently a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof: 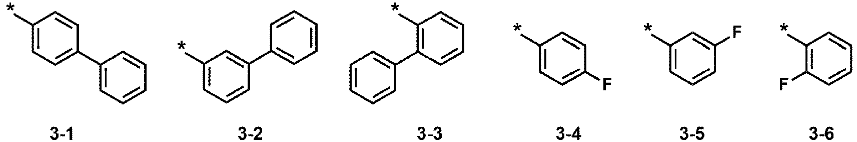 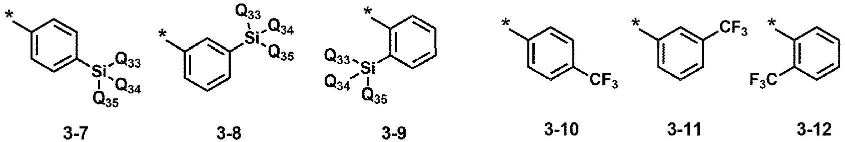 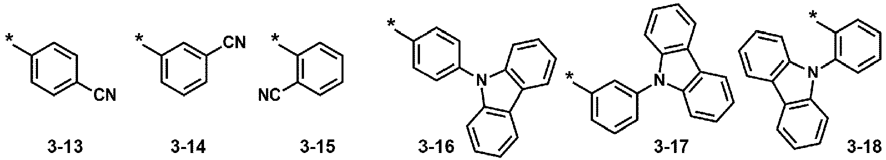 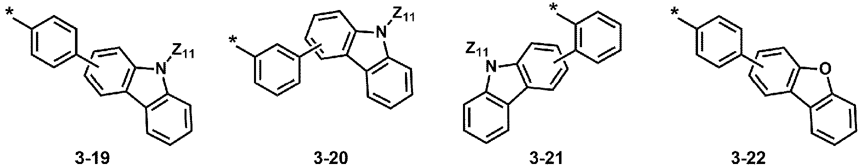 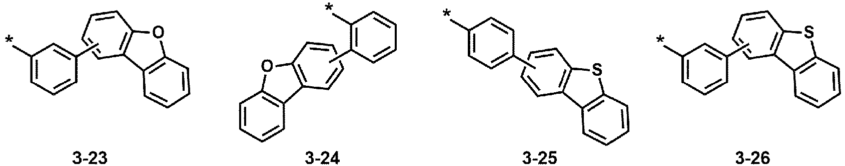 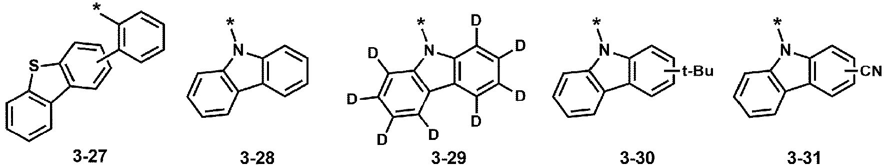 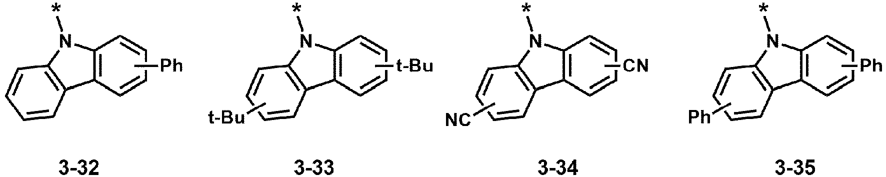 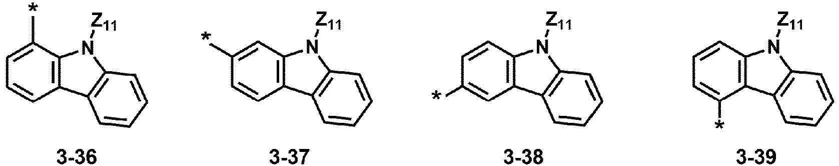 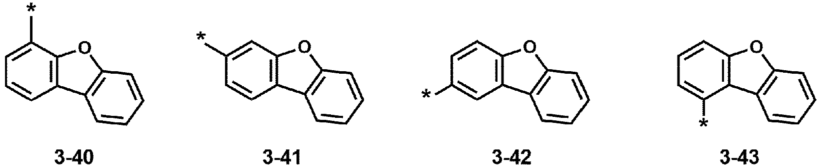 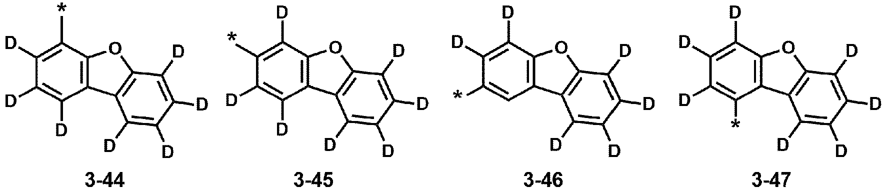 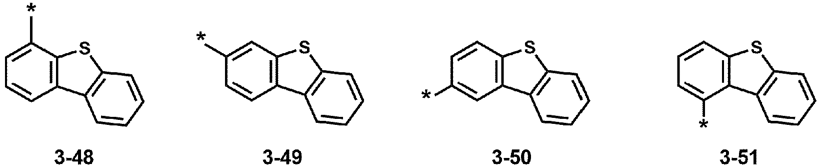 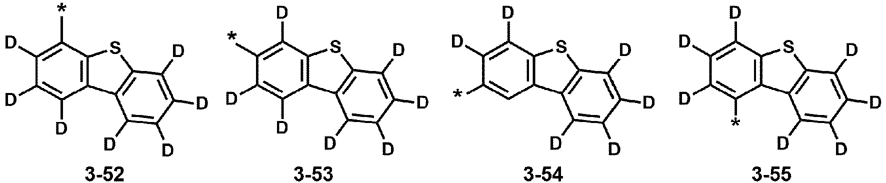
wherein, in Formulae 3-1 to 3-55,
   Q₃₃ to Q₃₅ and Z₁₁ are each a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof,
   "t-Bu" represents a tert-butyl group, "Ph" represents a phenyl group, and
   * indicates a binding site to an adjacent atom.

In one or more embodiments, in Formula 1, the sum of b31 and b32 may be 1.

In one or more embodiments, a moiety represented by 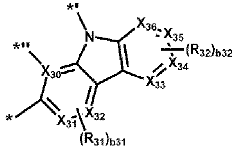
in Formula 1 may be represented by one of Formulae A30(1) to A30(6): 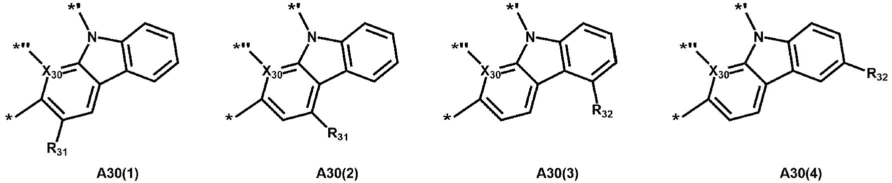 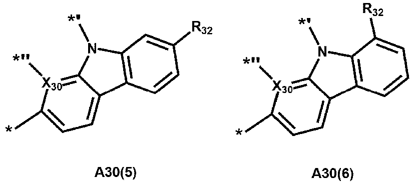
**wherein,** in Formulae A30(1) to A30(6),
   R₃₁, R₃₂, X₃₀, Q₃ to Q₅, and Q₃₃ to Q₃₅ may respectively be understood by referring to the descriptions of R₃₁, R₃₂, X₃₀, Q₃ to Q₅, and Q₃₃ to Q₃₅ provided herein,
   * and *' each indicate a binding site to an adjacent atom, and
   *" indicates a binding site to M₁.

In one or more embodiments, an organometallic compound may be represented by Formula 1A: 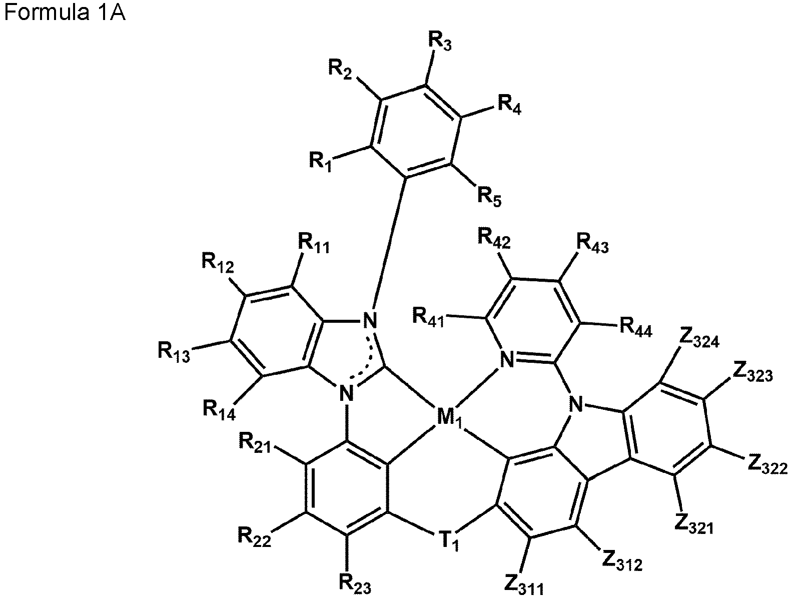 wherein, in Formula 1A,
M₁, T₁, and R₁ to R₅ may respectively be understood by referring to the descriptions of M₁, T₁, and R₁ to R₅ in Formula 1,
R₁₁ to R₁₄ may each independently be understood by referring to the description of R₁₀ in Formula 1,
R₂₁ to R₂₃ may each independently be understood by referring to the description of R₂₀ in Formula 1,
Z₃₁₁ and Z₃₁₂ may each independently be understood by referring to the description of R₃₁ in Formula 1,
Z₃₂₁ to Z₃₂₄ may each independently be understood by referring to the description of R₃₂ in Formula 1,
R₄₁ to R₄₄ may each independently be understood by referring to the description of R₄₀ in Formula 1.

For example, in Formula 1A, T₁ may be "-N(R₅₁)-*', *-B(R₅₁)-*', *-C(R₅₁)(R₅₂)-*', *-Si(R₅₁)(R₅₂)-*', *-Ge(R₅₁)(R₅₂)-*', *-S-*', or *-O-*', wherein * and *' each indicate a binding site to an adjacent atom.

In one or more embodiments, in Formula 1A, R₄₃ may not be hydrogen. For example, in Formula 1A, R₄₃ may be a substituted or unsubstituted C₁-C₆₀ alkyl group or a substituted or unsubstituted C₆-C₆₀ aryl group. R₄₃ may be identical to or different from R₂.

In one or more embodiments, in Formula 1A, R₄₃ may be:
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof, or
a phenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a naphthyl group, a fluorenyl group, a phenanthrenyl group, an anthracenyl group, a fluoranthenyl group, a triphenylenyl group, a pyrenyl group, a chrysenyl group, or a combination thereof.

In the present specification, a substituent of each of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, the substituted monovalent non-aromatic condensed heteropolycyclic group, the substituted C₅-C₃₀ carbocyclic group, and the substituted C₁-C₃₀ heterocyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each unsubstituted or substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), -P(Q₂₈)(Q₂₉), -P(=O)(Q₂₈)(Q₂₉), or a combination thereof;
-N(Q₃₁)(Q₃₂), -Si(Q₃₃)(Q₃₄)(Q₃₅), -B(Q₃₆)(Q₃₇), -P(Q₃₈)(Q₃₉), or - P(=O)(Q₃₈)(Q₃₉); or
a combination thereof,
wherein Q₁ to Q₉, Q₁₁ to Q₁₉, Q₂₁ to Q₂₉, and Q₃₁ to Q₃₉ are each independently: hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a C₂-C₆₀ substituted or unsubstituted alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

In one or more embodiments, the organometallic compound may be one or more of Compounds 1 to 220, 222 to 224, 227, 230, 231, 235, 236, 238, 239, 241, 246, 247, 250, 251, 259, 260, 263, 267, 273, 274, 276, 280 to 297, and 299 to 308, but embodiments are not limited thereto. The remaining compounds are reference compounds:

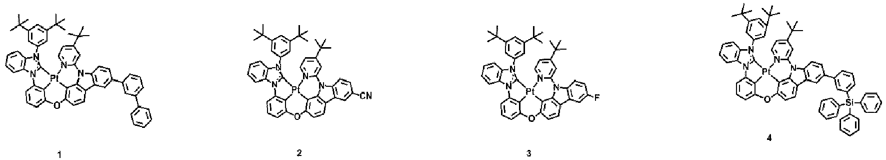

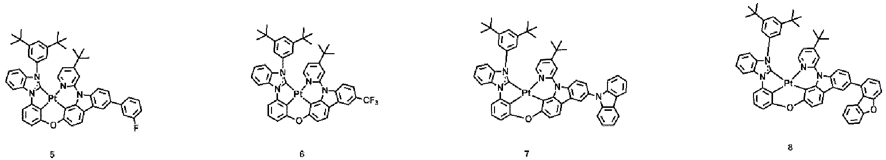

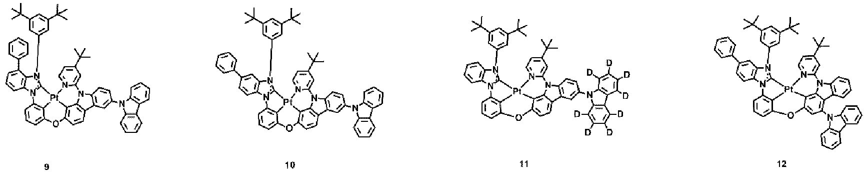

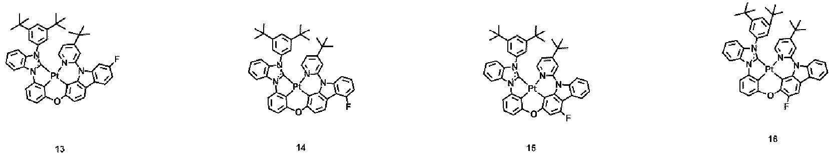

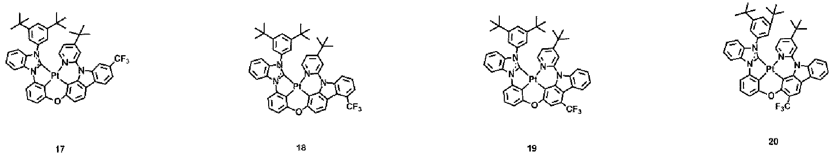

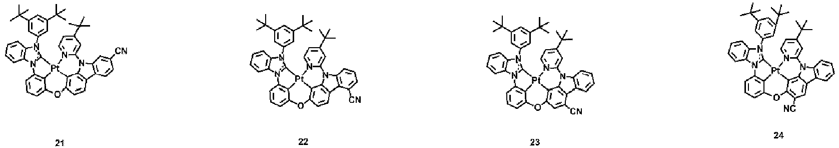

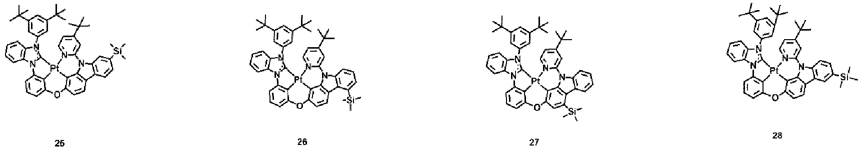

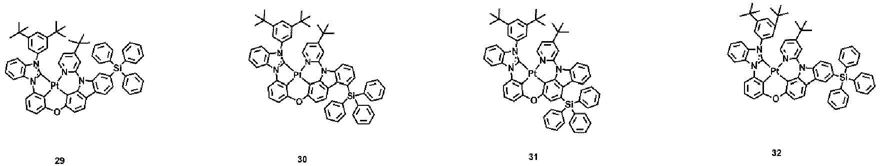

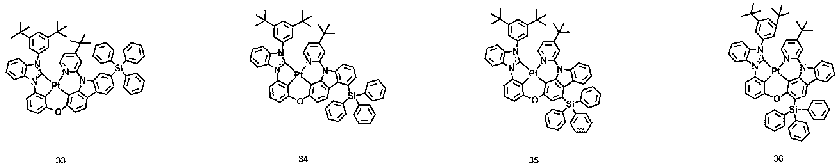

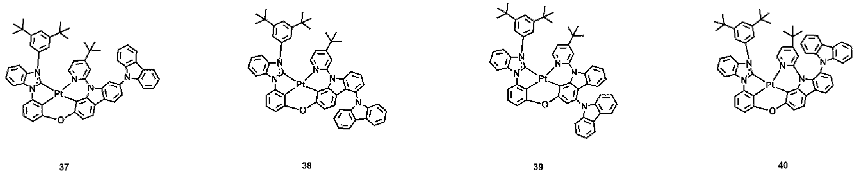

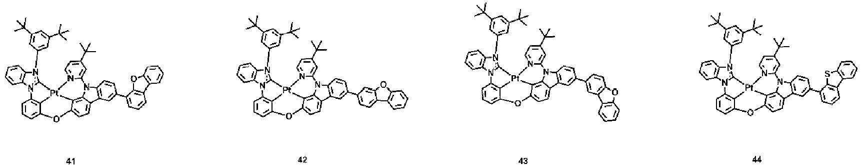

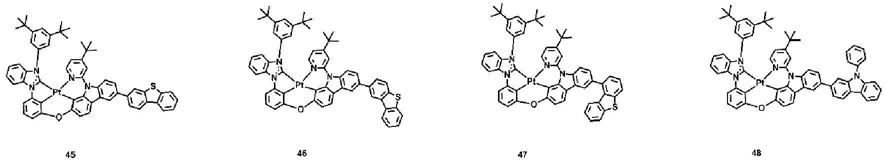

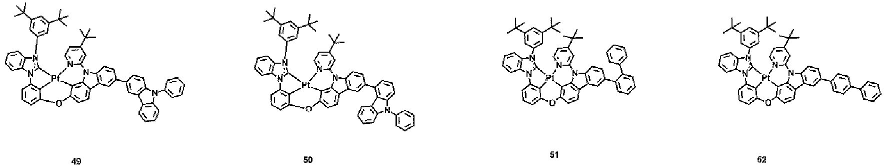

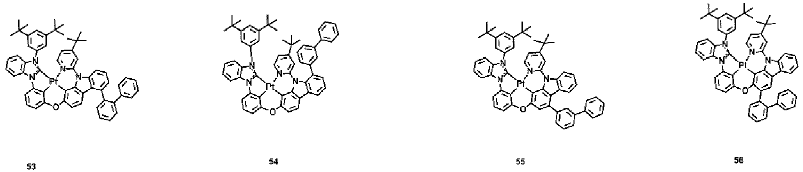

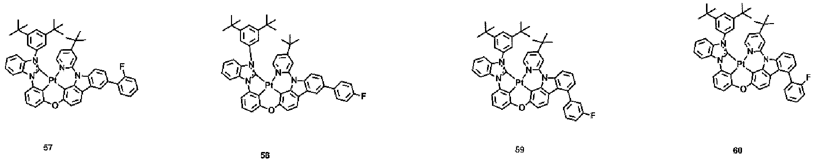

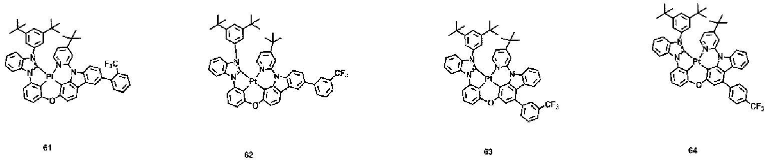

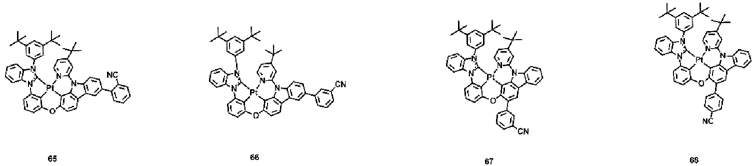

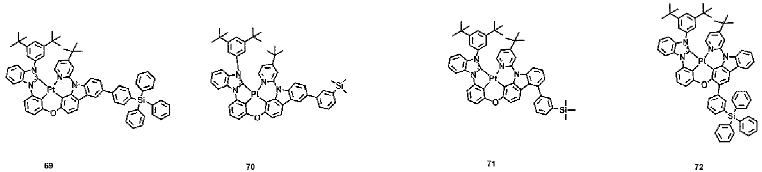

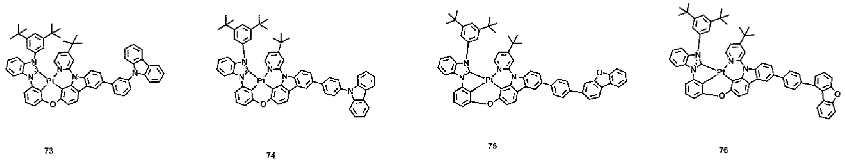

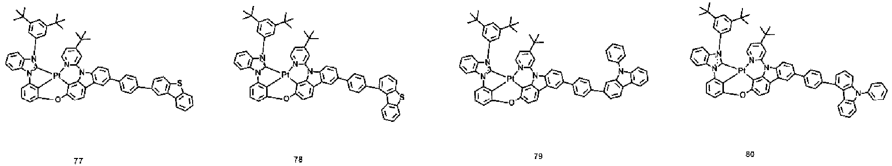

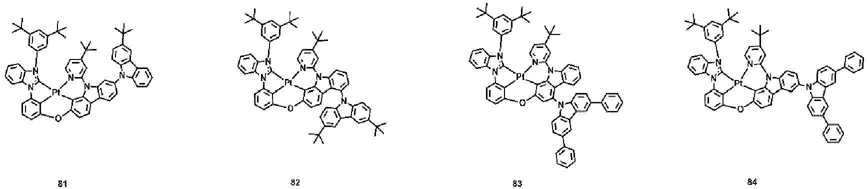

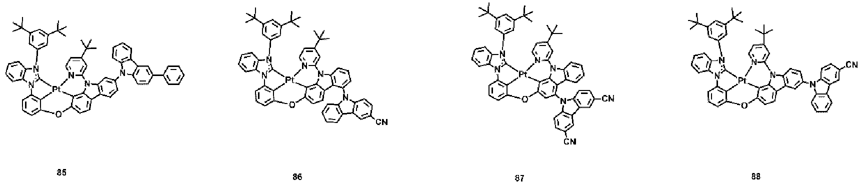

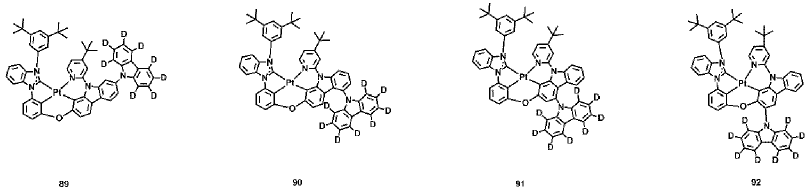

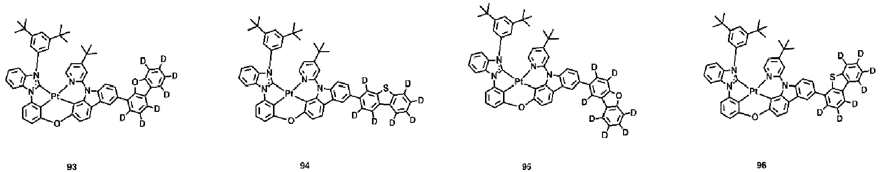

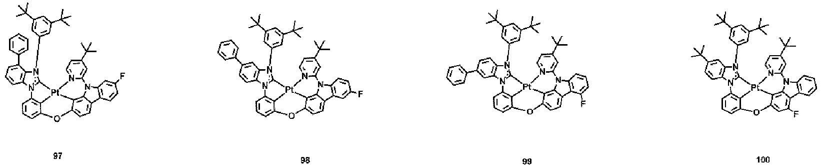

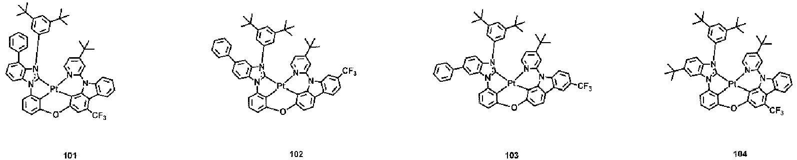

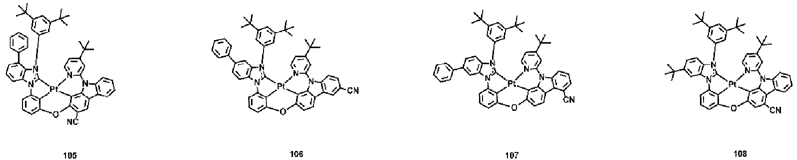

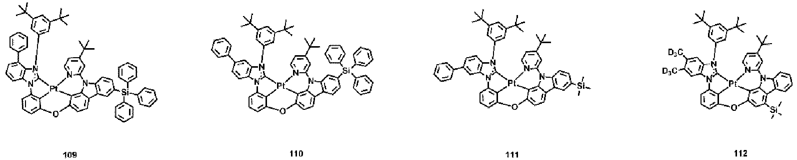

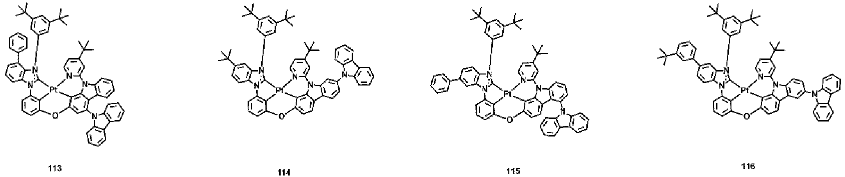

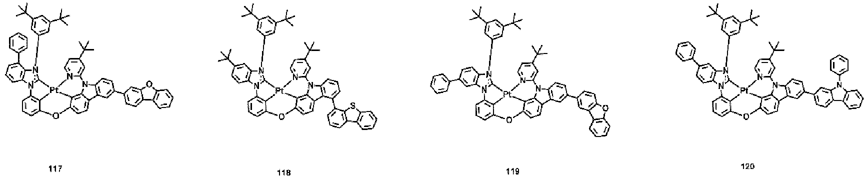

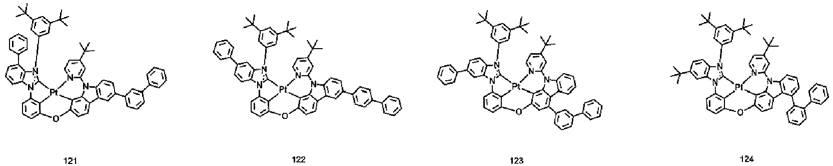

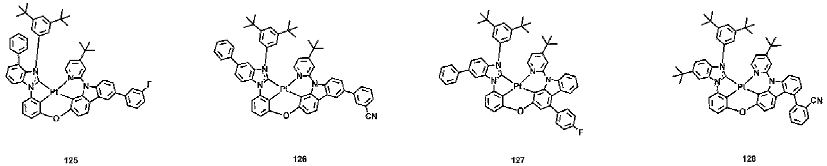

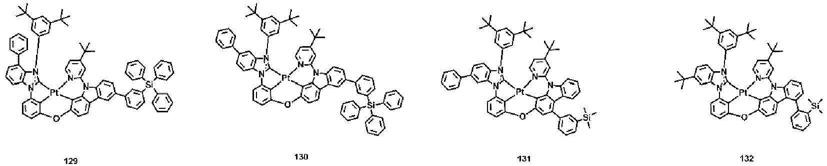

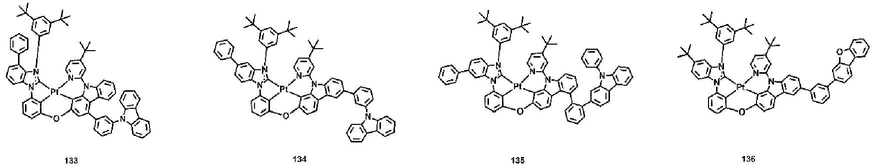

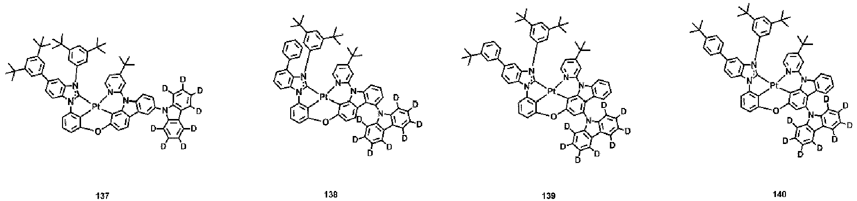

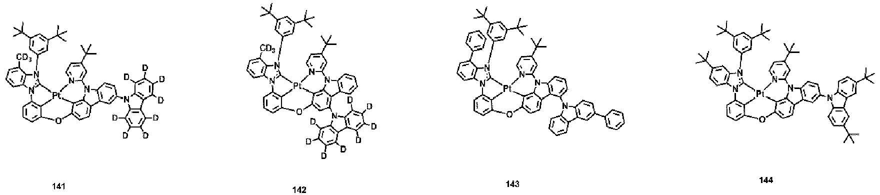

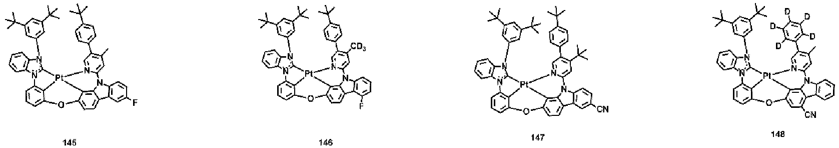

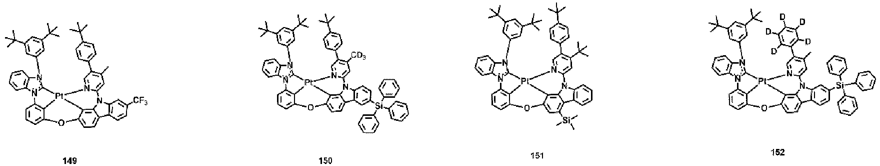

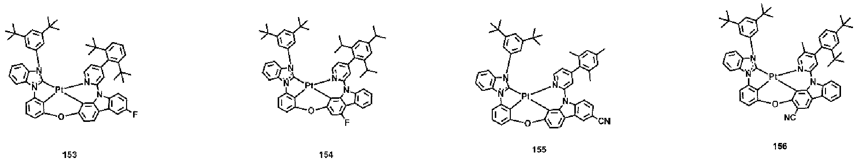

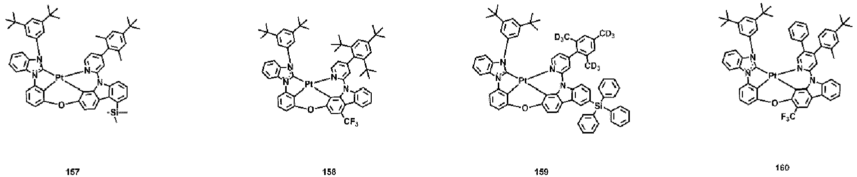

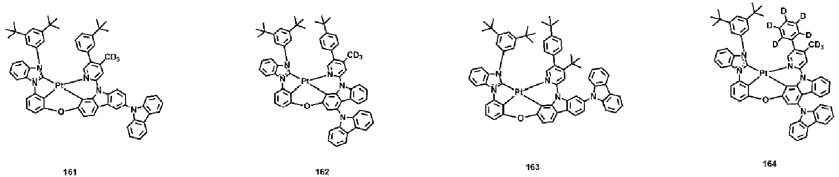

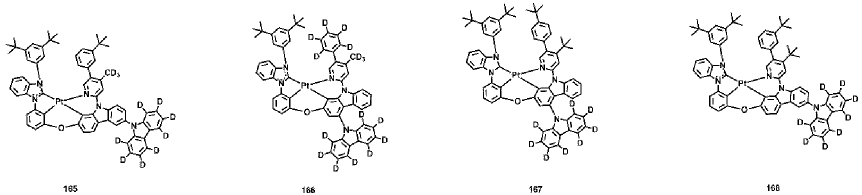

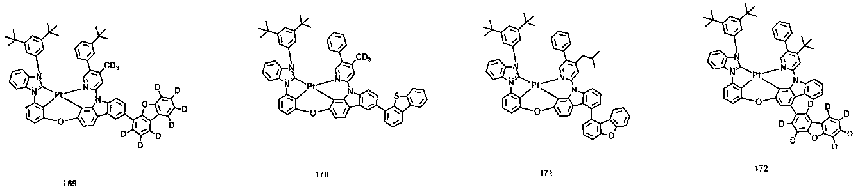

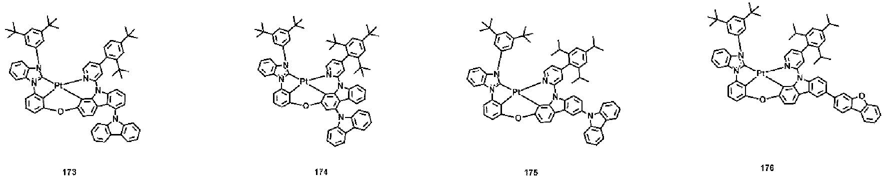

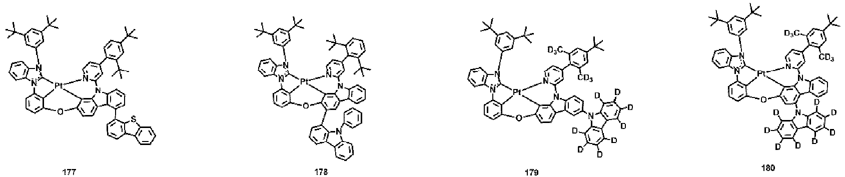

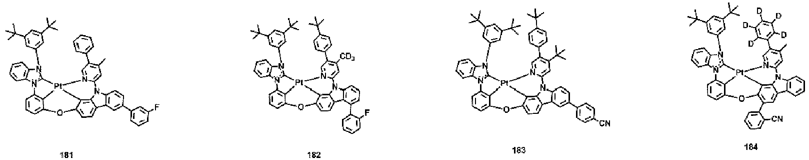

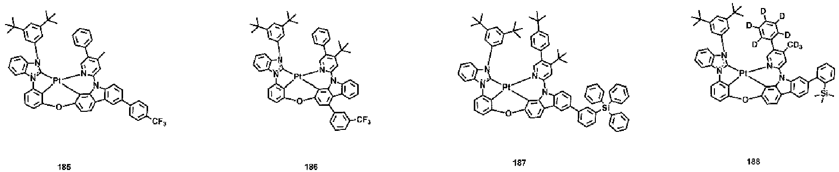

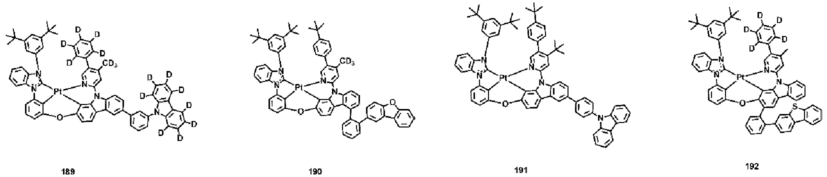

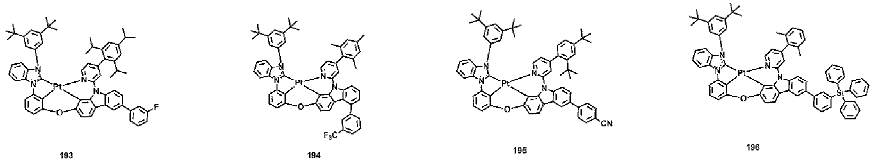

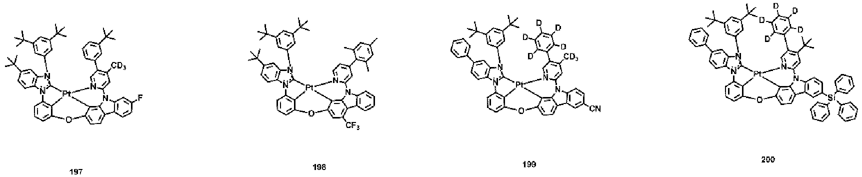

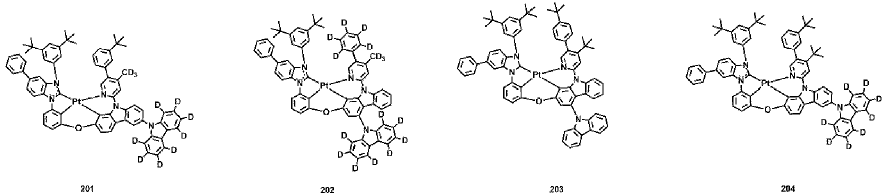

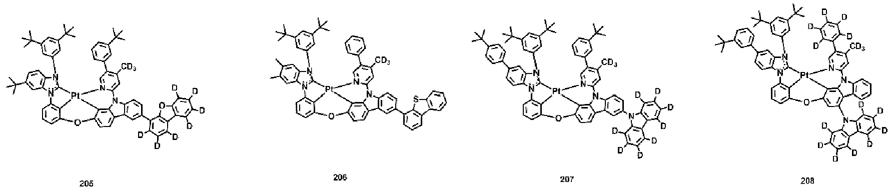

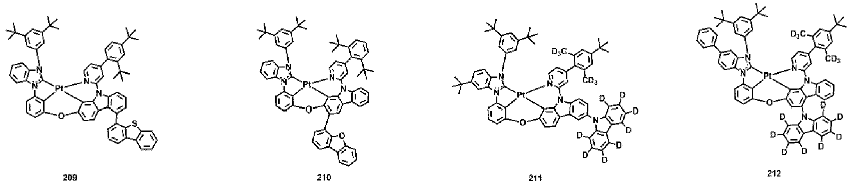

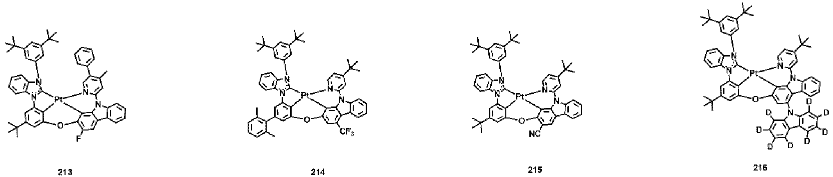

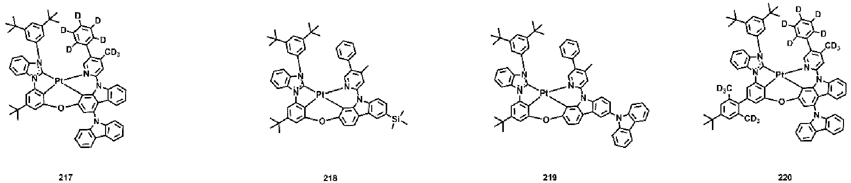

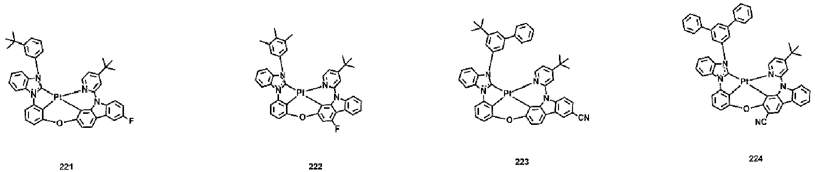

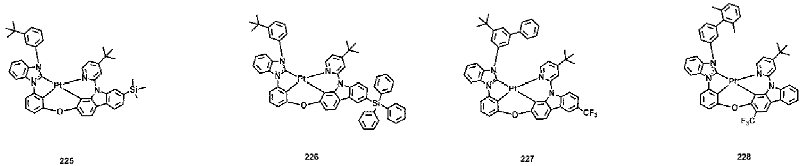

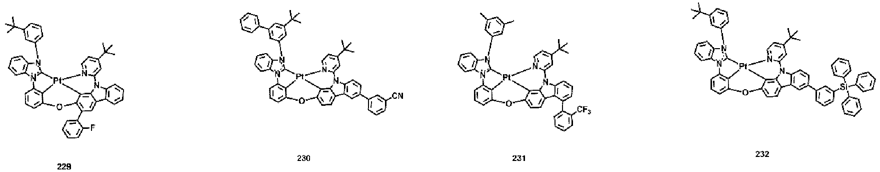

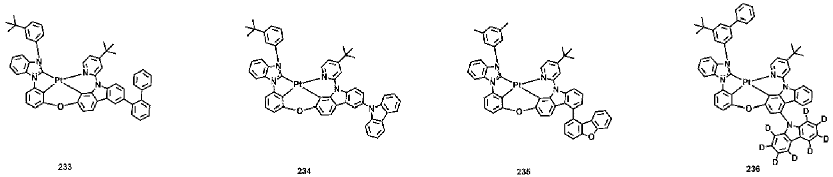

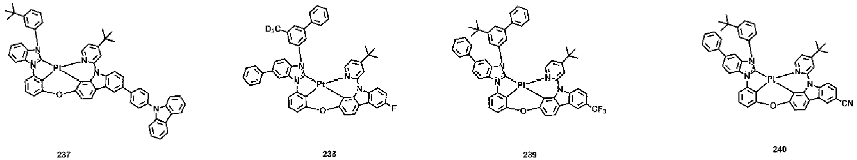

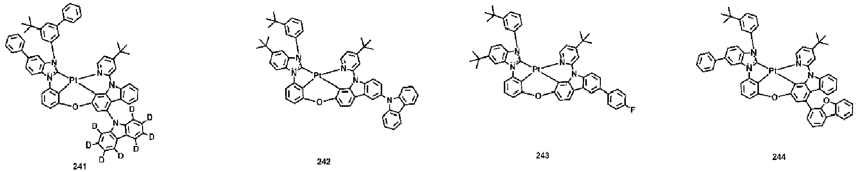

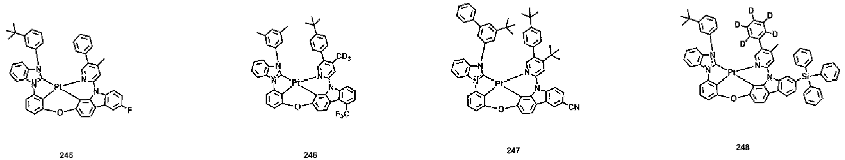

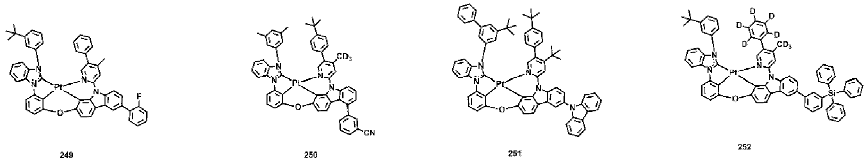

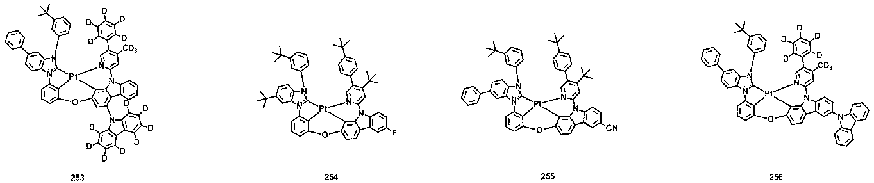

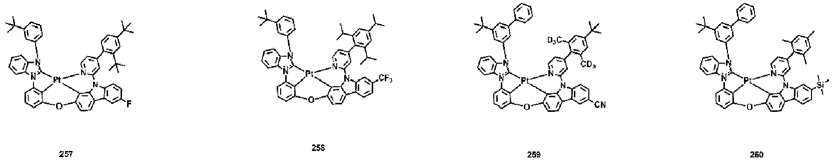

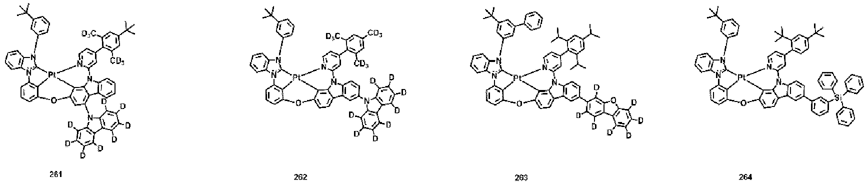

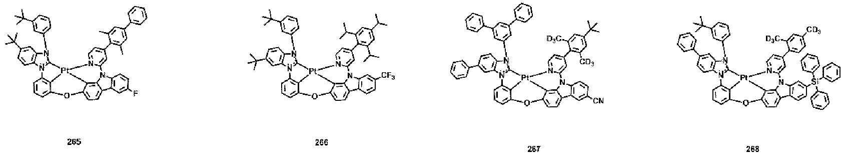

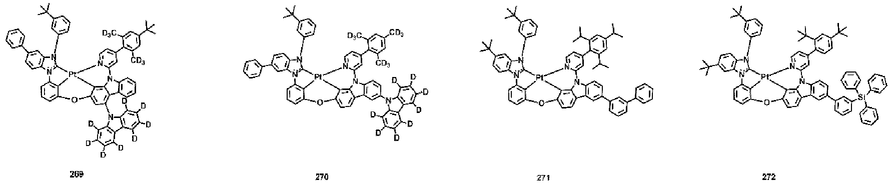

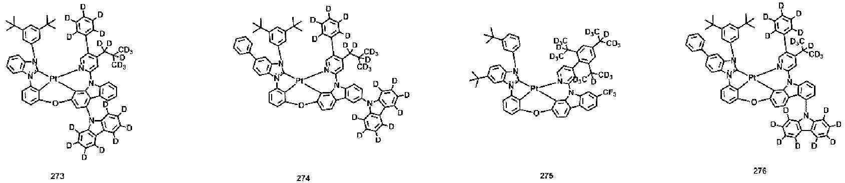

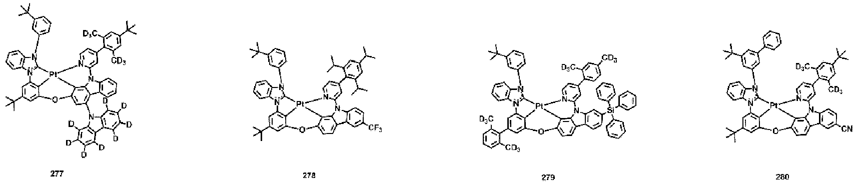

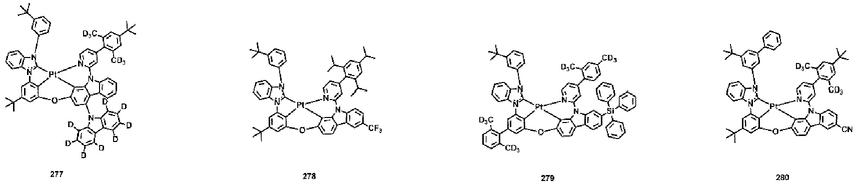

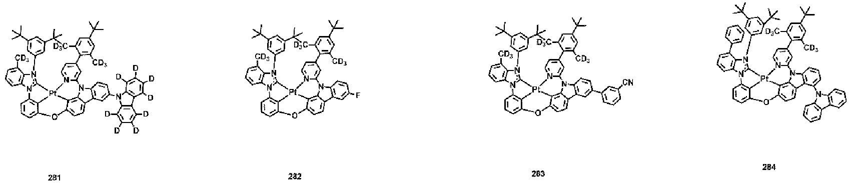

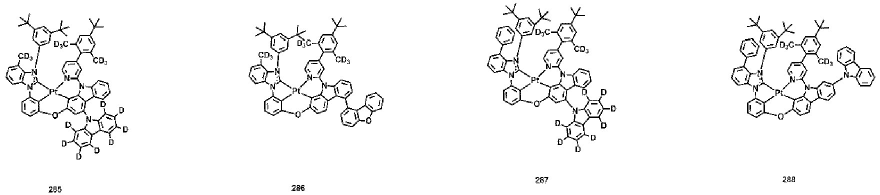

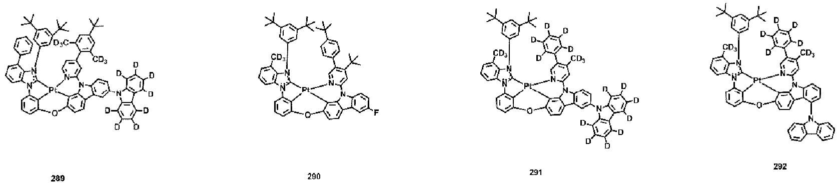

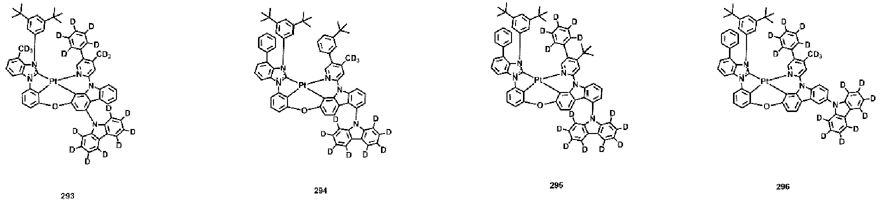

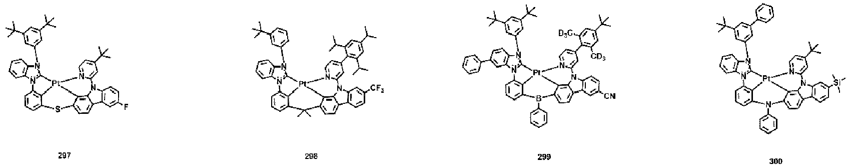

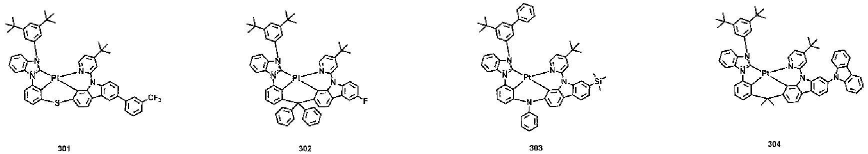

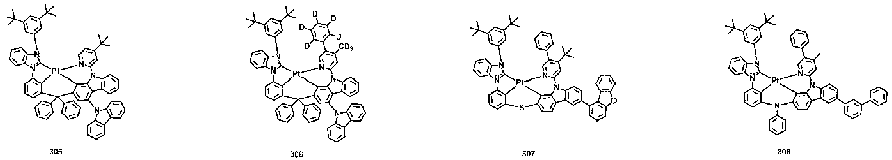

Without wishing to be bound to theory, a substituent R₂ in the organometallic compound represented by Formula 1 may improve luminescence efficiency of the organometallic compound due to inductive effects. When the R₂ position is substituted, a core may be protected by the sterically bulky R₂ substituent, which provides a steric hindrance at this position of the ligand. Thus, quenching of molecules of the organometallic compound may be prevented. Accordingly, when the organometallic compound is included in an electronic device, e.g., an organic light-emitting device, the organic light-emitting device may have improved efficiency and lifespan.

As previously described, the organometallic compound represented by Formula 1 satisfies Condition 1:

### Condition 1

At least one of:
R₃₁(s) in the number of b31, or
R₃₂(s) in the number of b32 in Formula 1
is:
-F, a cyano group, -CF₃, -CF₂H, -CFH₂, -Si(Q₃)(Q₄)(Q₅), or a group represented by one of Formulae 3-1 to 3-55.

The highest occupied molecular orbital (HOMO) may be present around a carbazole-based moiety in a ligand of the organometallic compound, and thus, the carbazole-based moiety may be a position having high reactivity. A substituent other than hydrogen may be introduced to the carbazole-based moiety of the organometallic compound to thereby improve chemical stability of the organometallic compound. In addition, by appropriately varying a type of substituent of the carbazole-based moiety, the HOMO energy level of the organometallic compound may be controlled. Accordingly, an organic light-emitting device including the organometallic compound may have improved driving voltage.

In addition, when the carbazole-based moiety is substituted as described in further detail herein, emitting dipole orientation (EDO) may be controlled in a horizontal direction, and thus, the organic light-emitting device including the organometallic compound may have improved external quantum efficiency.

Since the organometallic compound represented by Formula 1 satisfies Condition 1, the HOMO energy level of the organometallic compound may be controlled, as compared with that of a compound including an unsubstituted alkyl group or an unsubstituted aryl group in the carbazole-based moiety. Accordingly, when a blue light-emitting device includes the organometallic compound as an emitter, the emission wavelength and the energy level may be easily controlled to be proper for the blue light-emitting device.

The HOMO energy level, lowest unoccupied molecular orbital (LUMO) energy level, lowest triplet excited state (T₁) energy level, and maximum emission wavelength (λₘₐₓ, nanometer (nm)) of selected organometallic compounds represented by Formula 1 (Compounds 1 to 12) and Comparative Compound C1 were evaluated by density functional theory (DFT) using the Gaussian 09 program to perform molecular structure optimizations at a B3LYP level. The results thereof are shown in Table 1, where energies are provided in electron Volt (eV).

**Table 1**

| Compound No. | HOMO (eV) | LUMO (eV) | T₁ (eV) | λₘₐₓ (nm) |
|---|---|---|---|---|
| 1 | -4.68 | -1.23 | 2.66 | 466 |
| 2 | -4.92 | -1.50 | 2.68 | 463 |
| 3 | -4.74 | -1.28 | 2.67 | 464 |
| 4 | -4.67 | -1.23 | 2.66 | 466 |
| 5 | -4.72 | -1.29 | 2.66 | 466 |
| 6 | -4.82 | -1.37 | 2.68 | 463 |
| 7 | -4.79 | -1.32 | 2.67 | 464 |
| 8 | -4.72 | -1.28 | 2.66 | 466 |
| 9 | -4.77 | -1.34 | 2.67 | 464 |
| 10 | -4.79 | -1.34 | 2.66 | 466 |
| 11 | -4.79 | -1.32 | 2.67 | 464 |
| 12 | -4.84 | -1.35 | 2.67 | 464 |
| C1 | -4.65 | -1.22 | 2.65 | 467 |

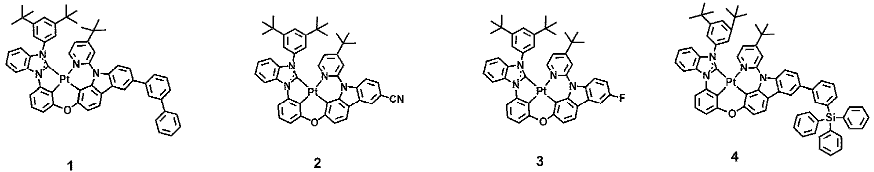

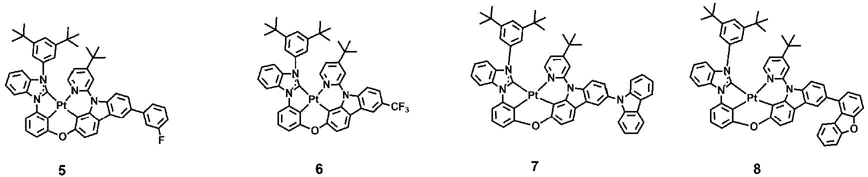

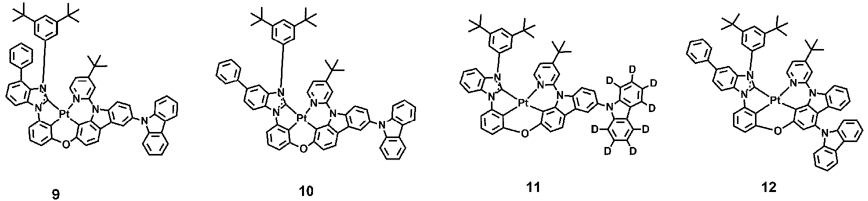

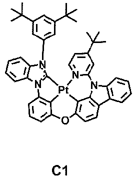

Referring to the results of Table 1, the organometallic compound according to one or more embodiments was found to have a deep HOMO energy level and a high T₁ energy level, as compared with Compound C1. Accordingly, the organometallic compound according to one or more embodiments were found to have blue optical characteristics and electrical characteristics suitable for blue light emission.

A method of synthesizing the organometallic compound represented by Formula 1 may be apparent to one of ordinary skill in the art and by referring to Synthesis Examples provided herein.

The organometallic compound represented by Formula 1 may be suitable for use in an organic layer of an organic light-emitting device, for example, as an emission layer material of the organic layer. Thus, according to another aspect, there is provided an organic light-emitting device that includes: a first electrode; a second electrode; and an organic layer located between the first electrode and the second electrode, wherein the organic layer includes an emission layer, and wherein the organic layer further includes at least one organometallic compound.

The organic light-emitting device may include an organic layer including the organometallic compound represented by Formula 1. Thus, the organic light-emitting device may have excellent driving voltage, excellent external quantum efficiency, emission spectrum having a reduced second peak intensity, and external colorimetric purity.

As used herein, the expression the "(organic layer) includes at least one organometallic compound" may be construed as meaning the "(organic layer) may include one organometallic compound of Formula 1 or two different organometallic compounds of Formula 1".

For example, Compound 1 may only be included in the organic layer as an organometallic compound. In this embodiment, Compound 1 may be included in the emission layer of the organic light-emitting device. In one or more embodiments, Compounds 1 and 2 may be included in the organic layer as organometallic compounds. In this embodiment, Compounds 1 and 2 may both be included in the same layer (for example, both Compounds 1 and 2 may be included in the emission layer).

In one or more embodiments, the at least one organometallic compound may be included in the emission layer of the organic light-emitting device.

In one or more embodiments, the emission layer may further include a host, and an amount of the host in the emission layer may be greater than an amount of the at least one organometallic compound in the emission layer.

The emission layer may emit red light, green light, or blue light. In one or more embodiments, the emission layer may emit blue light having a maximum emission wavelength in a range of about 410 nm to about 490 nm.

In one or more embodiments, the emission layer may include as a first emission layer embodiment or as a second emission layer embodiment as defined below:

### First emission layer embodiment

The emission layer may include the organometallic compound represented by Formula 1, and the organometallic compound may serve as a phosphorescence emitter. For example, a ratio of emission components emitted from the organometallic compound may be about 80 percent (%) or greater, about 85% or greater, about 90% or greater, or about 95% or greater of the total emission components emitted from the emission layer. In other words, at least about 80% or greater, about 85% or greater, about 90% or greater, or about 95% or greater of total emission from the emission layer is emitted from the at least one organometallic compound. Blue light may be emitted from the organometallic compound.

### Second emission layer embodiment

The emission layer may further include, in addition to the organometallic compound represented by Formula 1, a phosphorescent dopant, a fluorescent dopant, or a combination thereof, which is different from the organometallic compound. Here, the organometallic compound may serve, not as a phosphorescence emitter, but as a sensitizer or as an auxiliary dopant. In one or more embodiments, the emission layer may further include a fluorescent dopant, the fluorescent dopant may be different from the organometallic compound, and a ratio of emission components emitted from the fluorescent dopant may be 80% or greater, 85% or greater, 90% or greater, or 95% or greater of the total emission components emitted from the emission layer. In other words, at least about 80 % or greater, 85% or greater, 90% or greater, or 95% or greater of total emission from the emission layer is emitted from the fluorescent dopant.

In the second emission layer embodiment, a content (amount) of the phosphorescent dopant, the fluorescent dopant, or the combination thereof may be in a range of about 1 part to about 100 parts by weight, about 5 parts to about 50 parts by weight, or about 10 parts to about 20 parts by weight, based on 100 parts by weight of the organometallic compound represented by Formula 1.

In the second Embodiment, a total content of the organometallic compound represented by Formula 1 and the phosphorescent dopant, the fluorescent dopant, or the combination thereof may be in a range of about 1 part to about 30 parts by weight, about 3 parts to about 20 parts by weight, or about 5 parts to about 15 parts by weight, based on 100 parts by weight of the emission layer.

A fluorescent dopant that may be used in the second emission layer embodiment may not include a transition metal.

In the second emission layer embodiment, the emission layer may emit fluorescence produced upon transition of triplet excitons of the organometallic compound represented by Formula 1 to the fluorescent dopant.

For example, the fluorescent dopant may include a compound represented by Formula 503-1 or Formula 503-2: 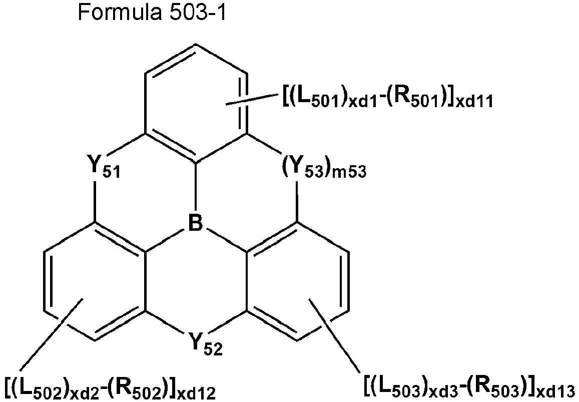 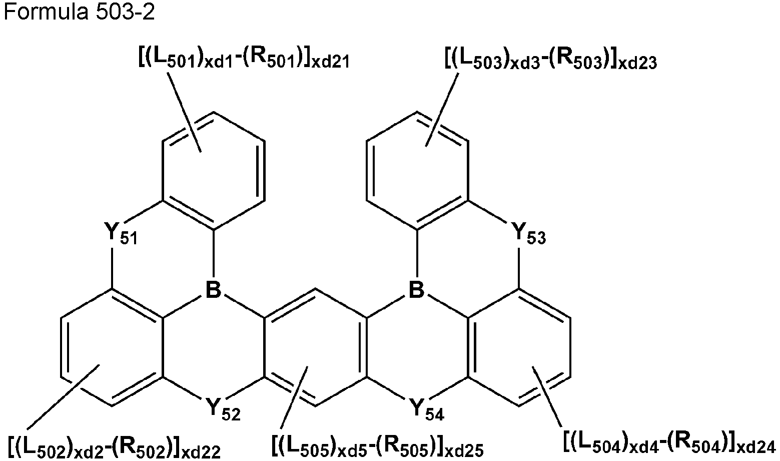 wherein, in Formulae 503-1 and 503-2,
Y₅₁ to Y₅₄ may each independently be a single bond, O, S, N[(L₅₀₆)_{xd6}-R₅₀₆], C[(L₅₀₆)_{xd6}-R₅₀₆][(L₅₀₇)_{xd7}-R₅₀₇], or Si[(L₅₀₆)_{xd6}-R₅₀₆][(L₅₀₇)_{xd7}-R₅₀₇],
m53 may be 0 or 1,
L₅₀₁ to L₅₀₇ may each independently be a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, or a substituted or unsubstituted divalent non-aromatic condensed heteropolycyclic group,
xd1 to xd7 may each independently be 0, 1, 2, or 3,
R₅₀₁ to R₅₀₇ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   when m53 is 0, xd11 and xd13 may each independently be 0, 1, 2, 3, or 4,
      when m53 is 1, xd11 and xd13 may each independently be 0, 1, 2, or 3,
      xd21 and xd23 may each independently be 0, 1, 2, 3, or 4,
      xd12, xd22, and xd24 may each independently be 0, 1, 2, or 3,
      xd25 may be 0, 1, or 2, and
      two or more of R₅₀₁ to R₅₀₇ may optionally be bonded to each other to form a substituted or unsubstituted C₅-C₃₀ carbocyclic group or a substituted or unsubstituted C₁-C₃₀ heterocyclic group.

In one or more embodiments, the first electrode may be anode, which is a hole injection electrode, and the second electrode may be a cathode, which is an electron injection electrode. Alternatively, the first electrode may be a cathode, which is an electron injection electrode, and the second electrode may be an anode, which is a hole injection electrode.

In one or more embodiments, the first electrode may be an anode, the second electrode may be a cathode, and the organic layer may include a hole transport region between the first electrode and the emission layer and an electron transport region between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

For example, the organometallic compound may be included in at least one of the hole transport region and the electron transport region.

The term "organic layer" as used herein refers to a single and/or a plurality of layers between the first electrode and the second electrode in an organic light-emitting device. The "organic layer" may include not only organic compounds but also organometallic complexes including metals.

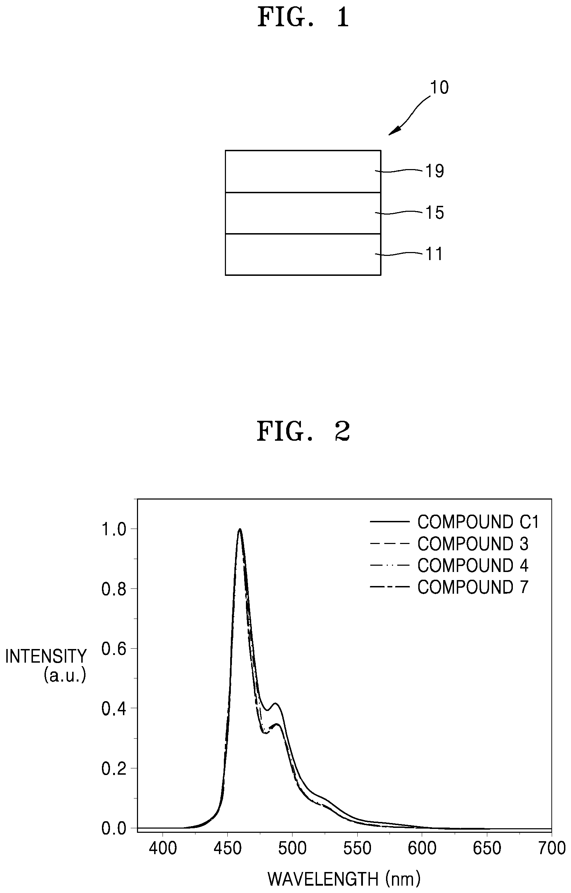

### Description of FIG. 1

FIG. 1 is a schematic cross-sectional view illustrating an organic light-emitting device 10 according to one or more embodiments. Hereinafter, a structure of an organic light-emitting device according to one or more embodiments and a method of manufacturing the organic light-emitting device will be described with reference to FIG. 1.

The organic light-emitting device 10 in FIG. 1 may include a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and/or water repellency.

The first electrode 11 may be produced by depositing or sputtering, onto the substrate, a material for forming the first electrode 11. The first electrode 11 may be an anode. The material for forming the first electrode 11 may be selected from materials with a high work function for easy hole injection.

The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be a metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In one or more embodiments, the first electrode 11 may have a triple-layered structure of ITO/Ag/ITO, but embodiments are not limited thereto.

The organic layer 15 may be on the first electrode 11.

The organic layer 15 may include a hole transport region, an emission layer, and an electron transport region.

The hole transport region may be between the first electrode 11 and the emission layer.

The hole transport region may include at least one selected from a hole injection layer, a hole transport layer, an electron blocking layer, and a buffer layer.

The hole transport region may include a hole injection layer only or a hole transport layer only. In one or more embodiments, the hole transport region may include a hole injection layer and a hole transport layer which are sequentially stacked on the first electrode 11. In one or more embodiments, the hole transport region may include a hole injection layer, a hole transport layer, and an electron blocking layer, which are sequentially stacked in the stated order on the first electrode 11.

When the hole transport region includes a hole injection layer, the hole injection layer may be formed on the first electrode 11 by using one or more suitable methods, such as vacuum deposition, spin coating, casting, and Langmuir-Blodgett (L-B) deposition.

When a hole injection layer is formed by vacuum deposition, for example, the vacuum deposition may be performed at a deposition temperature in a range of about 100°C to about 500°C, at a vacuum degree in a range of about 10⁻⁸ torr to about 10⁻³ torr, and at a deposition rate in a range of about 0.01 angstroms per second (Å/sec) to about 100 Å//sec, although the conditions may vary depending on a compound that is used as a hole injection material and a structure and thermal properties of a desired hole injection layer, but conditions for the vacuum deposition are not limited thereto.

When a hole injection layer is formed by spin coating, the spin coating may be performed at a coating rate in a range of about 2,000 revolutions per minute (rpm) to about 5,000 rpm, and at a temperature in a range of about 80°C to 200°C, to facilitate removal of a solvent after the spin coating, though the conditions may vary depending on a compound that is used as a hole injection material and a structure and thermal properties of a desired hole injection layer, but conditions for the spin coating are not limited thereto.

The conditions for forming a hole transport layer and an electron blocking layer may be inferred from the conditions for forming the hole injection layer.

The hole transport region may include at least one of (4,4',4"-tris(3-methylphenylphenylamino)triphenylamine) (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(naphthalene-1-yl)-N,N'-diphenyl-benzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), (polyaniline)/poly(4-styrenesulfonate) (PANI/PSS), a compound represented by Formula 201, or a compound represented by Formula 202: 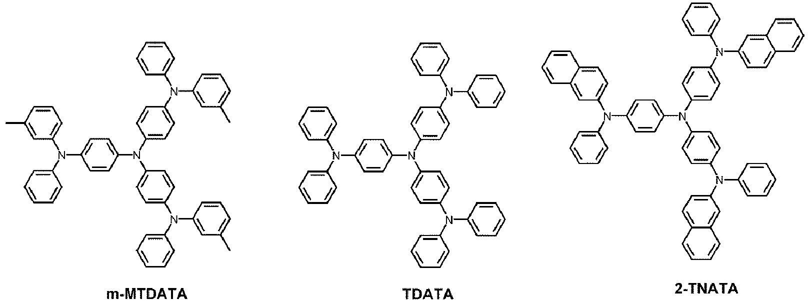 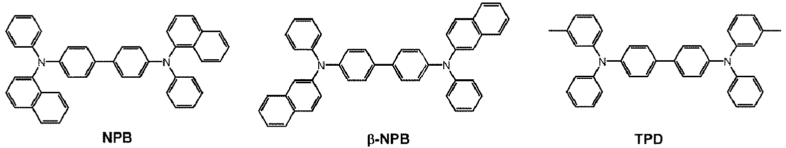 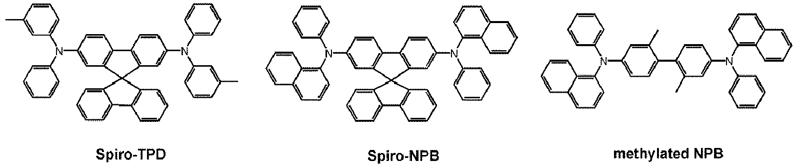 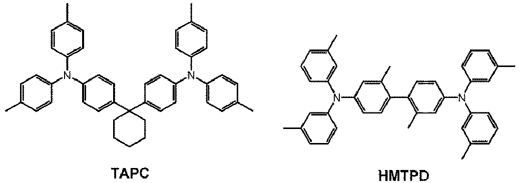 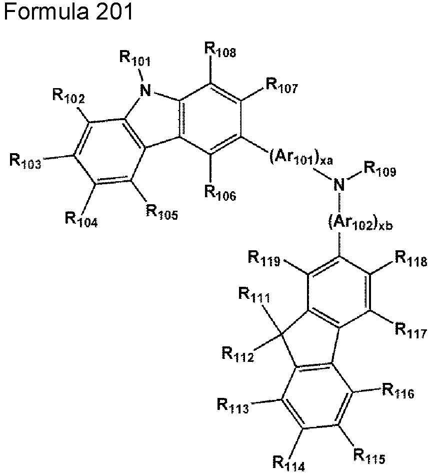 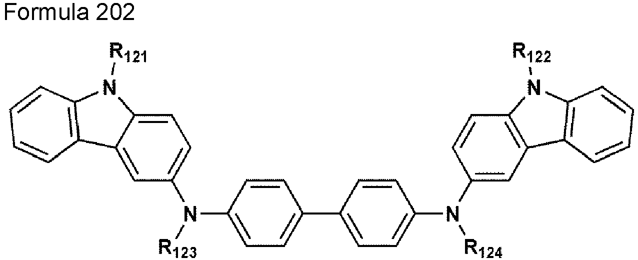 wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a monovalent non-aromatic condensed polycyclic group, a monovalent non-aromatic condensed heteropolycyclic group, or a combination thereof.

In Formula 201, xa and xb may each independently be an integer from 0 to 5. In one or more embodiments, xa and xb may each independently be 0, 1, or 2. In one or more embodiments, xa may be 1, and xb may be 0, but embodiments are not limited thereto.

In Formulae 201 and 202, R₁₀₁ to R₁₀₈, R₁₁₁ to R₁₁₉, and R₁₂₁ to R₁₂₄ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, pentyl group, a hexyl group, or the like), a C₁-C₁₀ alkoxy group (e.g., a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each unsubstituted or substituted with at least one of deuterium, -F, -Cl, -Br, -I, - SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

In Formula 201, R₁₀₉ may be a phenyl group, a naphthyl group, an anthracenyl group, or a pyridinyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₁₀ alkylthio group, a phenyl group, a naphthyl group, an anthracenyl group, a pyridinyl group, or a combination thereof.

In one or more embodiments, the compound represented by Formula 201 may be represented by Formula 201A: 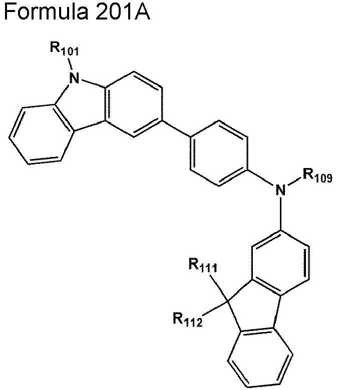 wherein, in Formula 201A, R₁₀₁, R₁₁₁, R₁₁₂, and R₁₀₉ may respectively be understood by referring to the descriptions of R₁₀₁, R₁₁₁, R₁₁₂, and R₁₀₉ provided herein.

In one or more embodiments, the hole transport region may include one of Compounds HT1 to HT20, or a combination thereof:

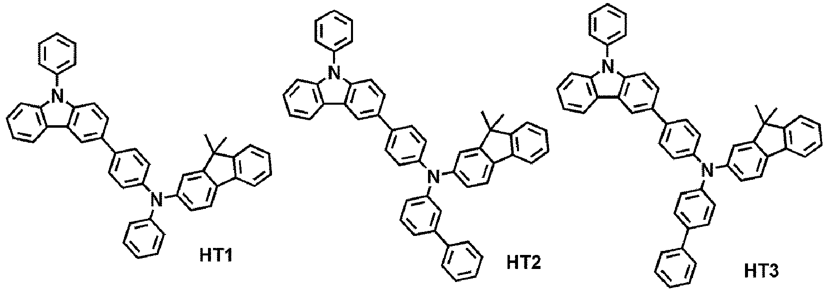

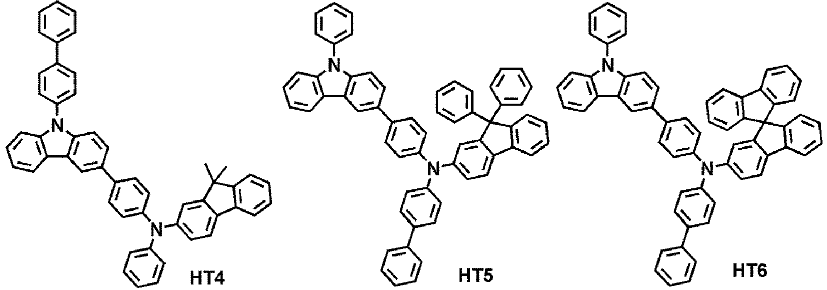

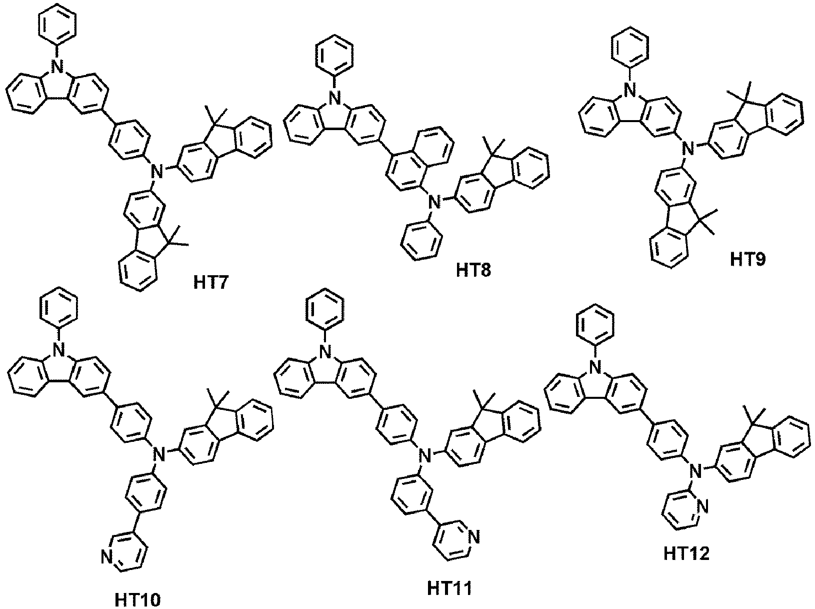

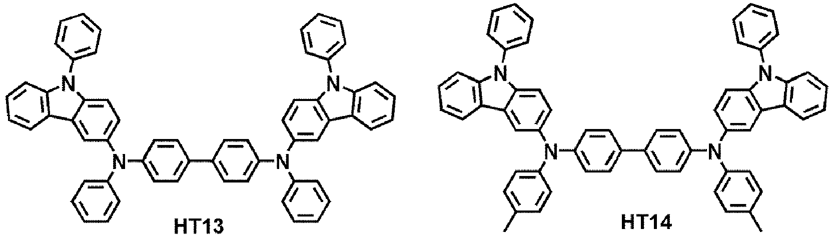

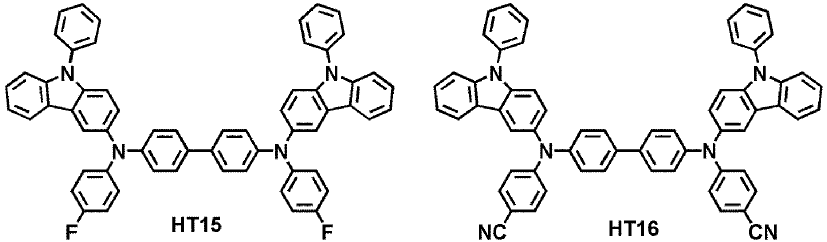

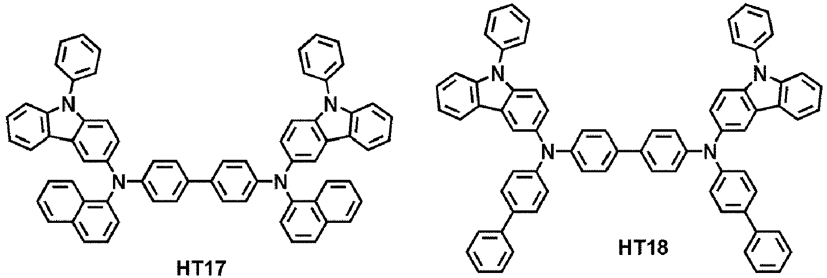

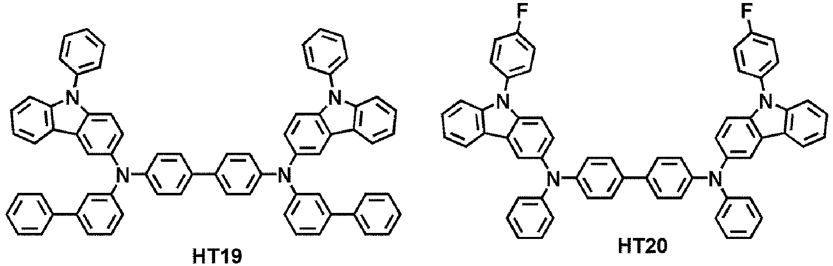

The thickness of the hole transport region may be in a range of about 100 Å (angstrom) to about 10,000 Å, and in one or more embodiments, about 100 Å to about 1,000 Å. When the hole transport region includes at least one of a hole injection layer and a hole transport layer, the thickness of the hole injection layer may be in a range of about 100 Å to about 10,000 Å, and in one or more embodiments, about 100 Å to about 1,000 Å, and the thickness of the hole transport layer may be in a range of about 50 Å to about 2,000 Å, and in one or more embodiments, about 100 Å to about 1,500 Å. When the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may be a quinone derivative, a metal oxide, a compound containing a cyano group, or a combination thereof, but embodiments are not limited thereto. For example, non-limiting examples of the p-dopant include a quinone derivative, such as tetracyanoquinodimethane (TCNQ), 2,3,5,6-tetrafluoro-tetracyano-1,4-benzoquinonedimethane (F4-TCNQ), or F6-TCNNQ; a metal oxide, such as a tungsten oxide or a molybdenum oxide; or a compound containing a cyano group, such as Compound HT-D1 or Compound HT-D2, but embodiments are not limited thereto:

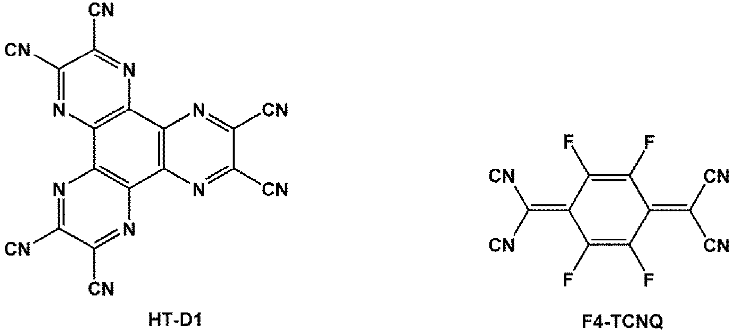

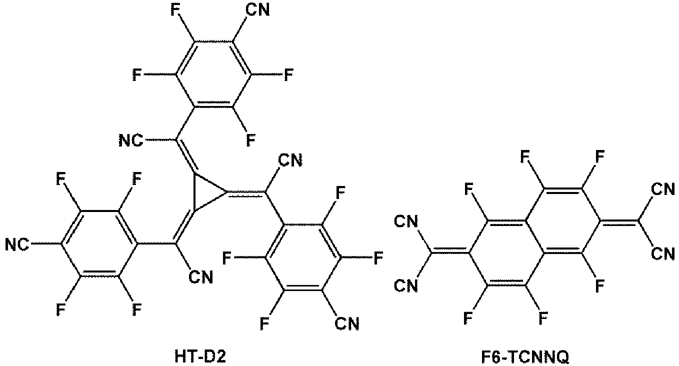

The hole transport region may further include a buffer layer.

The buffer layer may compensate for an optical resonance distance depending on a wavelength of light emitted from the emission layer to improve the efficiency of an organic light-emitting device.

The emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to those conditions for forming a hole injection layer, though the conditions may vary depending on a compound that is used.

The hole transport region may further include an electron blocking layer. The electron blocking layer may include any suitable known material, e.g., mCP, but embodiments are not limited thereto:

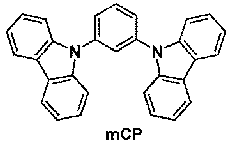

The thickness of the electron blocking layer may be in a range of about 50 Å to about 1,000 Å, and in one or more embodiments, about 70 Å to about 500 A. When the thickness of the electron blocking layer is within any of these ranges, excellent electron blocking characteristics may be obtained without a substantial increase in driving voltage.

When the organic light-emitting device 10 is a full-color organic light-emitting device, the emission layer may be patterned into a red emission layer, a green emission layer, and a blue emission layer. In one or more embodiments, the emission layer may have a structure in which the red emission layer, the green emission layer, and/or the blue emission layer are layered to emit white light. In one or more embodiments, the structure of the emission layer may vary.

The emission layer may include the organometallic compound represented by Formula 1.

The emission layer may include a host and a dopant, and the dopant may include the organometallic compound represented by Formula 1.

The host may include 1,3,5-tri(1-phenyl-1H-benzo[d]imidazol-2-yl)phenyl (TPBi), 3-tert-butyl-9,10-di(naphth-2-yl)anthracene (TBADN), 9,10-di(naphthalene-2-yl)anthracene (ADN, also known as "DNA"), 4,4'-bis(N-carbazolyl)-1,1'-biphenyl (CBP), 4,4'-bis(9-carbazolyl)-2,2'-dimethyl-biphenyl (CDBP), TCP, mCP, Compound H50, Compound H51, Compound H52, or a combination thereof:

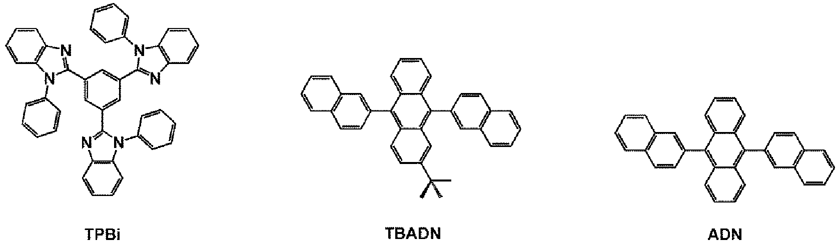

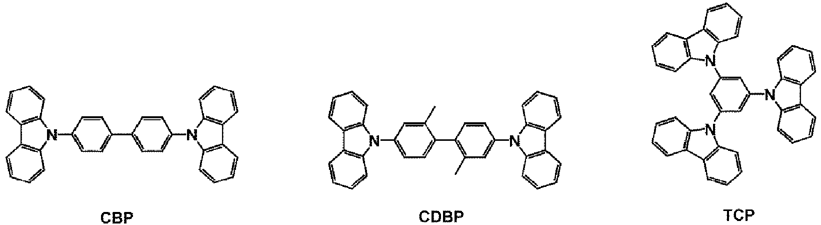

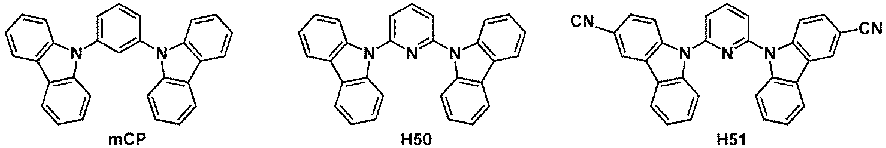

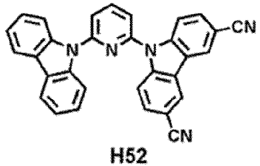

In one or more embodiments, the host may further include a compound represented by Formula 301: 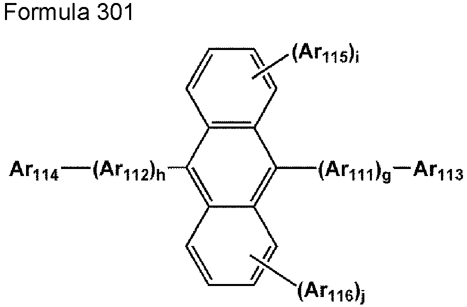 wherein, in Formula 301, Ar₁₁₁ and Ar₁₁₂ may each independently be:
a phenylene group, a naphthylene group, a phenanthrenylene group, or a pyrenylene group; or
a phenylene group, a naphthylene group, a phenanthrenylene group, and a pyrenylene group, each substituted with at least one of a phenyl group, a naphthyl group, an anthracenyl group, or a combination thereof.

In Formula 301, Ar₁₁₃ to Ar₁₁₆ may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, an anthracenyl group, or a combination thereof.

In Formula 301, g, h, i, and j may each independently be 0, 1, 2, 3, or 4, for example, 0, 1, or 2.

In Formula 301, Ar₁₁₃ to Ar₁₁₆ may each independently be:
a C₁-C₁₀ alkyl group substituted with at least one of a phenyl group, a naphthyl group, an anthracenyl group, or a combination thereof;
a phenyl group, a naphthyl group, an anthracenyl group, a pyrenyl group, a phenanthrenyl group, or a fluorenyl group; or
a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, a fluorenyl group, or a combination thereof, or 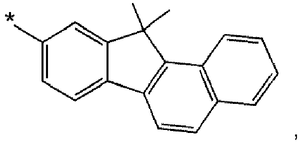 but embodiments are not limited thereto.

In one or more embodiments, the host may include a compound represented by Formula 302:

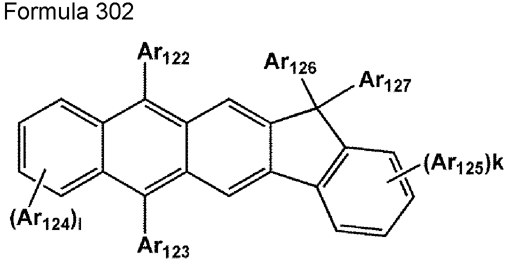

In Formula 302, Ar₁₂₂ to Ar₁₂₅ may each be understood by referring to the description of Ar₁₁₃ in Formula 301.

In Formula 302, Ar₁₂₆ and Ar₁₂₇ may each independently be a C₁-C₁₀ alkyl group, e.g., a methyl group, an ethyl group, or a propyl group.

In Formula 302, k and I may each independently be an integer of 0, 1, 2, 3, or 4. In one or more embodiments, k and I may each be 0, 1, or 2.

When the organic light-emitting device 10 is a full-color organic light-emitting device, the emission layer may be patterned into a red emission layer, a green emission layer, and a blue emission layer. In one or more embodiments, the emission layer may have a structure in which the red emission layer, the green emission layer, and/or the blue emission layer are layered to emit white light. In one or more embodiments, the structure of the emission layer may vary.

When the emission layer includes the host and the dopant, an amount of the dopant may be selected from a range of about 0.01 parts to about 20 parts by weight based on about 100 parts by weight of the emission layer, but embodiments are not limited thereto. When the amount of the dopant is within this range, light emission without quenching may be realized.

In one or more embodiments, the organic layer in organic light-emitting device may further include, in addition to the organometallic compound represented by Formula 1, a phosphorescent dopant or a fluorescent dopant. For example, the organic layer in organic light-emitting device may further include, in addition to the organometallic compound represented by Formula 1, a fluorescent dopant.

In one or more embodiments, the fluorescent dopant may be a condensed polycyclic compound, a styryl-based compound, or a combination thereof.

In one or more embodiments, the fluorescent dopant may include a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a group represented by one of Formulae 501-1 to 501-21, or a combination thereof:

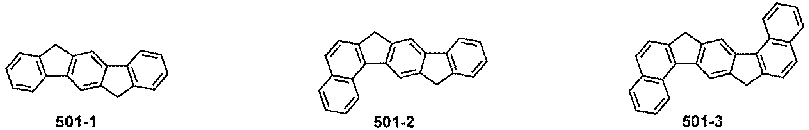

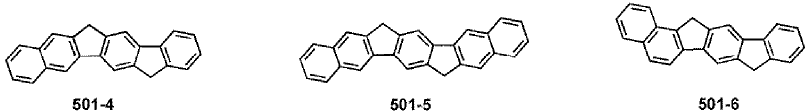

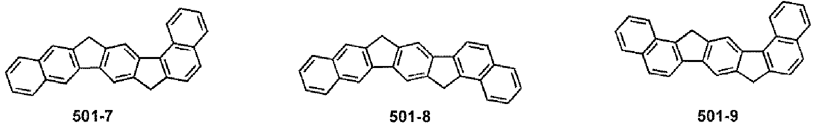

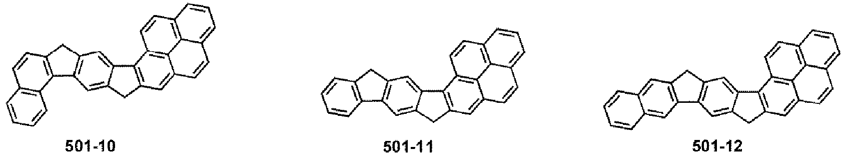

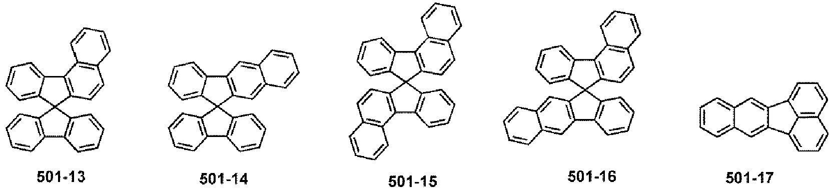

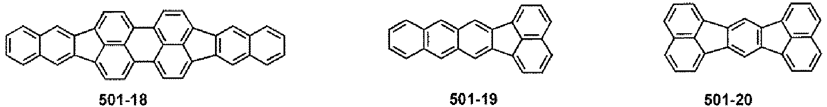

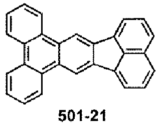

According to one or more embodiments, the fluorescent dopant may include a compound represented by Formula 501: 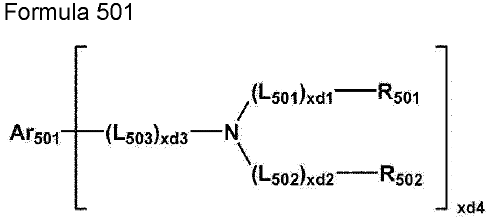 wherein, in Formula 501,
Ar₅₀₁ a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-21; or
naphthalene, fluorene, spiro-bifluorene, benzofluorene, dibenzofluorene, phenanthrene, anthracene, fluoranthene, triphenylene, pyrene, chrysene, naphthacene, picene, perylene, pentaphene, indenoanthracene, tetracene, bisanthracene, or groups represented by Formulae 501-1 to 501-21, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or - Si(Q₅₀₁)(Q₅₀₂)(Q₅₀₃), wherein Q₅₀₁ to Q₅₀₃ may each independently be hydrogen, a C₁-C₆₀ alkyl group, a C₁-C₆₀ alkoxy group, a C₁-C₆₀ alkylthio group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof,
L₅₀₁ to L₅₀₃ may each independently be a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₂-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, or a substituted or unsubstituted divalent non-aromatic condensed heteropolycyclic group,
R₅₀₁ and R₅₀₂ may each independently be:
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd1 to xd3 may each independently be 0, 1, 2, or 3, and
   xd4 may be 0, 1, 2, 3, 4, 5, or 6.

In one or more embodiments, in Formula 501, Ar₅₀₁ may be:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-21; or
naphthalene, fluorene, spiro-bifluorene, benzofluorene, dibenzofluorene, phenanthrene, anthracene, fluoranthene, triphenylene, pyrene, chrysene, naphthacene, picene, perylene, pentaphene, indenoanthracene, tetracene, bisanthracene, or groups represented by Formulae 501-1 to 501-21, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a dibenzofuranyl group, a dibenzothiophenyl group, a carbazolyl group, a pyridinyl group, a pyrimidinyl group, a triazinyl group, a quinolinyl group, an isoquinolinyl group, - Si(Q₅₀₁)(Q₅₀₂)(Q₅₀₃), or a combination thereof, wherein Q₅₀₁ to Q₅₀₃ may each independently be hydrogen, a C₁-C₂₀ alkyl group, a C₁-C₂₀ alkoxy group, a C₁-C₂₀ alkylthio group, a phenyl group, a biphenyl group, a terphenyl group, a naphthyl group, or a combination thereof,
L₅₀₁ to L₅₀₃ may each be understood by referring to the description of L₁ provided herein,
xd1 to xd3 may be each independently 0, 1, or 2, and
xd4 may be 0, 1, 2, or 3, but embodiments are not limited thereto.

In one or more embodiments, the fluorescence dopant may include a compound represented by one of Formulae 502-1 to 502-5: 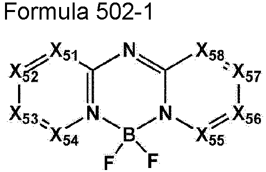 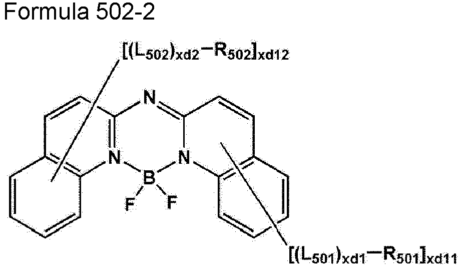 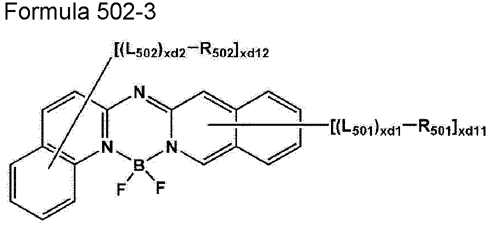 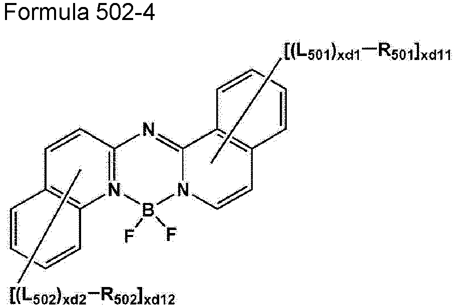 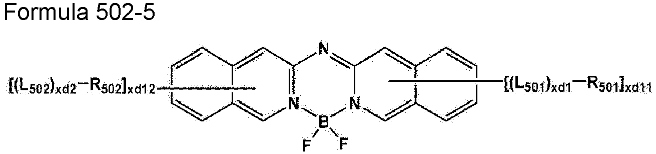 wherein, in Formulae 502-1 to 502-5,
X₅₁ may be N or C-[(L₅₀₁)_{xd1}-R₅₀₁], X₅₂ may be N or C-[(L₅₀₂)_{xd2}-R₅₀₂], X₅₃ may be N or C-[(L₅₀₃)_{xd3}-R₅₀₃], X₅₄ may be N or C-[(L₅₀₄)_{xd4}-R₅₀₄], X₅₅ may be N or C-[(L₅₀₅)_{xd5}-R₅₀₅], X₅₆ may be N or C-[(L₅₀₅)_{xd5}-R₅₀₅], X₅₇ may be N or C-[(L₅₀₇)_{xd7}-R₅₀₇], and X₅₈ may be N or C-[(L₅₀₅)_{xd5}-R₅₀₅],
L₅₀₁ to L₅₀₈ may each be understood by referring to the description of L₅₀₁ in Formula 501,
xd1 to xd8 may each be understood by referring to the description of xd1 in Formula 501,
R₅₀₁ to R₅₀₈ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd11 and xd12 may each independently be 0, 1, 2, 3, 4, or 5,
   two or more of R₅₀₁ to R₅₀₄ may optionally be bonded together to form a substituted or unsubstituted C₅-C₃₀ carbocyclic group or a substituted or unsubstituted C₁-C₃₀ heterocyclic group, and
   two or more of R₅₀₅ to R₅₀₈ may optionally be bonded together to form a substituted or unsubstituted C₅-C₃₀ carbocyclic group or a substituted or unsubstituted C₁-C₃₀ heterocyclic group.

In one or more embodiments, the fluorescent dopant may include a compound represented by Formula 503-1 or Formula 503-2: 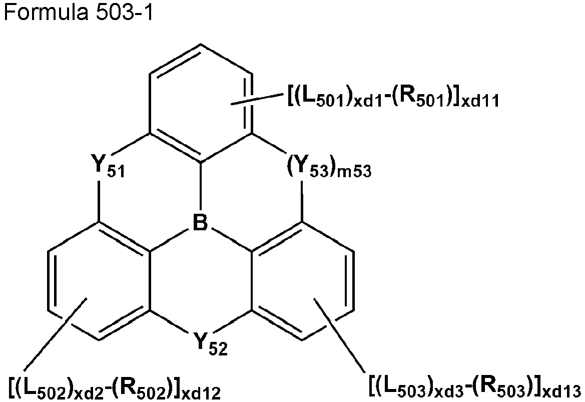 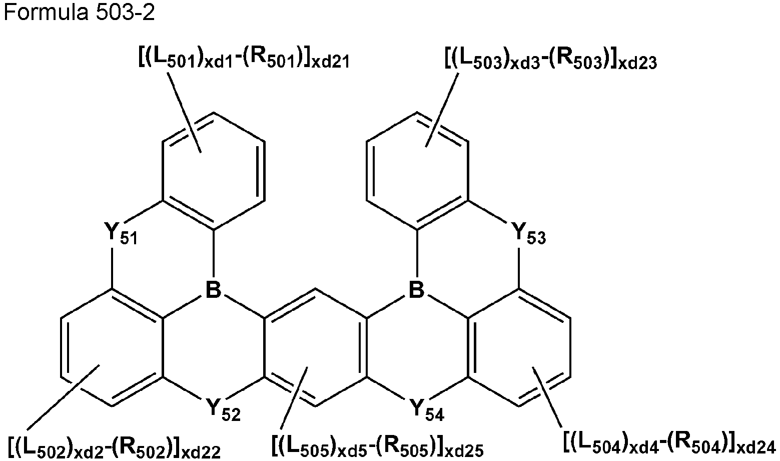 wherein, in Formulae 503-1 and 503-2,
Y₅₁ to Y₅₄ may each independently be a single bond, O, S, N[(L₅₀₆)_{xd6}-R₅₀₆], C[(L₅₀₆)_{xd6}-R₅₀₆][(L₅₀₇)_{xd7}-R₅₀₇], or Si[(L₅₀₆)_{xd6}-R₅₀₆][(L₅₀₇)_{xd7}-R₅₀₇],
m53 may be 0 or 1,
L₅₀₁ to L₅₀₇ may each be understood by referring to the description of L₅₀₁ in Formula 501,
xd1 to xd7 may each be understood by referring to the description of xd1 in Formula 501,
R₅₀₁ to R₅₀₇ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   when m53 is 0, xd11 and xd13 may each independently be 0, 1, 2, 3, or 4,
   when m53 is 1, xd11 and xd13 may each independently be 0, 1, 2, or 3,
   xd21 and xd23 may each independently be 0, 1, 2, 3, or 4,
   xd12, xd22, and xd24 may each independently be 0, 1, 2, or 3,
   xd25 may be 0, 1, or 2, and
   two or more of R₅₀₁ to R₅₀₇ may optionally be bonded to each other to form a substituted or unsubstituted C₅-C₃₀ carbocyclic group or a substituted or unsubstituted C₁-C₃₀ heterocyclic group.

The fluorescent dopant may include, for example, Compounds FD(1) to FD(16), Compounds FD1 to FD17, or a combination thereof:

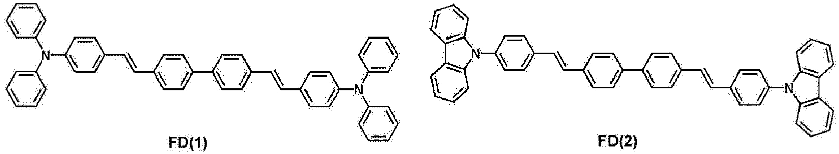

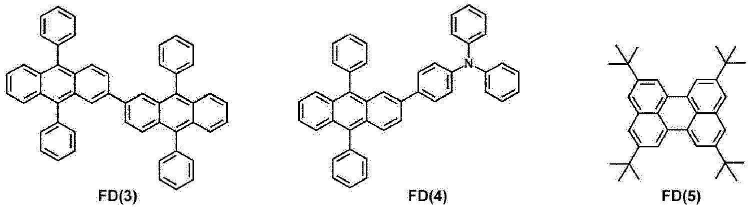

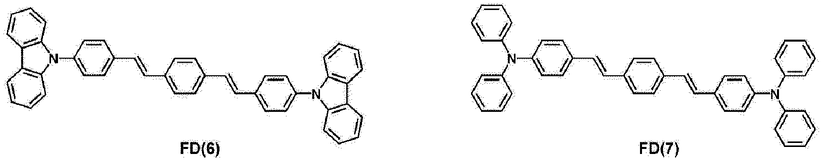

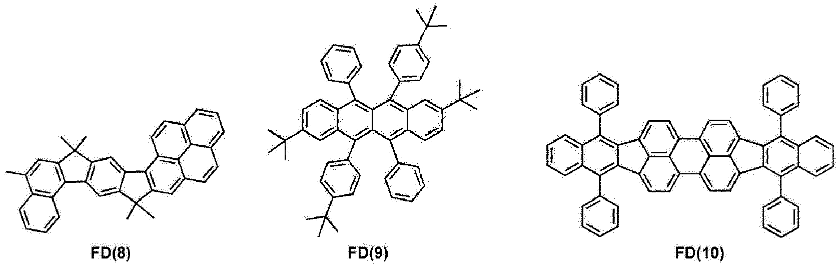

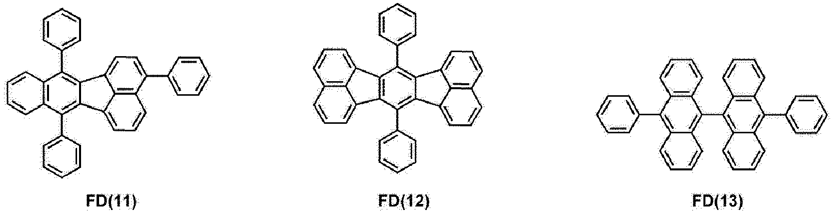

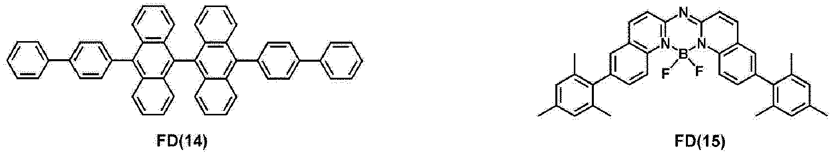

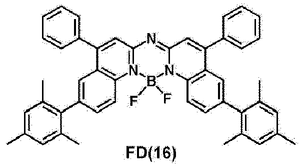

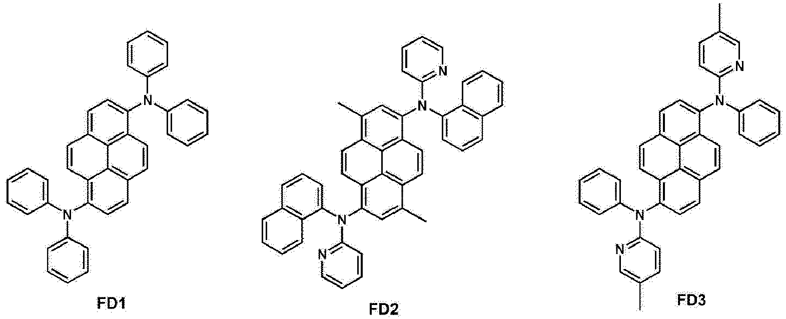

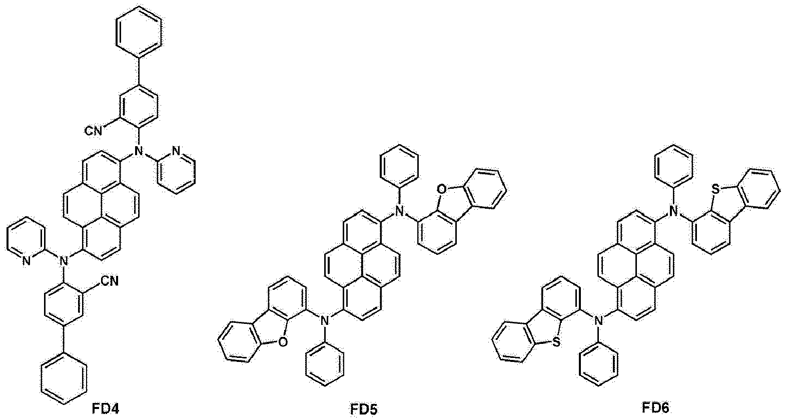

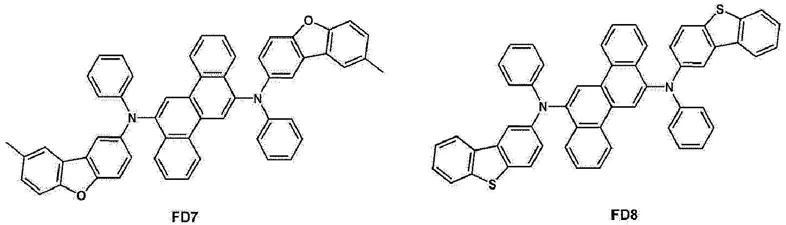

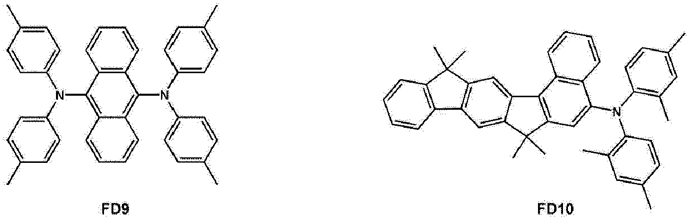

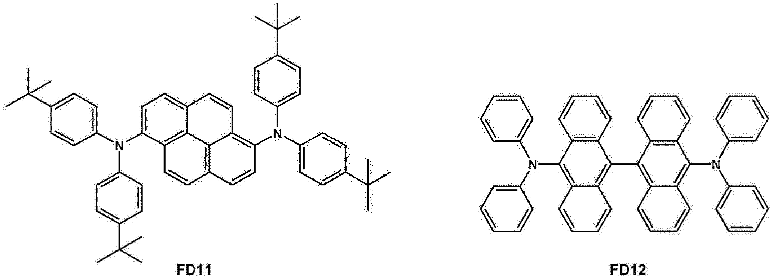

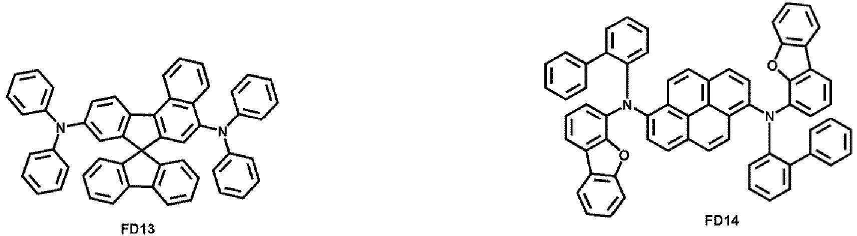

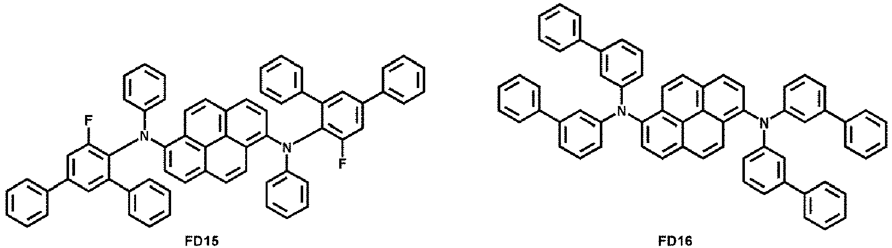

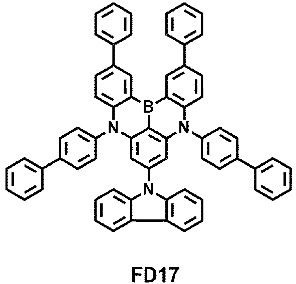

The thickness of the emission layer may be in a range of about 100 Å to about 1,000 Å, and in one or more embodiments, about 200 Å to about 600 Å. When the thickness of the emission layer is within any of these ranges, improved luminescence characteristics may be obtained without a substantial increase in driving voltage.

Next, an electron transport region may be formed on the emission layer.

The electron transport region may include at least one selected from a hole blocking layer, an electron transport layer, and an electron injection layer.

In one or more embodiments, the electron transport region may have a hole blocking layer/an electron transport layer/an electron injection layer structure or an electron transport layer/an electron injection layer structure, but embodiments are not limited thereto. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer, for example, may include at least one of 2,9-dimethyl-4,7-diphenyl-1,10-phenanthroline (BCP) or 4,7-diphenyl-1,10-phenanthroline (Bphen), but embodiments are not limited thereto:

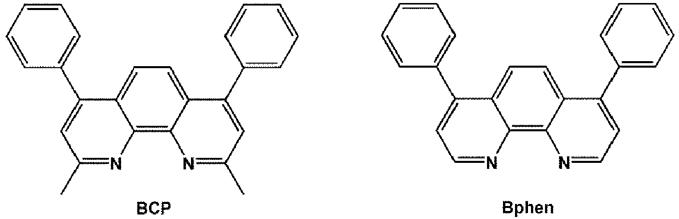

The thickness of the hole blocking layer may be in a range of about 20 Å to about 1,000 Å, and in one or more embodiments, about 30 Å to about 300 Å. When the thickness of the hole blocking layer is within any of these ranges, excellent hole blocking characteristics may be obtained without a substantial increase in driving voltage.

The electron transport layer may include BCP, Bphen, 1,3,5-tri(1-phenyl-1H-benzo[d]imidazol-2-yl)phenyl (TPBi), tris(8-hydroxyquinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

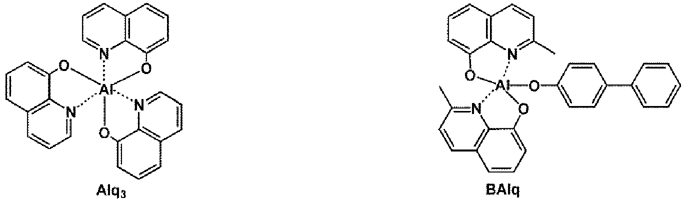

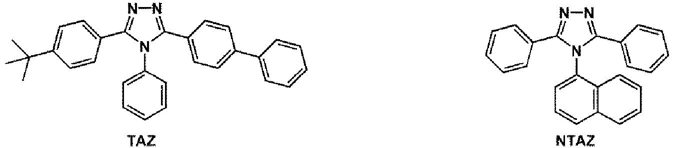

In one or more embodiments, the electron transport layer may include at least one of Compounds ET1 to ET25, but embodiments are not limited thereto:

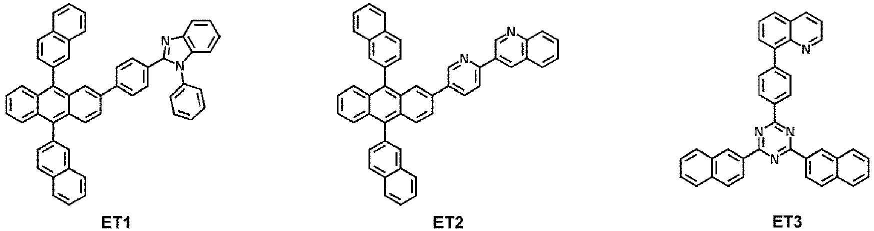

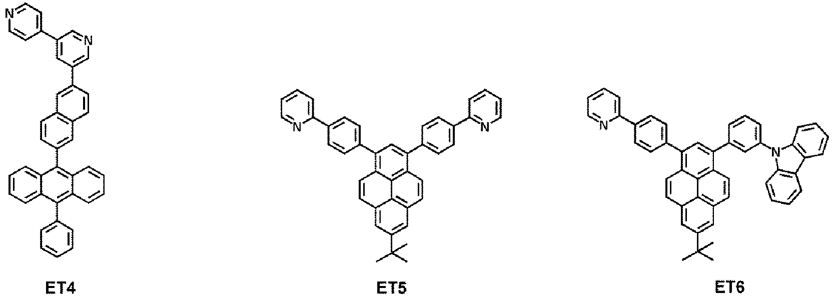

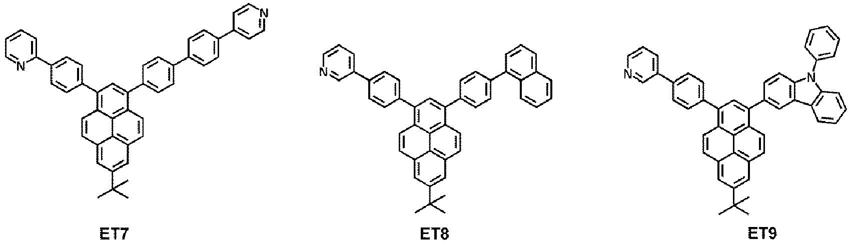

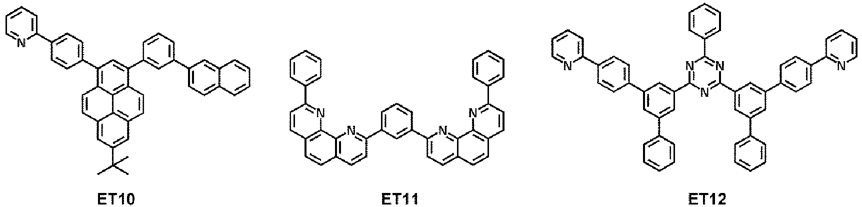

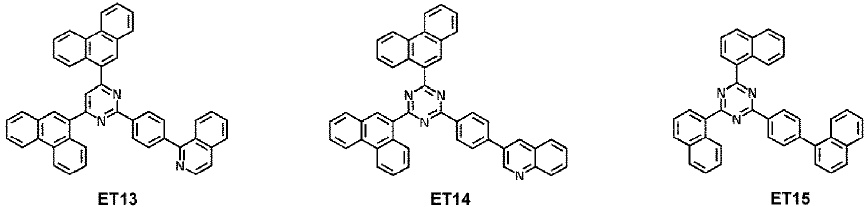

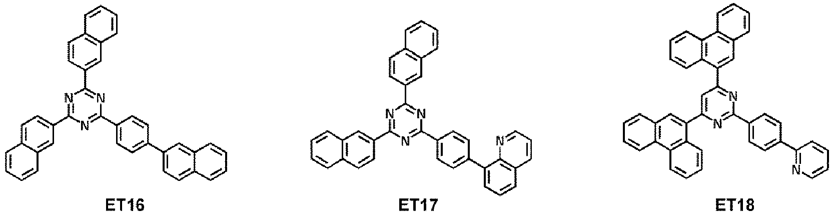

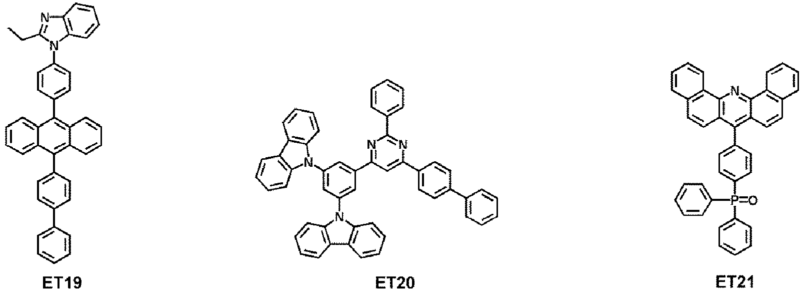

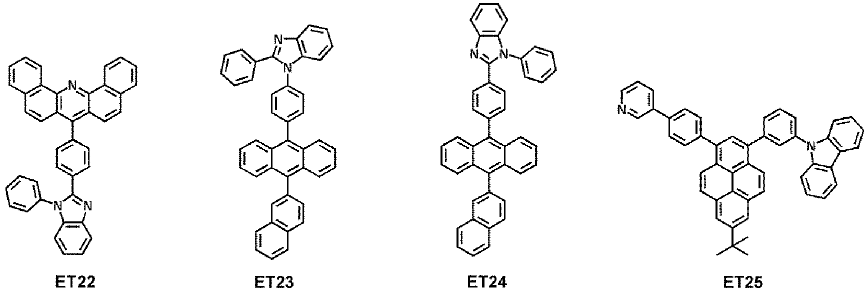

The thickness of the electron transport layer may be in a range of about 100 Å to about 1,000 Å, and in one or more embodiments, about 150 Å to about 500 Å. When the thickness of the electron transport layer is within any of these ranges, excellent electron transport characteristics may be obtained without a substantial increase in driving voltage.

The electron transport layer may further include a material containing metal, in addition to the materials described above.

The material containing metal may include a Li complex. The Li complex may include, e.g., Compound ET-D1 (LiQ) or Compound ET-D2:

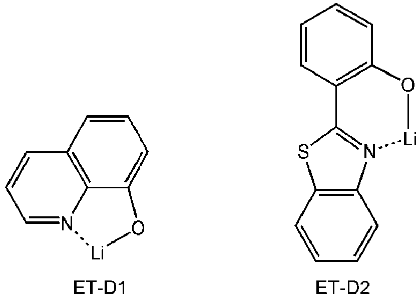

The electron transport region may include an electron injection layer that facilitates injection of electrons from the second electrode 19.

The electron injection layer may include at least one of LiQ, LiF, NaCl, CsF, Li₂O, or BaO.

The thickness of the electron injection layer may be in a range of about 1 Å to about 100 Å, for example, about 3 Å to about 90 Å. When the thickness of the electron injection layer is within any of these ranges, excellent electron injection characteristics may be obtained without a substantial increase in driving voltage.

The second electrode 19 may be on the organic layer 15. The second electrode 19 may be a cathode. A material for forming the second electrode 19 may be a material with a relatively low work function, such as a metal, an alloy, an electrically conductive compound, and a mixture thereof. Examples of the material for forming the second electrode 19 may include lithium (Li), magnesium (Mg), aluminum (Al), silver (Ag), aluminum-lithium (Al-Li), calcium (Ca), magnesium-indium (Mg-In), and magnesium-silver (Mg-Ag). In one or more embodiments, ITO or IZO may be used to form a transmissive second electrode 19 to manufacture a top emission light-emitting device. In one or more embodiments, the material for forming the second electrode 19 may vary.

Hereinbefore the organic light-emitting device 10 has been described with reference to FIG. 1, but embodiments are not limited thereto.

According to an aspect of still another embodiment, a diagnostic composition may include at least one organometallic compound represented by Formula 1.

Since the organometallic compound represented by Formula 1 provides high luminescence efficiency, the diagnostic efficiency of the diagnostic composition that includes the organometallic compound represented by Formula 1 may be excellent.

The diagnostic composition may be applied in various ways, such as in a diagnostic kit, a diagnostic reagent, a biosensor, or a biomarker.

### General definitions of terms

The term "C₁-C₆₀ alkyl group" as used herein refers to a linear or branched saturated aliphatic hydrocarbon monovalent group having 1 to 60 carbon atoms. Examples thereof include a methyl group, an ethyl group, a propyl group, an iso-butyl group, a sec-butyl group, a tert-butyl group, a pentyl group, an iso-amyl group, and a hexyl group. The term "C₁-C₆₀ alkylene group" as used herein refers to a divalent group having substantially the same structure as the C₁-C₆₀ alkyl group.

The term "C₁-C₆₀ alkoxy group" as used herein refers to a monovalent group represented by -OA₁₀₁ (wherein A₁₀₁ is a C₁-C₆₀ alkyl group). Examples thereof include a methoxy group, an ethoxy group, and an isopropyloxy group.

The term "C₁-C₆₀ alkylthio group" as used herein refers to a monovalent group represented by -SA_{101'} (wherein A_{101'} is a C₁-C₆₀ alkyl group).

The term "C₂-C₆₀ alkenyl group" as used herein refers to a group formed by including at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having substantially the same structure as the C₂-C₆₀ alkenyl group.

The term "C₂-C₆₀ alkynyl group" as used herein refers to a group formed by including at least one carbon-carbon triple bond in the middle or at the terminus of the C₂-C₆₀ alkyl group. Examples thereof include an ethenyl group and a propenyl group. The term "C₂-C₆₀ alkynylene group" as used herein refers to a divalent group having substantially the same structure as the C₂-C₆₀ alkynyl group.

The term "C₃-C₁₀ cycloalkyl group" as used herein refers to a monovalent monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent monocyclic group including at least one heteroatom selected from N, O, P, Si, Se, Ge, and S as a ring-forming atom and 1 to 10 carbon atoms. Examples thereof include a tetrahydrofuranyl group and a tetrahydrothiophenyl group. The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent monocyclic group including 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent monocyclic group including at least one heteroatom selected from N, O, P, Si, Se, Ge, and S as a ring-forming atom, 1 to 10 carbon atoms, and at least one double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent C₆-C₆₀ aryl group having a carbocyclic aromatic system and 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and a C₆-C₆₀ arylene group each include at least two rings, the at least two rings may be fused.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group having a heterocyclic aromatic system having at least one heteroatom selected from N, O, P, Si, and S as a ring-forming atom and 1 to 60 carbon atoms. The term "C₁-C₆₀ heteroarylene group" as used herein refers to a divalent C₁-C₆₀ heteroaryl group having a heterocyclic aromatic system having at least one heteroatom selected from N, O, P, and S as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include at least two rings, the at least two rings may be fused.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein refers to -OA₁₀₂ (wherein A₁₀₂ is a C₆-C₆₀ aryl group). The term "C₆-C₆₀ arylthio group" as used herein refers to -SA₁₀₃ (wherein A₁₀₃ is a C₆-C₆₀ aryl group).

The term "C₁-C₆₀ heteroaryloxy group" as used herein indicates -OA_{102'} (wherein A_{102'} is a C₁-C₆₀ heteroaryl group), and the term "C₁-C₆₀ heteroarylthio group" as used herein indicates -SA_{103'} (wherein A_{103'} is a C₁-C₆₀ heteroaryl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and a heteroatom selected from N, O, P, Si, and S and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group.

The term "C₁-C₃₀ heterocyclic group" as used herein refers to saturated or unsaturated cyclic group including 1 to 30 carbon atoms and at least one heteroatom selected from N, O, P, Si, Se, Ge, and S as ring-forming atoms. The C₁-C₃₀ heterocyclic group may be a monocyclic group or a polycyclic group.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, the substituted monovalent non-aromatic condensed heteropolycyclic group, the substituted C₅-C₃₀ carbocyclic group, and the substituted or unsubstituted C₁-C₃₀ heterocyclic group may be:
deuterium, -F, -Cl, -Br, -I, SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(Q₂₈)(Q₂₉), - P(=O)(Q₂₈)(Q₂₉), or a combination thereof; or
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(Q₃₈)(Q₃₉), or -P(=O)(Q₃₈)(Q₃₉),
wherein Q₁ to Q₉, Q₁₁ to Q₁₉, Q₂₁ to Q₂₉, and Q₃₁ to Q₃₉ may each independently be: hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q₁ to Q₉, Q₁₁ to Q₁₉, Q₂₁ to Q₂₉, and Q₃₁ to Q₃₉ in this specification may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

The term "room temperature" and "ambient temperature" as used herein refers to a temperature of about 25°C.

The terms "a biphenyl group, a terphenyl group, and a tetraphenyl group" as used herein each refer to a monovalent group having two, three, and four phenyl groups linked via a single bond, respectively.

Hereinafter, exemplary compounds and organic light-emitting devices according to one or more exemplary embodiments will be described in further detail with reference to Synthesis Examples and Examples, however, the present disclosure is not limited thereto. The wording "B was used instead of A" used in describing Synthesis Examples means that an amount of B used was identical to an amount of A used based on molar equivalence.

### EXAMPLES

### Synthesis Example 1:

### Synthesis Example 1: Synthesis of Compound 1

### (1) Synthesis of Intermediate 1(1)

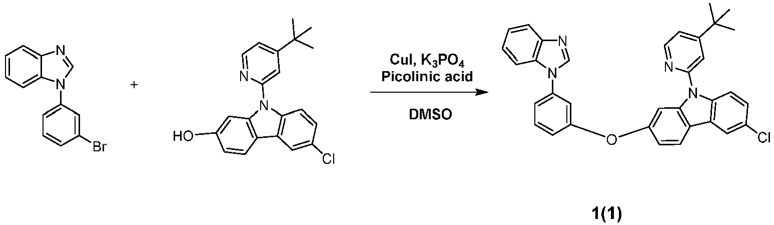

51.3 millimole (mmol) (14 grams (g)) of 1-(3-bromophenyl)-1H-benzo[d]imidazole and 57.0 mmol (20 g) of 9-(4-(tert-butyl) a pyridine-2-yl)-6-chloro-9H-carbazol-2-ol were dissolved in 500 milliliters (mL) of dimethyl sulfoxide (DMSO). Then, 15.5 mmol (3.0 g) of Cul, 207.2 mmol (44.0 g) of K₃PO₄, and 77.7 mmol (9.6 g) of picolinic acid were added thereto, followed by reflux at a temperature of 100°C for 12 hours. The resultant was allowed to cool to room temperature, and an organic layer was extracted three times therefrom using a mixture of ethyl acetate and water, followed by drying the organic layer with magnesium sulfate. Under a reduced pressure, a solvent was removed therefrom to obtain a crude product. Then, using silica gel column chromatography (eluent: ethyl acetate and hexanes), Intermediate 1(1) was obtained (yield: 72%).

Higher performance liquid chromatography-mass spectrometry analysis (HPLC-MS): 543.24 [M+H]⁺.

### (2) Synthesis of Intermediate 1(2)

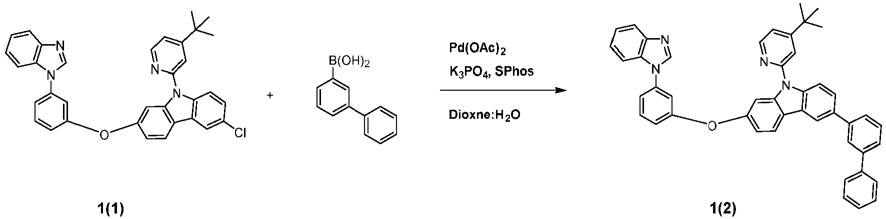

11.0 mmol (6.0 g) of Intermediate 1(1) and 14.4 mmol (2.8 g) of [1,1'-biphenyl]-3-yl boronic acid were dissolved in a solution containing 25 mL of 1,4-dioxane and 8 mL of deionized (DI) water. Then, 2.2 mmol (0.5 g) of palladium (II) acetate (Pd(OAc)₂), 33.0 mmol (7.0 g) of K₃PO₄, and 4.4 mmol (1.8 g) of 2-dicyclohexylphosphino-2',6'-dimethoxybiphenyl (SPhos) were added to the mixture, followed by reflux at a temperature of 110°C for 12 hours. The resultant was allowed to cool to room temperature, and an organic layer was extracted three times therefrom using a mixture of ethyl acetate and water, followed by drying the organic layer with magnesium sulfate. Under a reduced pressure, a solvent was removed therefrom to obtain a crude product. Then, using silica gel column chromatography (eluent: ethyl acetate and hexanes), Intermediate 1(2) was obtained (yield: 85%).

HPLC-MS: 661.35 [M+H]⁺.

### (3) Synthesis of Intermediate 1(3)

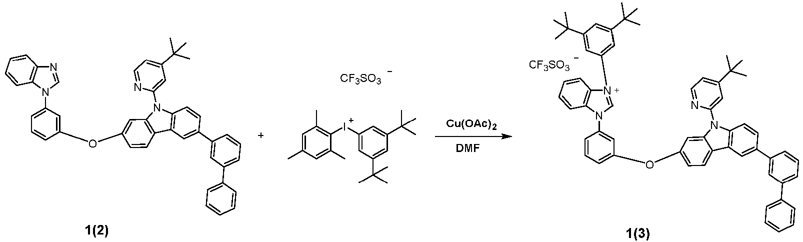

8.47 mmol (5.6 g) of Intermediate 1(2), 11.0 mmol (6.4 g) of (3,5-di-t-butylphenyl)(mesityl)iodonium trifluoromethane sulfonate, and 0.85 mmol (0.15 g) of copper (II) acetate (Cu(OAc)₂) were added to 40 mL of dimethylformamide (DMF), followed by heating at reflux at a temperature of 130°C for 12 hours. The solvent was removed under a reduced pressure to obtain a crude product. Then, using silica gel column chromatography (eluent: dichloromethane and acetone), Intermediate 1(3) was obtained (yield: 47%).

HPLC-MS: 849.51 [M-OTF]⁺,

### (4) Synthesis of Compound 1

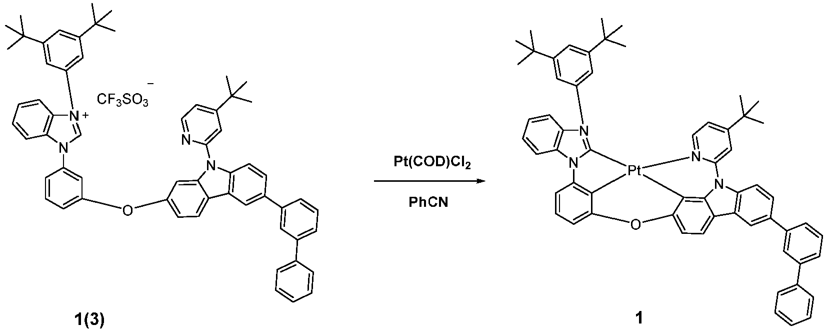

4.0 mmol (1.5 g) of (1,5-cyclooctadiene)platinum(II) dichloride (Pt(COD)Cl₂), 4.0 g mmol (4.0 mmol) of Intermediate 1(3), and 12.0 mmol (1.0 g) of sodium acetate (NaOAc) were added to 70 mL of benzonitrile (PhCN), followed by reflux at a temperature of 180°C for 12 hours. Once the reaction was complete, the resultant was allowed to cool to room temperature. Then, a solvent was removed therefrom under a reduced pressure to obtain a crude product. Then, using silica gel column chromatography (eluent: dichloromethane and hexanes), Compound 1 was obtained (yield: 37%).

HPLC-MS:1042.48 [M+H]⁺.

### Synthesis Example 2: Synthesis of Compound 2

### (1) Synthesis of Intermediate 2(1)

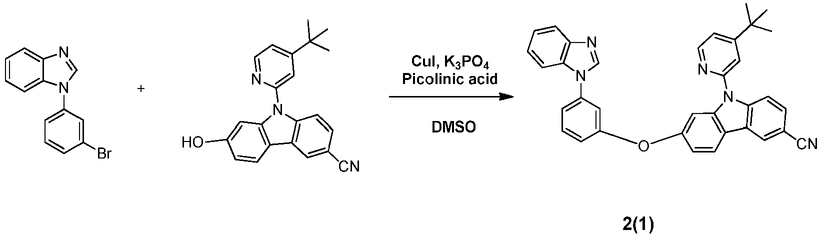

Intermediate 2(1) was synthesized in a similar manner as in Synthesis of Intermediate 1(1) in Synthesis Example 1, except that 9-(4-(tert-butyl)pyridin-2-yl)-7-hydroxy-9H-carbazol-3-carbonitrile was used instead of 9-(4-(tert-butyl)pyridin-2-yl)-6-chloro-9H-carbazol-2-ol (yield: 75%).

HPLC-MS: 534.21 [M+H]⁺.

### (2) Synthesis of Intermediate 2(2)

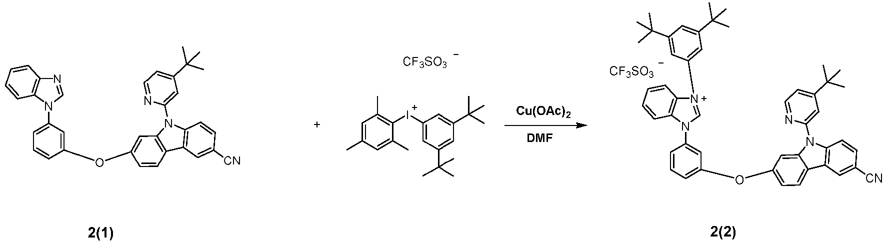

Intermediate 2(2) was synthesized in a similar manner as in Synthesis of Intermediate 1(3) in Synthesis Example 1, except that Intermediate 2(1) was used instead of Intermediate 1(2) (yield: 60%).

HPLC-MS: 722.38 [M-OTf]⁺.

### (3) Synthesis of Compound 2

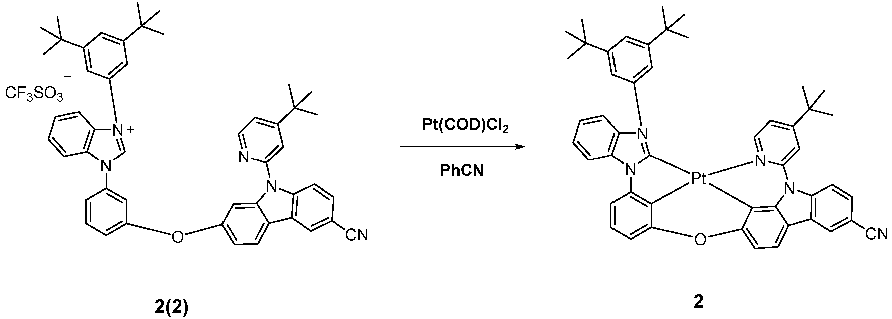

Compound 2 was synthesized in a similar manner as in Synthesis of Compound 1 in Synthesis Example 1, except that Intermediate 2(2) was used instead of Intermediate 1(3) (yield: 35%).

HPLC-MS: 915.32 [M+H]⁺.

### Synthesis Example 3: Synthesis of Compound 3

### (1) Synthesis of Intermediate 3(1)

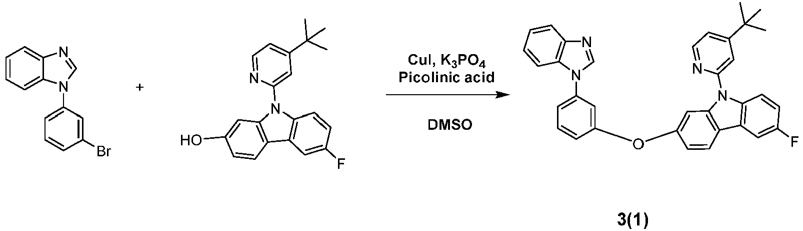

Intermediate 3(1) was synthesized in a similar manner as in Synthesis of Intermediate 1(1) in Synthesis Example 1, except that 9-(4-(tert-butyl)pyridin-2-yl)-6-fluoro-9H-carbazol-2-ol was used instead of 9-(4-(tert-butyl)pyridin-2-yl)-6-chloro-9H-carbazol-2-ol (yield: 47%).

HPLC-MS: 527.23 [M+H]⁺.

### (2) Synthesis of Intermediate 3(2)

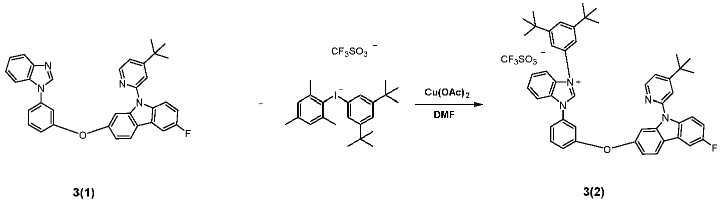

Intermediate 3(2) was synthesized in a similar manner as in Synthesis of Intermediate 1(3) in Synthesis Example 1, except that Intermediate 3(1) was used instead of Intermediate 1(2) (yield: 84%).

HPLC-MS: 715.38 [M-OTf]⁺.

### (3) Synthesis of Compound 3

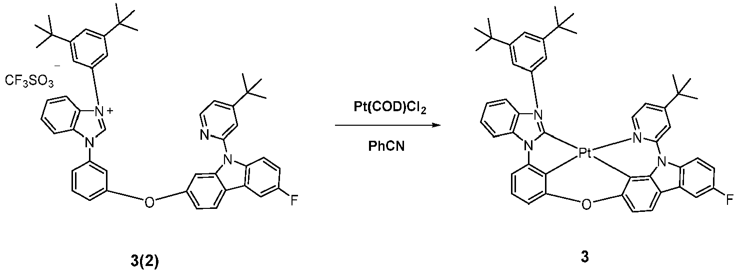

Compound 3 was synthesized in a similar manner as in Synthesis of Compound 1 in Synthesis Example 1, except that Intermediate 3(2) was used instead of Intermediate 1(3) (yield: 46%).

HPLC-MS: 908.33 [M+H]⁺.

### Synthesis Example 4: Synthesis of Compound 4

### (1) Synthesis of Intermediate 4(1)

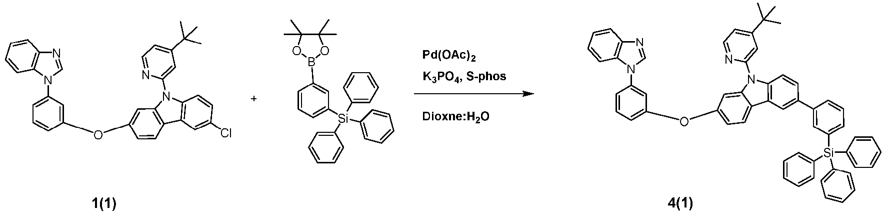

Intermediate 4(1) was synthesized in a similar manner as in Synthesis of Intermediate 1(2) in Synthesis Example 1, except that triphenyl(3-(4,4,5,5-tetramethyl-1,3,2-dioxaboran-2-yl)phenyl)silane was used instead of [1,1'-biphenyl]-3-yl boronic acid (yield: 73%).

HPLC-MS: 843.34 [M+H]⁺.

### (2) Synthesis of Intermediate 4(2)

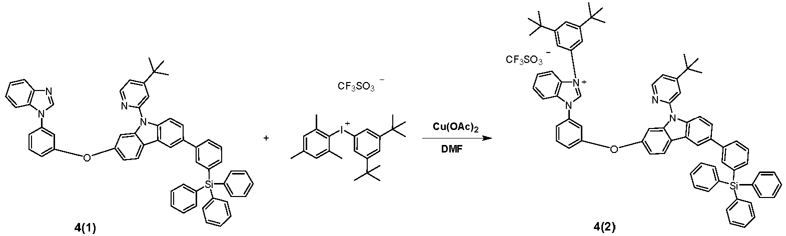

Intermediate 4(2) was synthesized in a similar manner as in Synthesis of Intermediate 1(3) in Synthesis Example 1, except that Intermediate 4(1) was used instead of Intermediate 1(2) (yield: 61%).

HPLC-MS: 1031.50 [M-OTf]⁺.

### (3) Synthesis of Compound 4

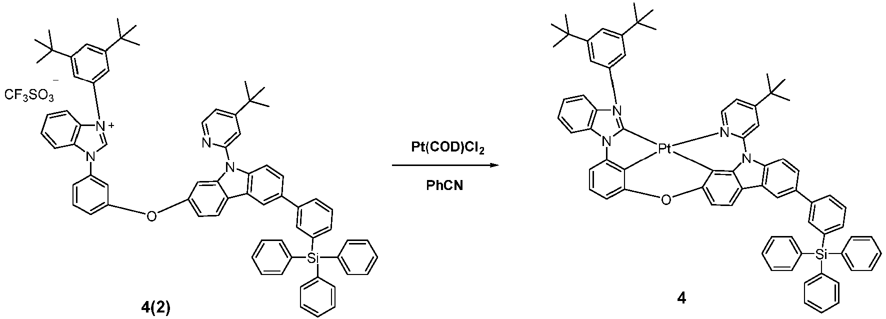

Compound 4 was synthesized in a similar manner as in Synthesis of Compound 1 in Synthesis Example 1, except that Intermediate 4(2) was used instead of Intermediate 1(3) (yield: 39%).

HPLC-MS: 1224.44 [M+H]⁺.

### Synthesis Example 5: Synthesis of Compound 5

### (1) Synthesis of Intermediate 5(1)

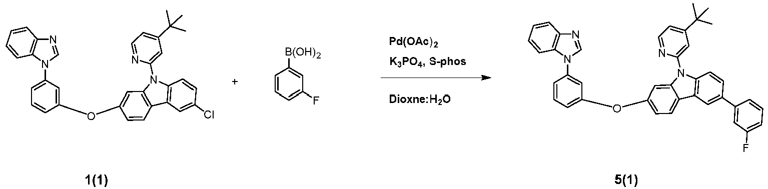

Intermediate 5(1) was synthesized in a similar manner as in Synthesis of Intermediate 1(2) in Synthesis Example 1, except that (3-fluorophenyl)boronic acid was used instead of [1,1'-biphenyl]-3-yl boronic acid (yield: 79%).

HPLC-MS: 603.24 [M+H]⁺.

### (2) Synthesis of Intermediate 5(2)

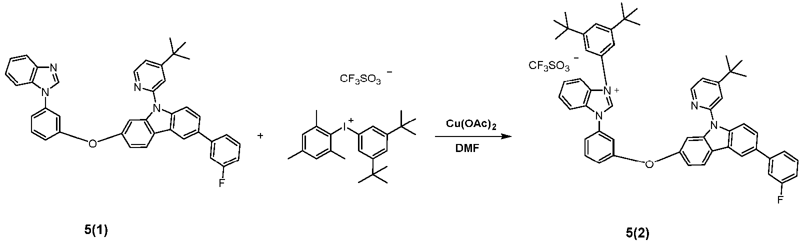

Intermediate 5(2) was synthesized in a similar manner as in Synthesis of Intermediate 1(3) in Synthesis Example 1, except that Intermediate 5(1) was used instead of Intermediate 1(2) (yield: 81%).

HPLC-MS: 791.40 [M-OTf]⁺.

### (3) Synthesis of Compound 5

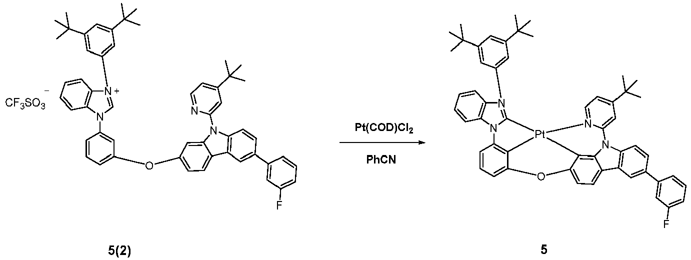

Compound 5 was synthesized in a similar manner as in Synthesis of Compound 1 in Synthesis Example 1, except that Intermediate 5(2) was used instead of Intermediate 1(3) (yield: 34%).

HPLC-MS: 984.31 [M+H]⁺.

### Synthesis Example 6: Synthesis of Compound 6

### (1) Synthesis of Intermediate 6(1)

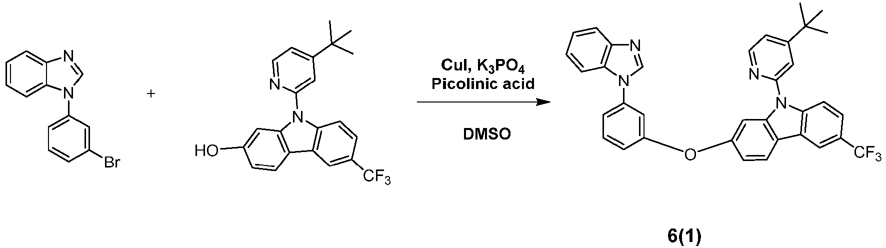

Intermediate 6(1) was synthesized in a similar manner as in Synthesis of Intermediate 1(1) in Synthesis Example 1, except that 9-(4-(tert-butyl) pyridin-2-yl)-6-(trifluoromethyl)-9H-carbazol-2-ol was used instead of 9-(4-(tert-butyl)pyridin-2-yl)-6-chloro-9H-carbazol-2-ol (yield: 51%).

HPLC-MS: 577.19 [M+H]⁺.

### (2) Synthesis of Intermediate 6(2)

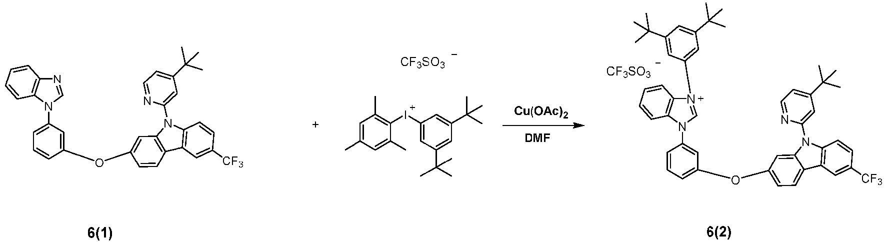

Intermediate 6(2) was synthesized in a similar manner as in Synthesis of Intermediate 1(3) in Synthesis Example 1, except that Intermediate 6(1) was used instead of Intermediate 1(2) (yield: 63%).

HPLC-MS: 765.24 [M-OTf]⁺.

### (3) Synthesis of Compound 6

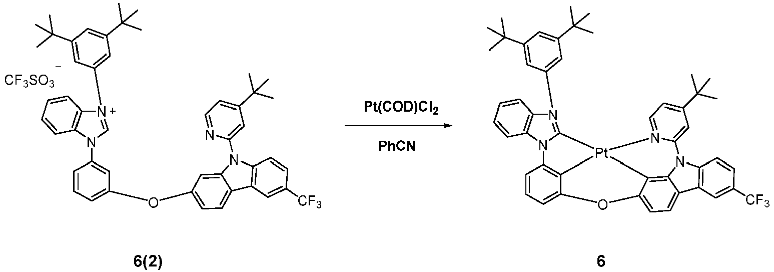

Compound 6 was synthesized in a similar manner as in Synthesis of Compound 1 in Synthesis Example 1, except that Intermediate 6(2) was used instead of Intermediate 1(3) (yield: 35%).

HPLC-MS: 958.26 [M+H]⁺.

### Synthesis Example 7: Synthesis of Compound 7

### (1) Synthesis of Intermediate 7(1)

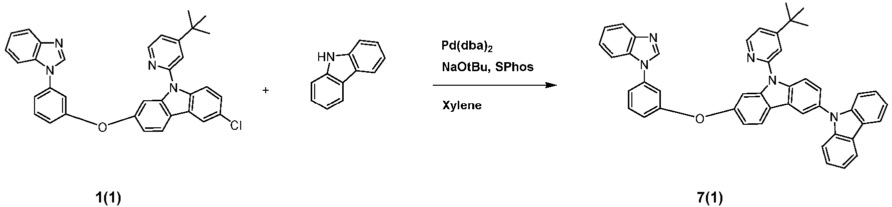

7.4 mmol (4.0 g) of Intermediate (1) and 0.6 mmol (1.6 g) of 9H-carbazole were dissolved in 40 mL of xylene, and 0.74 mmol (0.4 g) of bis(dibenzylideneacetone)palladium(0) (Pd(dba)₂), 14.8 mmol (1.4 g) of sodium tert-butoxide (NaO^{t}Bu), and 0.81 mmol (0.3 g) of picolinic acid were added to the solution, followed by reflux at a temperature of 110°C for 12 hours. The resultant was cooled to room temperature, and an organic layer was extracted three times therefrom using a mixture of ethyl acetate and water, followed by drying the organic layer with magnesium sulfate. Under a reduced pressure, a solvent was removed therefrom to obtain a crude product. Then, using silica gel column chromatography (eluent: ethyl acetate and hexanes), Intermediate 7(1) was obtained (yield: 46%).

HPLC-MS: 674.28 [M+H]⁺.

### (2) Synthesis of Intermediate 7(2)

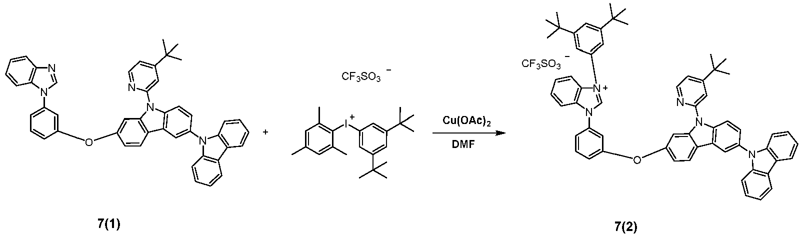

Intermediate 7(2) was synthesized in a similar manner as in Synthesis of Intermediate 1(3) in Synthesis Example 1, except that Intermediate 7(1) was used instead of Intermediate 1(2) (yield: 86%).

HPLC-MS: 862.43 [M-OTf]⁺.

### (3) Synthesis of Compound 7

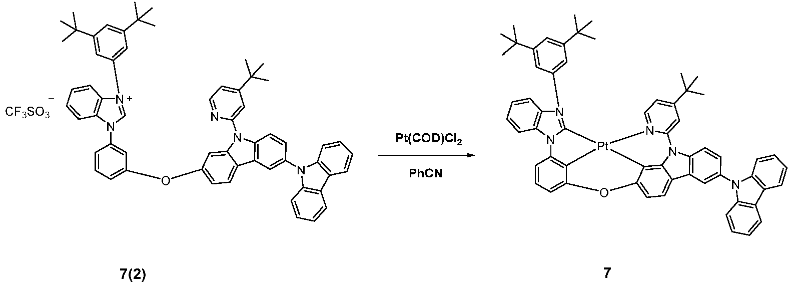

Compound 7 was synthesized in a similar manner as in Synthesis of Compound 1 in Synthesis Example 1, except that Intermediate 7(2) was used instead of Intermediate 1(3) (yield: 42%).

HPLC-MS: 1055.38 [M+H]⁺.

### Synthesis Example 8: Synthesis of Compound 8

### (1) Synthesis of Intermediate 8(1)

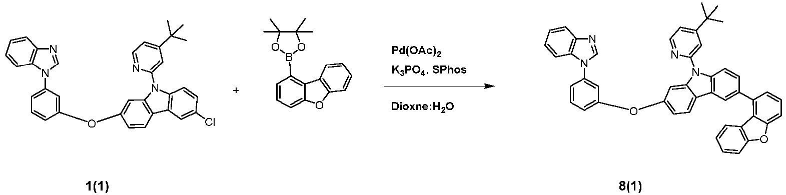

Intermediate 8(1) was synthesized in a similar manner as in Synthesis of Intermediate 1(2) in Synthesis Example 1, except that 2-(dibenzo[b, d]furan-1-yl)-4,4,5,5-tetramethyl-1,3,2-dioxaborolane was used instead of [1,1'-biphenyl]-3-yl boronic acid (yield: 80%).

HPLC-MS: 675.26 [M+H]⁺.

### (2) Synthesis of Intermediate 8(2)

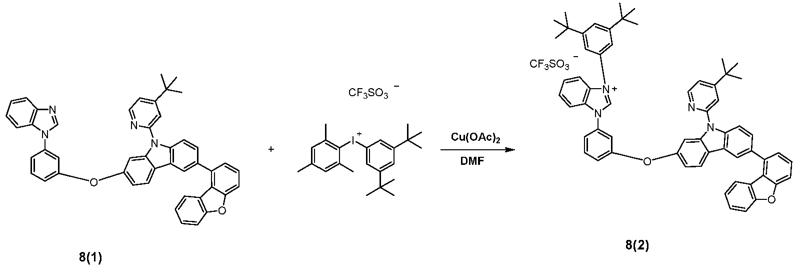

Intermediate 8(2) was synthesized in a similar manner as in Synthesis of Intermediate 1(3) in Synthesis Example 1, except that Intermediate 8(1) was used instead of Intermediate 1(2) (yield: 73%).

HPLC-MS: 863.41 [M-OTf]⁺.

### (3) Synthesis of Compound 8

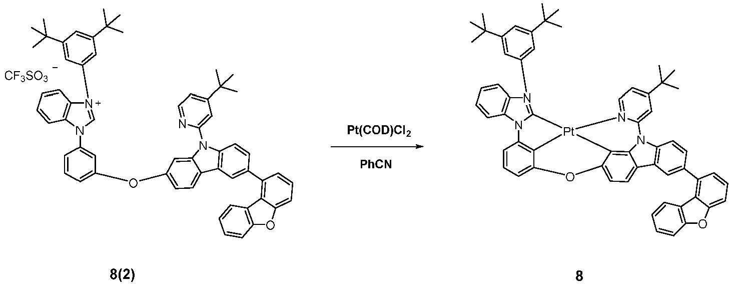

Compound 8 was synthesized in a similar manner as in Synthesis of Compound 1 in Synthesis Example 1, except that Intermediate 8(2) was used instead of Intermediate 1(3) (yield: 49%).

HPLC-MS: 1056.35 [M+H]⁺.

### Synthesis Example 9: Synthesis of Compound 9

### (1) Synthesis of Intermediate 9(1)

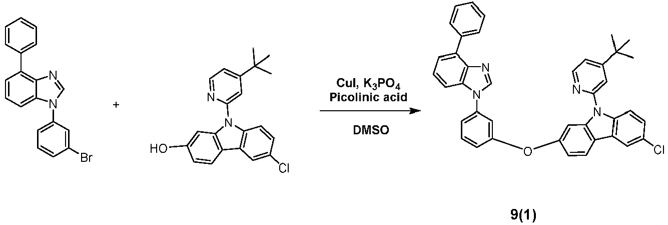

Intermediate 9(1) was synthesized in a similar manner as in Synthesis of Intermediate 1(1) in Synthesis Example 1, except that 1-(3-bromophenyl)-4-phenyl-1H-benzo[d]imidazole was used instead of 1-(3-bromophenyl)-1H-benzo[d]imidazole (yield: 68%).

HPLC-MS: 619.21 [M+H]⁺.

### (2) Synthesis of Intermediate 9(2)

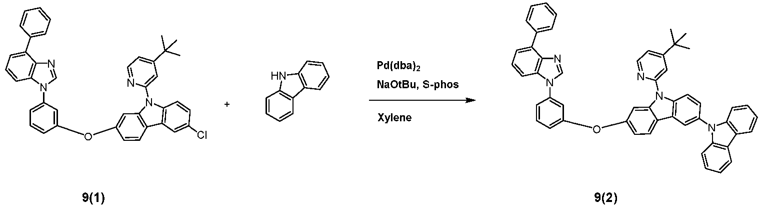

Intermediate 9(2) was synthesized in a similar manner as in Synthesis of Intermediate 7(1) in Synthesis Example 1, except that Intermediate 9(1) was used instead of Intermediate 1(1) (yield: 44%).

HPLC-MS: 750.29 [M+H]⁺.

### (3) Synthesis of Intermediate 9(3)

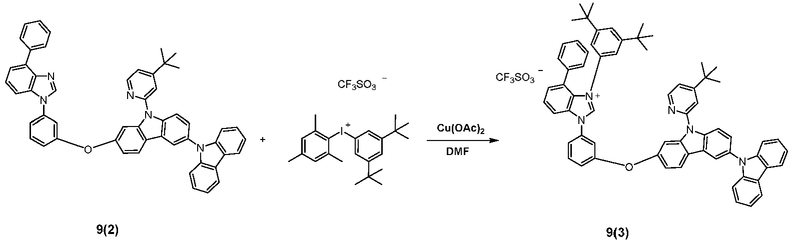

Intermediate 9(3) was synthesized in a similar manner as in Synthesis of Intermediate 1(3) in Synthesis Example 1, except that Intermediate 9(2) was used instead of Intermediate 1(2) (yield: 71%).

HPLC-MS: 938.42 [M-OTf]⁺.

### (4) Synthesis of Compound 9

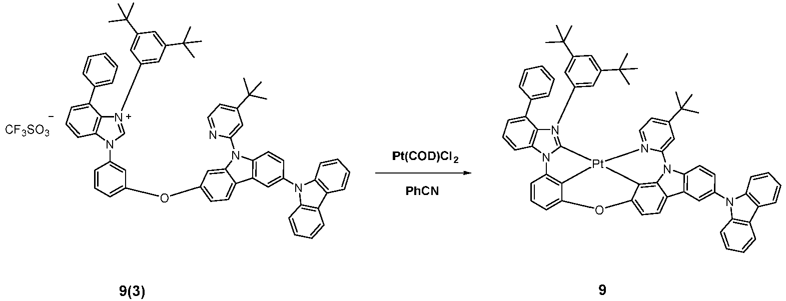

Compound 9 was synthesized in a similar manner as in Synthesis of Compound 1 in Synthesis Example 1, except that Intermediate 9(3) was used instead of Intermediate 1(3) (yield: 36%).

HPLC-MS: 1131.34 [M+H]⁺.

### Synthesis Example 10: Synthesis of Compound 10

### (1) Synthesis of Intermediate 10(1)

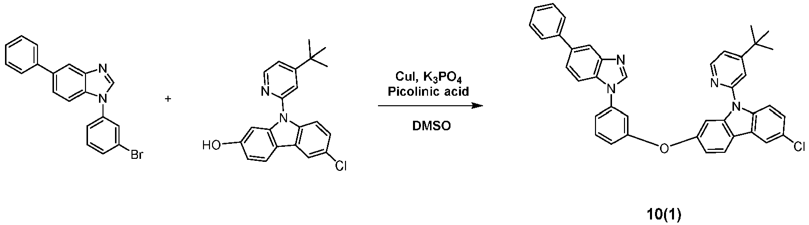

Intermediate 10(1) was synthesized in a similar manner as in Synthesis of Intermediate 1(1) in Synthesis Example 1, except that 1-(3-bromophenyl)-5-phenyl-1H-benzo[d]imidazole was used instead of 1-(3-bromophenyl)-1H-benzo[d]imidazole (yield: 60%).

HPLC-MS: 619.22 [M+H]⁺.

### (2) Synthesis of Intermediate 10(2)

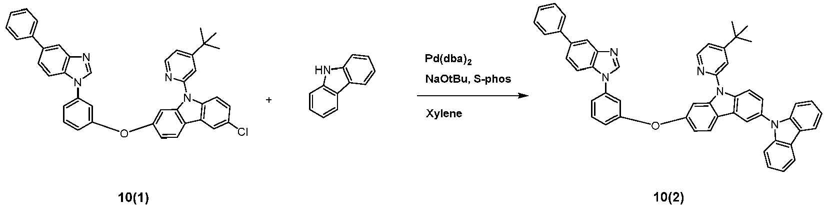

Intermediate 10(2) was synthesized in a similar manner as in Synthesis of Intermediate 7(1) in Synthesis Example 7, except that Intermediate 10(1) was used instead of Intermediate 1(1) (yield: 47%).

HPLC-MS: 750.28 [M+H]⁺.

### (3) Synthesis of Intermediate 10(3)

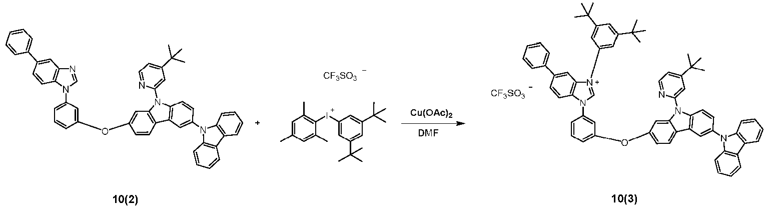

Intermediate 10(3) was synthesized in a similar manner as in Synthesis of Intermediate 1(3) in Synthesis Example 1, except that Intermediate 10(2) was used instead of Intermediate 1(2) (yield: 84%).

HPLC-MS: 938.41 [M-OTf]⁺.

### (4) Synthesis of Compound 10

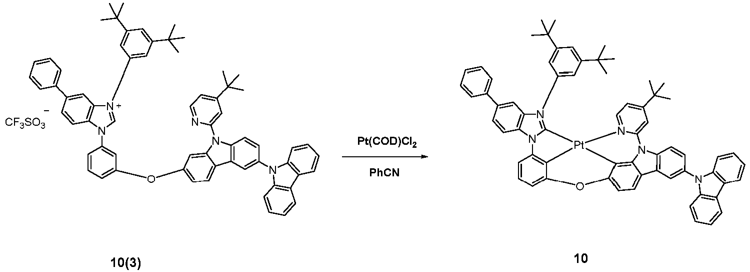

Compound 10 was synthesized in a similar manner as in Synthesis of Compound 1 in Synthesis Example 1, except that Intermediate 10(3) was used instead of Intermediate 1(3) (yield: 34%).

HPLC-MS: 1131.36 [M+H]⁺.

### Synthesis Example 11: Synthesis of Compound 11

### (1) Synthesis of Intermediate 11(1)

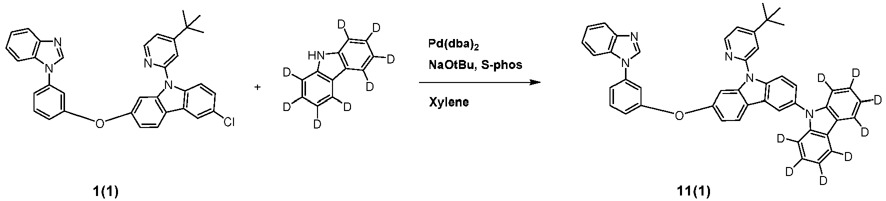

Intermediate 11(1) was synthesized in a similar manner as in Synthesis of Intermediate 7(1) in Synthesis Example 7, except that 9H-carbazole-d8 was used instead of 9H-carbazole (yield: 46%).

HPLC-MS: 681.32 [M+H]⁺.

### (2) Synthesis of Intermediate 11(2)

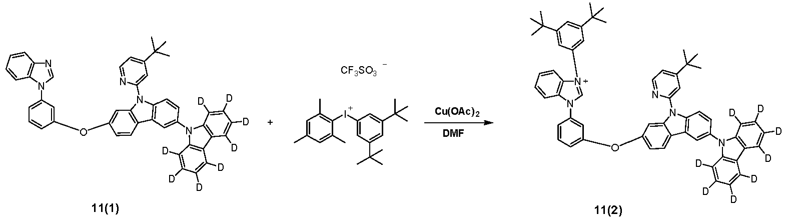

Intermediate 11(2) was synthesized in a similar manner as in Synthesis of Intermediate 1(3) in Synthesis Example 1, except that Intermediate 11(1) was used instead of Intermediate 1(2) (yield: 82%).

HPLC-MS: 869.50 [M-OTf]⁺.

### (3) Synthesis of Compound 11

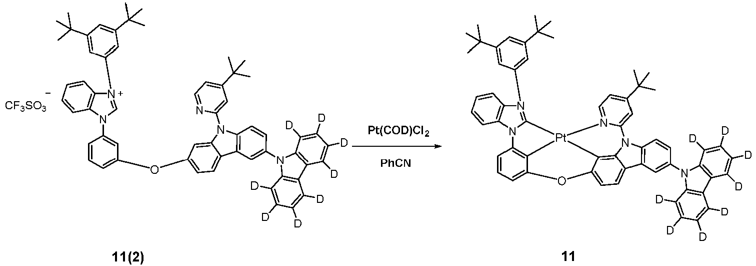

Compound 11 was synthesized in a similar manner as in Synthesis of Compound 1 in Synthesis Example 1, except that Intermediate 11(3) was used instead of Intermediate 1(3) (yield: 43%).

HPLC-MS: 1061.43 [M+H]⁺.

### Synthesis Example 12: Synthesis of Compound 12

### (1) Synthesis of Intermediate 12(1)

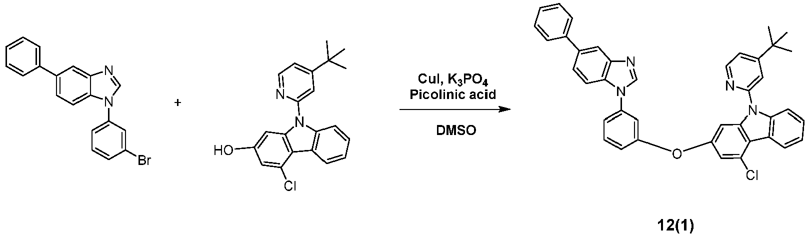

Intermediate 12(1) was synthesized in a similar manner as in Synthesis of Intermediate (1) in Synthesis Example 1, except that 1-(3-bromophenyl)-5-phenyl-1H-benzo[d]imidazole was used instead of 1-(3-bromophenyl)-1H-benzo[d]imidazole, and 9-(4-(tert-butyl)pyridin-2-yl)-4-chloro-9H-carbazole-2-ol was used instead of 9-(4-(tert-butyl)pyridin-2-yl)-6-chloro-9H-carbazole-2-ol (yield: 51%).

HPLC-MS: 619.23 [M+H]⁺.

### (2) Synthesis of Intermediate 12(2)

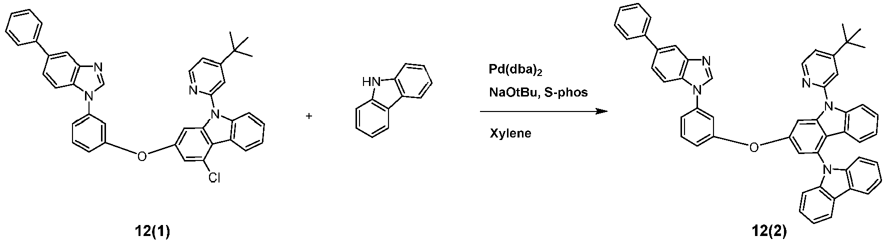

Intermediate 12(2) was synthesized in a similar manner as in Synthesis of Intermediate 7(1) in Synthesis Example 7, except that Intermediate 12(1) was used instead of Intermediate 1(1) (yield: 66%).

HPLC-MS: 750.26 [M+H]⁺.

### (3) Synthesis of Intermediate 12(3)

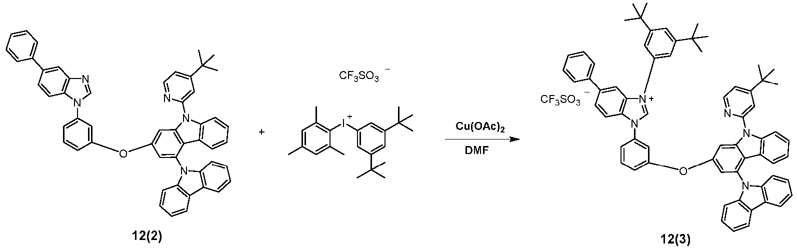

Intermediate 12(3) was synthesized in a similar manner as in Synthesis of Intermediate 1(3) in Synthesis Example 1, except that Intermediate 12(2) was used instead of Intermediate 1(2) (yield: 89%).

HPLC-MS: 938.40 [M-OTf]⁺.

### (4) Synthesis of Compound 12

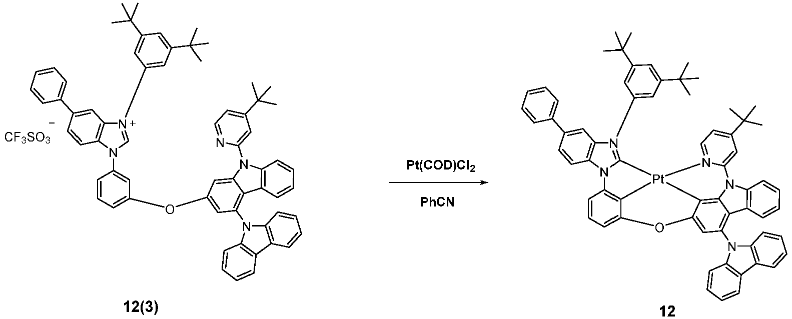

Compound 12 was synthesized in a similar manner as in Synthesis of Compound 1 in Synthesis Example 1, except that Intermediate 12(3) was used instead of Intermediate 1(3) (yield: 36%).

HPLC-MS: 1131.43 [M+H]⁺.

### Evaluation Example 1: Evaluation of Photoluminescence (PL) optical characteristics

Compound 1 was diluted in toluene at a concentration of 10 millimolar (mM), and a PL spectrum of Compound 1 was measured at room temperature by using an ISC PC1 spectrofluorometer, in which a xenon lamp was mounted. The evaluation was performed on Compounds 2 to 12 and Comparative Compound C1. The PL spectra of the compounds are shown in FIG. 2. The maximum emission wavelength (PLₘₐₓ, nm), full width at half maximum (FWHM, nm), and second peak intensity of each compound were measured from the PL spectra thereof. The results thereof are shown in Table 2.

**Table 2**

| Compound No. | PLₘₐₓ (nm) | FWHM (nm) | Second peak intensity |
|---|---|---|---|
| 1 | 460 | 19 | 0.357 |
| 2 | 458 | 20 | 0.363 |
| 3 | 459 | 18 | 0.352 |
| 4 | 460 | 18 | 0.346 |
| 5 | 460 | 18 | 0.351 |
| 6 | 458 | 19 | 0.376 |
| 7 | 459 | 18 | 0.355 |
| 8 | 459 | 19 | 0.335 |
| 9 | 458 | 16 | 0.310 |
| 10 | 461 | 19 | 0.384 |
| 11 | 459 | 18 | 0.354 |
| 12 | 460 | 19 | 0.412 |
| C1 | 460 | 20 | 0.419 |

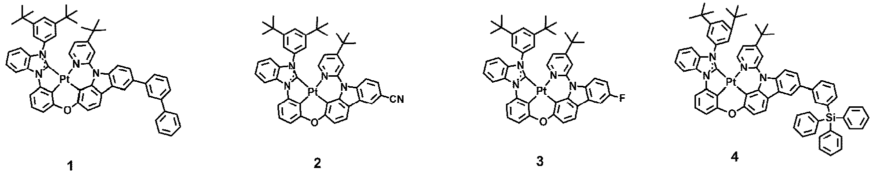

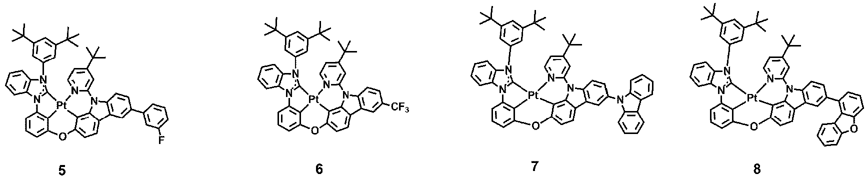

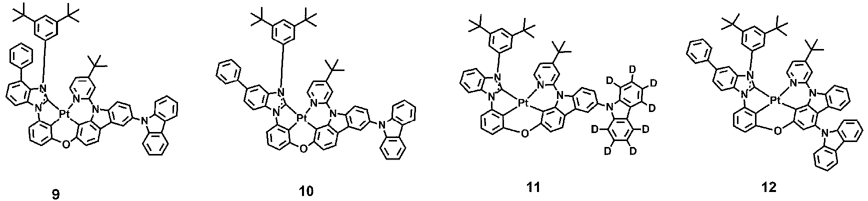

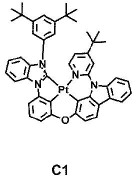

Referring to the results shown in FIG. 2 and Table 2, Compounds 1 to 12 according to one or more embodiments were each found to have a PL spectrum having a FWHM narrower than or equal to Comparative Compound C1 and a smaller second peak intensity than Comparative Compound C1.

### Evaluation Example 2: Evaluation of PL quantum yield (PLQY)

A CH₂Cl₂ solution of poly(methyl methacrylate) (PMMA), 5 percent by weight (wt%, based on the weight of PMMA) of CBP, and 0.5 percent by weight (wt%, based on the weight of PMMA) Compound 1 were mixed together. The resultant mixture obtained therefrom was coated on a quartz substrate by using a spin coater, heat-treated in an oven at a temperature of 80°C, and cooled to room temperature, thereby obtaining a film.

Luminescence quantum yields in the film was evaluated by using Hamamatsu Photonics absolute PL quantum yield measurement system employing PLQY measurement software (Hamamatsu Photonics, Ltd., Shizuoka, Japan), in which a xenon light source, a monochromator, a photonic multichannel analyzer, and an integrating sphere are mounted. Thus, PLQY Compound 1 was evaluated. This process was repeatedly performed on Compounds 2 to 12 and Comparative Compound C1. The results thereof are shown in Table 3.

**Table 3**

| Compound No. | PLQY in PMMA |
|---|---|
| 1 | 0.779 |
| 2 | 0.722 |
| 3 | 0.817 |
| 4 | 0.775 |
| 5 | 0.775 |
| 6 | 0.819 |
| 7 | 0.797 |
| 8 | 0.762 |
| 9 | 0.790 |
| 10 | 0.804 |
| 11 | 0.797 |
| 12 | 0.859 |
| C1 | 0.712 |

Referring to the results of Table 3, Films of Compounds 1 to 12 according to one or more embodiments were each found to having a high PLQY and improved luminescence characteristics, as compared with a film of Comparative Compound C1.

### Example 1

A glass substrate having an indium tin oxide (ITO) electrode (a first electrode, an anode) deposited thereon at a thickness of 500 Å was washed with DI water in the presence of ultrasound waves. Once the washing with DI waterwas complete, ultrasound wave washing was performed on the substrate by using isopropyl alcohol, acetone, and methanol in this stated order. Subsequently, the substrate was dried, transferred to a plasma washer, washed for 5 minutes using oxygen plasma, and mounted in a vacuum deposition device.

Compound HT3 was vacuum-deposited on the ITO electrode of the glass substrate to form a first hole injection layer having a thickness of 3,500 Å, Compound HT-D1 was vacuum-deposited on the first hole injection layer to form a second hole injection layer having a thickness of 300 Å, and TAPC was vacuum-deposited on the second hole injection layer to form an electron blocking layer having a thickness of 100 Å, thereby forming a hole transport region.

Compound H52 as a host and Compound 1 (10 wt%, based on the total weight of the emission layer) as an emitter were co-deposited on the hole transport region to form an emission layer having a thickness of 300 Å.

Compound ET3 was vacuum-deposited on the emission layer to form an electron transport layer having a thickness of 250 Å, ET-D1 (Liq) was deposited on the electron transport layer to form an electron injection layer having a thickness of 5 Å, and an AI second electrode (a cathode) was formed on the electron injection layer to have a thickness of 1,000 Å, thereby completing the manufacture of an organic light-emitting device.

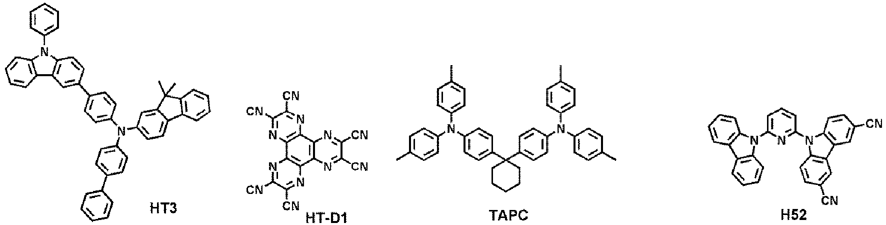

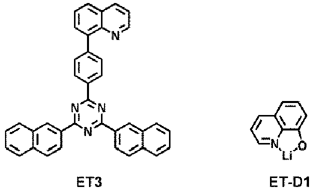

### Examples 2 and 12 and Comparative Example 1

Organic light-emitting devices were manufactured in a similar manner as in Example 1, except that the compounds shown in Table 4 were used instead of Compound 1 as an emitter in formation of an emission layer.

### Evaluation Example 3

The EL spectrum, the maximum emission wavelength of the EL spectrum (λₘₐₓ, nm), the driving voltage (relative value), and the external quantum efficiency (EQE, relative value) of each of the organic light-emitting devices manufactured in Examples 1 to 12 and Comparative Example 1 were evaluated. The results thereof are shown in Table 4. The driving voltage and EQE in Table 4 are shown as relative values with respect to Comparative Example 1. The driving voltage and EQE were measured as follows.

### (1) Measurement of maximum emission wavelength of EL spectrum

The maximum emission wavelength of EL spectra of the manufactured organic light-emitting devices at a luminance of 1,000 candelas per square meter (cd/m²) were measured by using a luminance meter (Minolta Cs-1000A).

### (2) Measurement of driving voltage and external quantum efficiency

A Keithley 2400 current voltmeter and a luminance meter (Minolta Cs-1000A) were used in evaluation of the driving voltage and the external quantum efficiency at a luminance of 1,000 cd/m².

**Table 4**

| | Emission layer dopant | λₘₐₓ (nm) | Driving voltage (relative value) | EQE (relative value) |
|---|---|---|---|---|
| Example 1 | 1 | 464 | 93 | 114 |
| Example 2 | 2 | 460 | 90 | 104 |
| Example 3 | 3 | 462 | 93 | 123 |
| Example 4 | 4 | 462 | 100 | 110 |
| Example 5 | 5 | 463 | 93 | 119 |
| Example 6 | 6 | 461 | 92 | 116 |
| Example 7 | 7 | 462 | 88 | 116 |
| Example 8 | 8 | 462 | 100 | 106 |
| Example 9 | 9 | 460 | 89 | 125 |
| Example 10 | 10 | 464 | 85 | 132 |
| Example 11 | 11 | 462 | 86 | 123 |
| Example 12 | 12 | 462 | 83 | 129 |
| Comparative Example 1 | C1 | 462 | 100 | 100 |

Referring to the results of Table 4, the organic light-emitting devices of Examples 1 to 3 were each found to have driving voltage and EQE that are equal to or better than those of the organic light-emitting device of Comparative Example 1.

### Evaluation Example 4: Evaluation of EL spectrum and Second peak

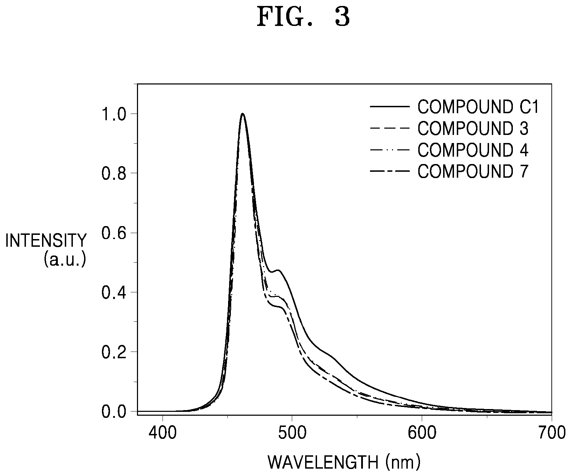

The EL spectra of the organic light-emitting devices of Examples 3, 4, and 7 and Comparative Example 1 are shown in FIG. 3.

As shown in FIG. 3, the EL spectra of the organic light-emitting devices of Examples 3, 4 and 7 were each found to have smaller second peak intensity, as compared with the EL spectrum of the organic light-emitting device of Comparative Example 1.

### Example 13

An organic light-emitting device was manufactured in a similar manner as in Example 1, except that 10 wt% of Compound 3 was used as a sensitizer instead of 1.5 wt% of FD17 as an emitter in formation of the emission layer.

### Example 14

An organic light-emitting device was manufactured in a similar manner as in Example 1, except that 10 wt% of Compound 4 was used as a sensitizer instead of 1.5 wt% of FD17 as an emitter in formation of the emission layer.

### Example 15

An organic light-emitting device was manufactured in a similar manner as in Example 1, except that 10 wt% of Compound 7 was used as a sensitizer instead of 1.5 wt% of FD17 as an emitter in formation of the emission layer.

### Example 16

An organic light-emitting device was manufactured in a similar manner as in Example 1, except that 10 wt% of Compound 8 was used as a sensitizer instead of 1.5 wt% of FD17 as an emitter in formation of the emission layer.

### Comparative Example 2

An organic light-emitting device was manufactured in a similar manner as in Example 1, except that 1.5 wt% of FD17 was used as an emitter in formation of the emission layer.

**Table 5**

| | Dopant compound | Driving voltage (relative value) | EQE (relative value) | Lifespan (T₉₅) (relative value) | λₘₐₓ (nm) |
|---|---|---|---|---|---|
| Example 13 | Compound 3 + FD17 | 78 | 172 | 963 | 462 |
| Example 14 | Compound 4 + FD17 | 94 | 174 | 1444 | 462 |
| Example 15 | Compound 7 + FD17 | 80 | 180 | 1000 | 462 |
| Example 16 | Compound 8 + FD17 | 91 | 161 | 852 | 462 |
| Comparative Example 2 | FD17 | 100 | 100 | 100 | 462 |

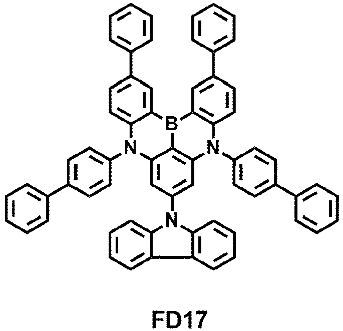

The lifetime (T₉₅) of Table 5 was measured as the time it takes to reach 95% of the initial luminance compared to 100% of the initial luminance, and a current-voltmeter (Keithley 2400) and a luminance meter (Minolta Cs-1000A) were used as an evaluation device.

Referring to the results of Table 5, the organic light-emitting devices of Examples 13 to 16 using the organometallic compound according to one or more embodiments as a sensitizer in the emission layer were each found to have improved driving voltage, conversion efficiency, and lifespan, as compared with the organic light-emitting device of Comparative Example 2 not using a sensitizer.

As apparent from the foregoing description, the organometallic compound represented by Formula 1 was found to show an emission spectrum of which the second peak intensity is small, and thus, an organic light-emitting device including the organometallic compound may realize deep blue color due to the improved colorimetric purity.

It should be understood that the exemplary embodiments described herein should be considered in a descriptive sense and not for purposes of limitation.

## Claims

1. An organometallic compound, represented by Formula 1: 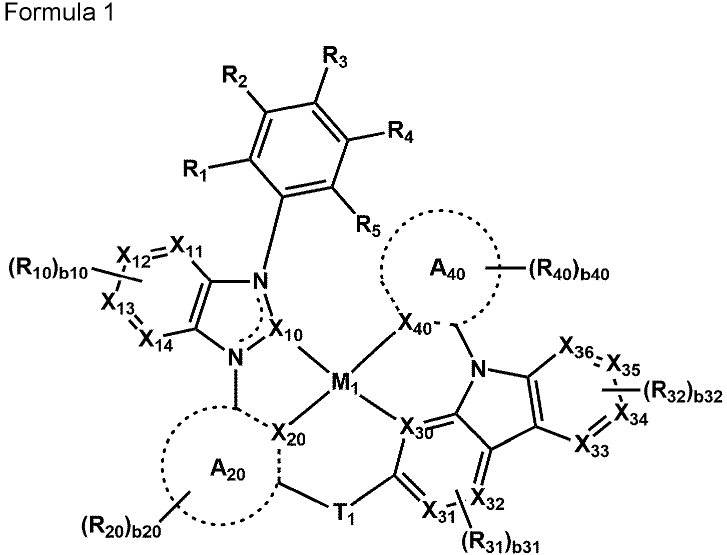 wherein, in Formula 1,
M₁ is iridium (Ir), platinum (Pt), osmium (Os), titanium (Ti), zirconium (Zr), hafnium (Hf), europium (Eu), terbium (Tb), thulium (Tm), rhodium (Rh), palladium (Pd), or gold (Au),
X₁₀ is C,
X₁₁ to X₁₄, X₂₀, X₃₀ to X₃₆, and X₄₀ are each independently C or N,
ring A₂₀ and ring A₄₀ are each independently a C₅-C₃₀ carbocyclic group or a C₁-C₃₀ heterocyclic group,
T₁ is *-N(R₅₁)-*', *-B(R₅₁)-*', "-P(R₅₁)-*', *-C(R₅₁)(R₅₂)-*', *-Si(R₅₁)(R₅₂)-*', *-Ge(R₅₁)(R₅₂)-*', *-S-*', *-Se-*', *-O-*', *-C(=O)-*', *-S(=O)-*', *-S(=O)₂-*', *-C(R₅₁)=C(R₅₂)-*', *-C(=S)-*', or *-C≡C-*', wherein * and *' each indicated a binding site to an adjacent atom,
R₂ and R₄ are each independently a substituted or unsubstituted C₁-C₆₀ alkyl group or a substituted or unsubstituted C₆-C₆₀ aryl group,
R₁, R₃, R₅, R₁₀, R₂₀, R₃₁, R₃₂, R₄₀, R₅₁, and R₅₂ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), -P(Q₈)(Q₉), or -P(=O)(Q₈)(Q₉),
two or more of R₁₀, R₂₀, R₃₁, R₃₂, R₄₀, R₅₁, and R₅₂ are optionally bonded to each other to form a substituted or unsubstituted C₅-C₃₀ carbocyclic group or a substituted or unsubstituted C₁-C₃₀ heterocyclic group,
b10 and b32 are each independently an integer from 1 to 4,
b20 and b40 are each independently an integer from 1 to 10,
b31 is 1 or 2,
provided that at least one of R₃₁(s) in the number of b31, or R₃₂(s) in the number of b32 is:
-F, a cyano group, -CF₃, -CF₂H, -CFH₂, -Si(Q₃)(Q₄)(Q₅), or a group represented by one of Formulae 3-1 to 3-55,
wherein Q₃ to Q₅ are each independently a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof: 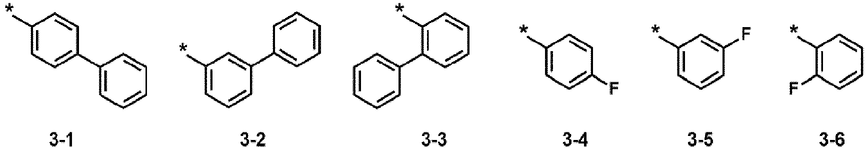 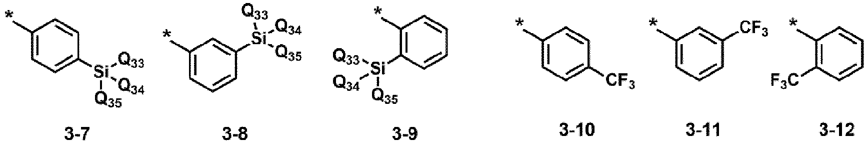 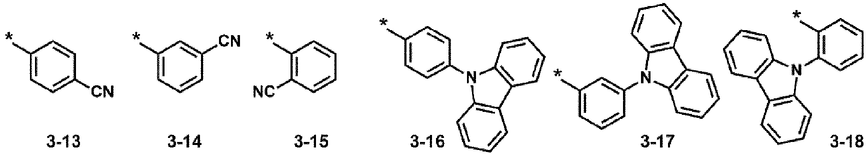 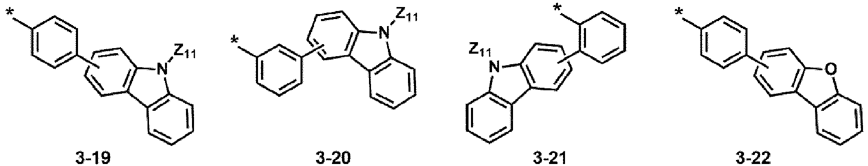 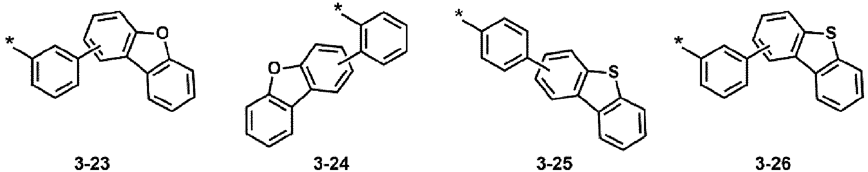 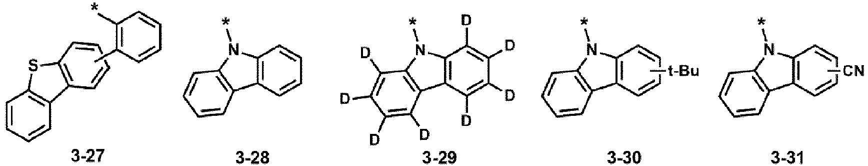 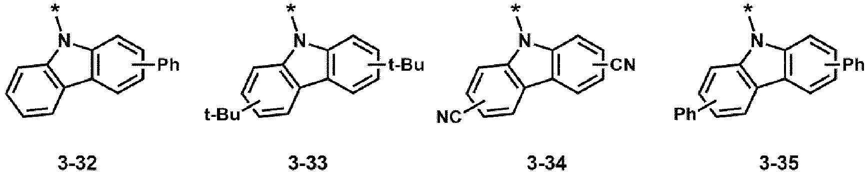 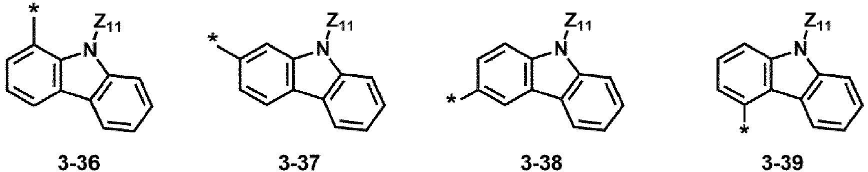 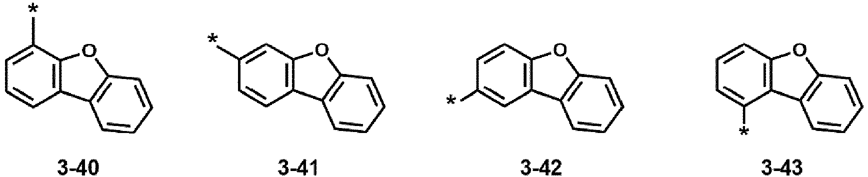 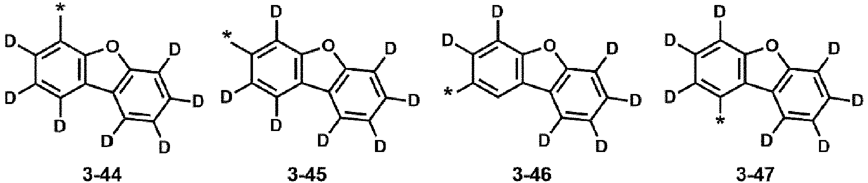 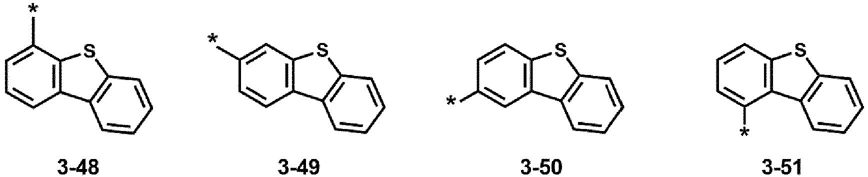 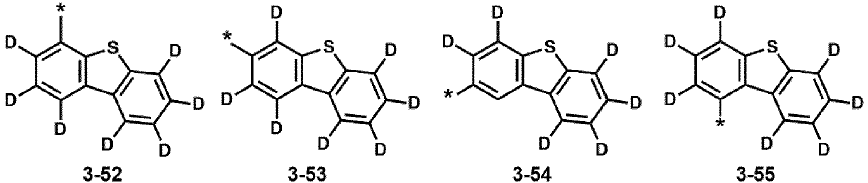
wherein, in Formulae 3-1 to 3-55,
Q₃₃ to Q₃₅ and Z₁₁ are each independently a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof,
t-Bu represents a tert-butyl group, Ph represents a phenyl group, and
* indicates a binding site to an adjacent atom, and
a substituent of each of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, the substituted monovalent non-aromatic condensed heteropolycyclic group, the substituted C₅-C₃₀ carbocyclic group, and the substituted C₁-C₃₀ heterocyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -B(Q₂₆)(Q₂₇), -P(Q₂₈)(Q₂₉), -P(=O)(Q₂₈)(Q₂₉), or a combination thereof;
-N(Q₃₁)(Q₃₂), -Si(Q₃₃)(Q₃₄)(Q₃₅), -B(Q₃₆)(Q₃₇), -P(Q₃₈)(Q₃₉), or -P(=O)(Q₃₈)(Q₃₉); or
a combination thereof,
wherein Q₁ to Q₉, Q₁₁ to Q₁₉, Q₂₁ to Q₂₉, and Q₃₁ to Q₃₉ are each independently: hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein M₁ in Formula 1 is platinum (Pt), palladium (Pd), or gold (Au); and/or
wherein ring A₂₀ and ring A₄₀ in Formula 1 are each independently a cyclopentane group, a cyclopentene group, a cyclohexane group, a cyclohexene group, a cyclohexadiene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophenegroup, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

3. The organometallic compound of claims 1 or 2, wherein ring A₂₀ in Formula 1 is represented by one of Formulae A20(1) to A20(15): 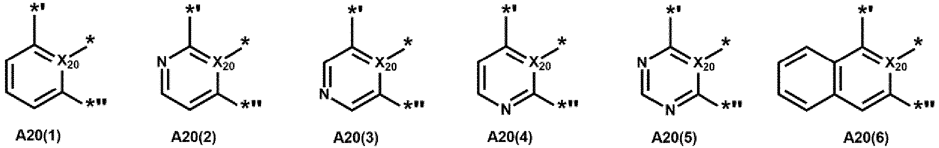 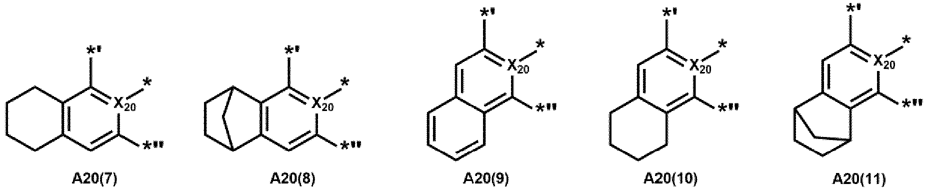 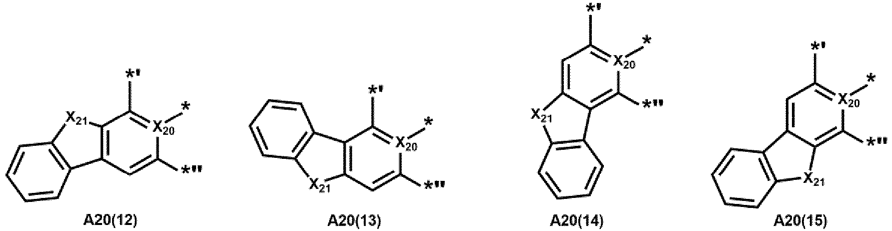
wherein, in Formulae A20(1) to A20(15),
X₂₀ is C or N,
X₂₁ is O, S, N(R₂₁), C(R₂₁)(R₂₂), or Si(R₂₁)(R₂₂),
R₂₁ and R₂₂ are each independently as defined for R₂₀ in claim 1,
* indicates a binding site to M₁ in Formula 1,
*' indicates a binding site to N in Formula 1, and
*" indicates a binding site to T₁ in Formula 1; and/or
wherein ring A₄₀ in Formula 1 is represented by one of Formulae A40(1) to A40(34): 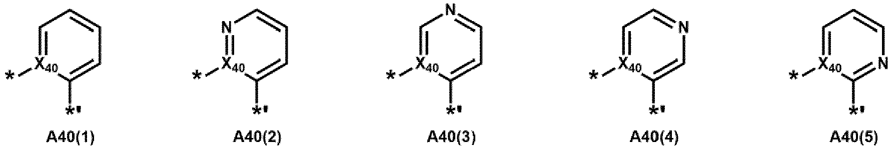 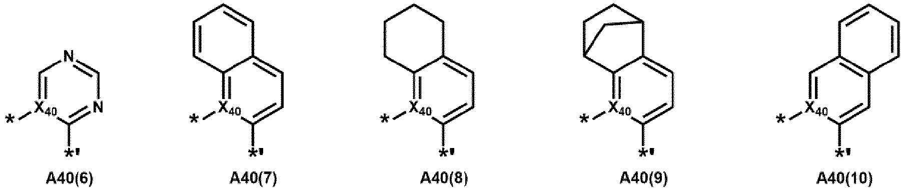 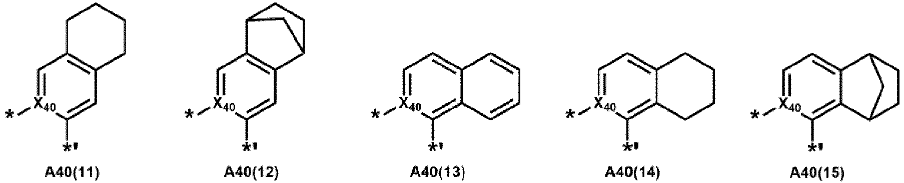 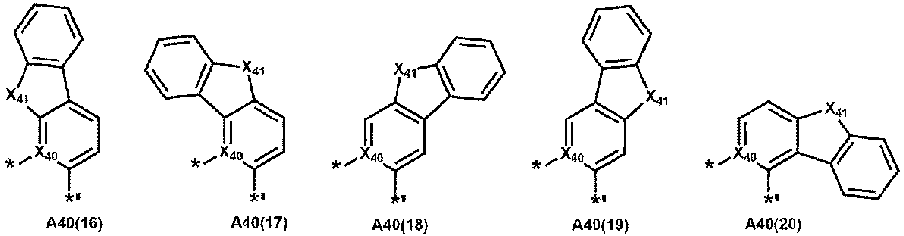 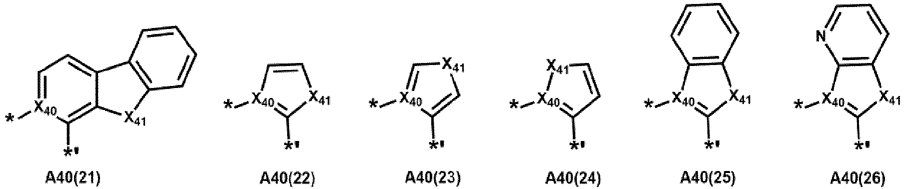 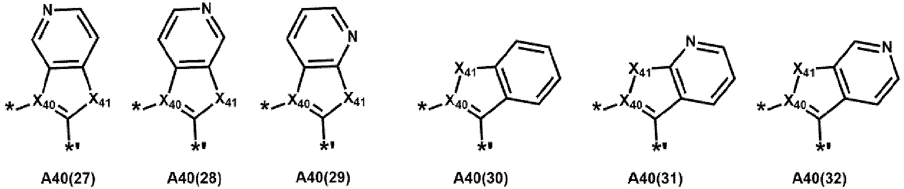 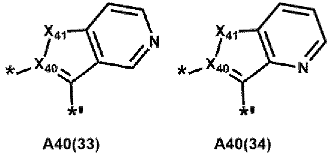
wherein, in Formulae A40(1) to A40(34),
X₄₀ is C or N,
X₄₁ is O, S, N(R₄₁), C(R₄₁)(R₄₂), or Si(R₄₁)(R₄₂),
R₄₁ and R₄₂ are each independently as defined for R₄₀ in claim 1,
* indicates a binding site to M₁ in Formula 1, and
*' indicates a binding site to N in Formula 1.

4. The organometallic compound of any of claims 1-3, wherein R₂ in Formula 1 is:
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each unsubstituted or substituted with at least one of deuterium, -F, -Cl, -Br, -I, - SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a naphthyl group, a fluorenyl group, a phenanthrenyl group, an anthracenyl group, a fluoranthenyl group, a triphenylenyl group, a pyrenyl group, a chrysenyl group, or a combination thereof.

5. The organometallic compound of any of claims 1-4, wherein, in Formula 1,
i) R₁ and R₃ to R₅ are each hydrogen,
ii) R₁, R₃, and R₅ are each hydrogen, and
R₄ is:
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each unsubstituted or substituted with at least one of deuterium, -F, -Cl, -Br, -I, - SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a naphthyl group, a fluorenyl group, a phenanthrenyl group, an anthracenyl group, a fluoranthenyl group, a triphenylenyl group, a pyrenyl group, a chrysenyl group, or a combination thereof, or
iii) R₁ and R₅ are each hydrogen, and
R₃ and R₄ are each independently:
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each unsubstituted or substituted with at least one of deuterium, -F, -Cl, -Br, -I, - SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or ay combination thereof; or
a phenyl group, a naphthyl group, a fluorenyl group, a phenanthrenyl group, an anthracenyl group, a fluoranthenyl group, a triphenylenyl group, a pyrenyl group, or a chrysenyl group, each unsubstituted or substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a phenyl group, a naphthyl group, a fluorenyl group, a phenanthrenyl group, an anthracenyl group, a fluoranthenyl group, a triphenylenyl group, a pyrenyl group, a chrysenyl group, or a combination thereof.

6. The organometallic compound of any of claims 1-5, wherein a moiety represented by 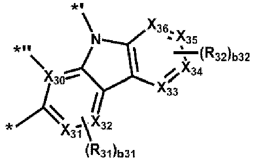 in Formula 1 is represented by one of Formulae A30(1) to A30(6): 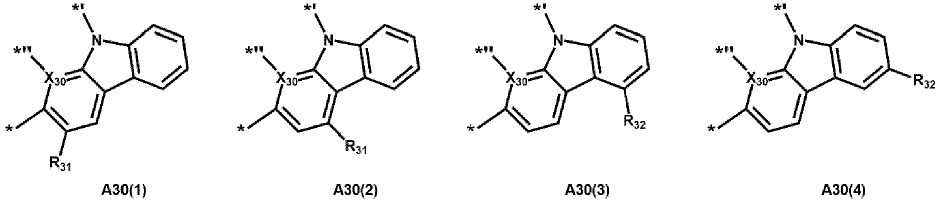 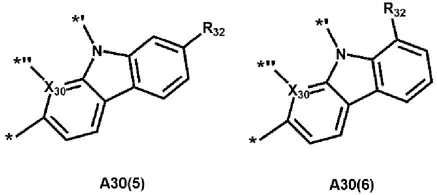
wherein, in Formulae A30(1) to A30(6),
R₃₁, R₃₂, X₃₀, Q₃ to Q₅, and Q₃₃ to Q₃₅ are as defined in claim 1,
* and *' each indicate a binding site to an adjacent atom, and
*" indicates a binding site to M₁; and/or
wherein the organometallic compound is represented by Formula 1A: 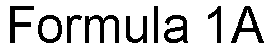 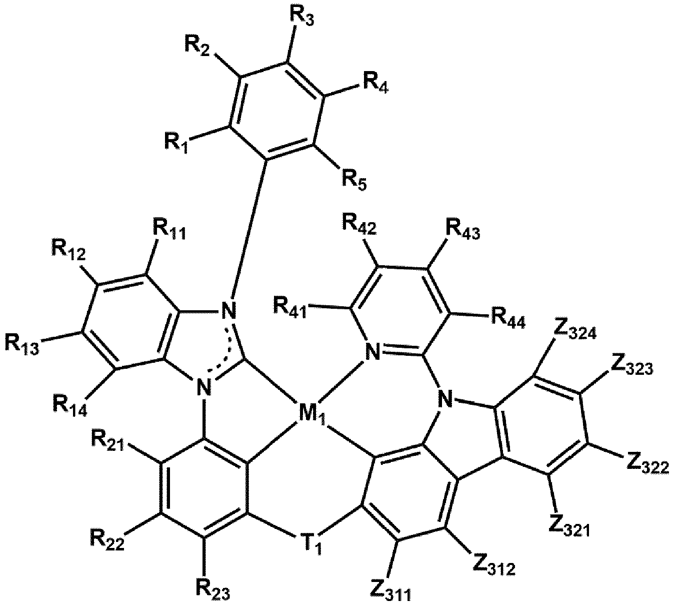
wherein, in Formula 1A,
M₁, T₁, and R₁ to Rs are as defined in claim 1,
R₁₁ to R₁₄ are each independently as defined for R₁₀ in claim 1,
R₂₁ to R₂₃ are each independently as defined for R₂₀ in claim 1,
Z₃₁₁ and Z₃₁₂ are each independently as defined for R₃₁ in claim 1,
Z₃₂₁ to Z₃₂₄ are each independently as defined for R₃₂ in claim 1,
R₄₁ to R₄₄ are each independently as defined for R₄₀ in claim 1.

7. The organometallic compound of claim 1, wherein the organometallic compound is represented by one or more of Compounds 1 to 220, 222 to 224, 227, 230, 231, 235, 236, 238, 239, 241, 246, 247, 250, 251, 259, 260, 263, 267, 273, 274, 276, 280 to 297, and 299 to 308:

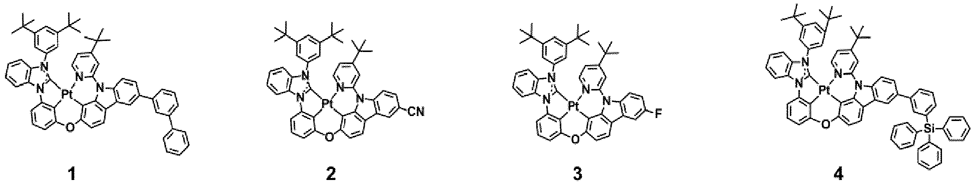

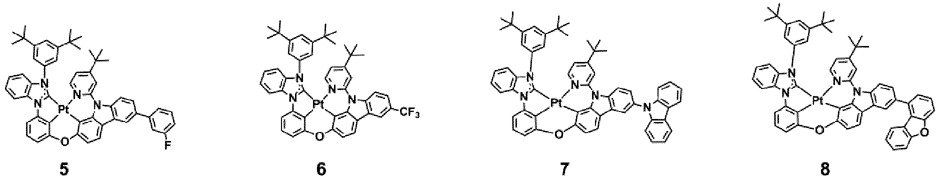

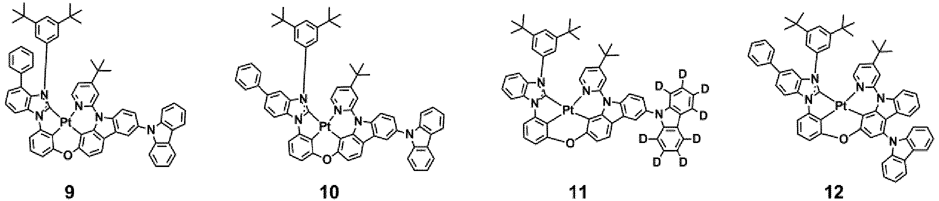

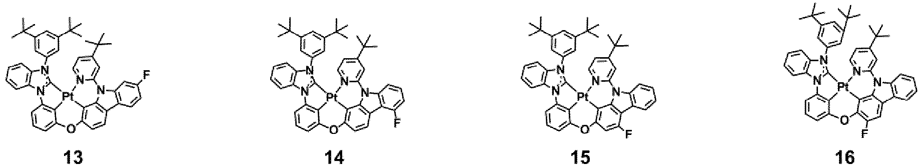

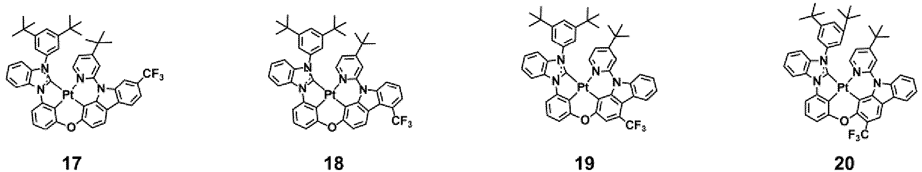

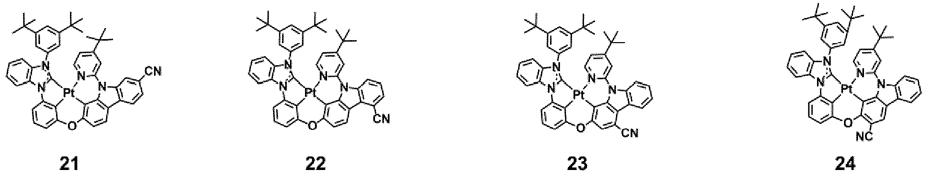

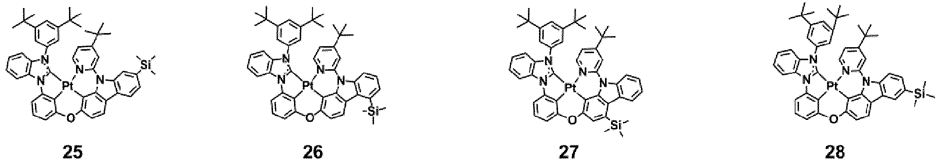

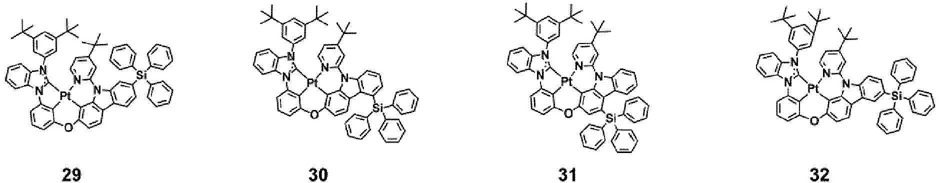

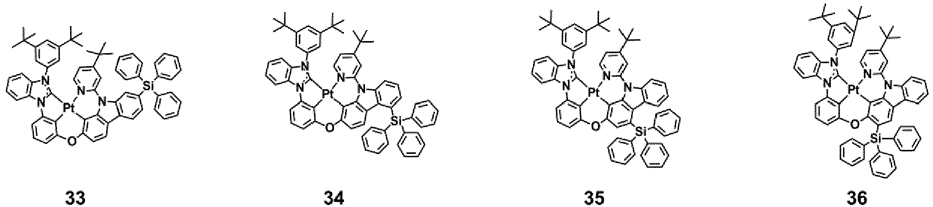

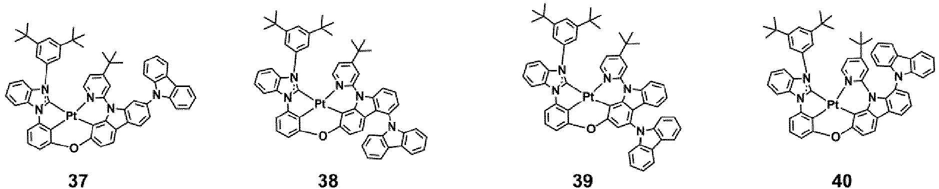

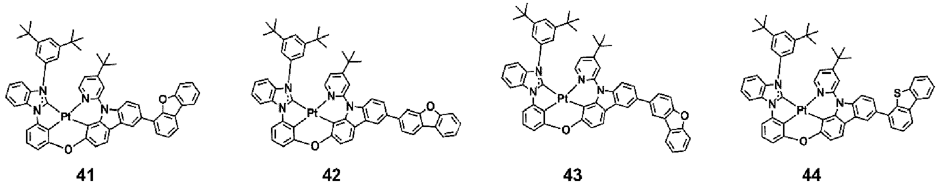

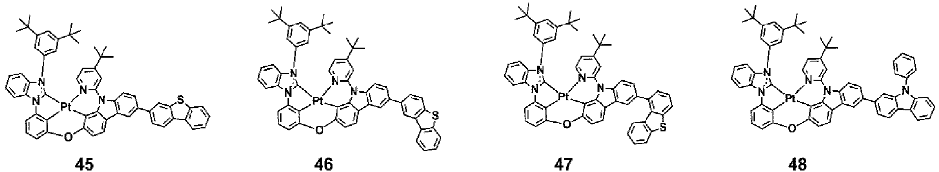

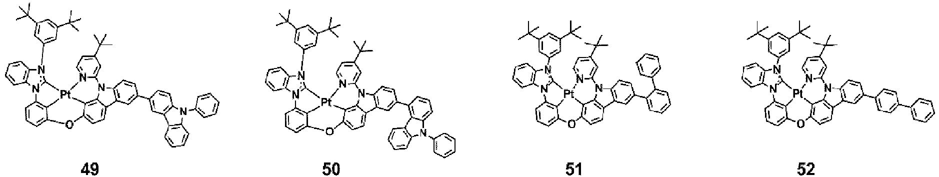

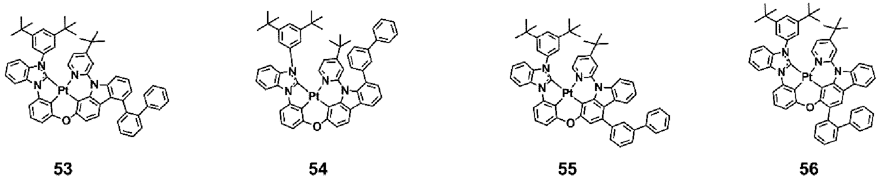

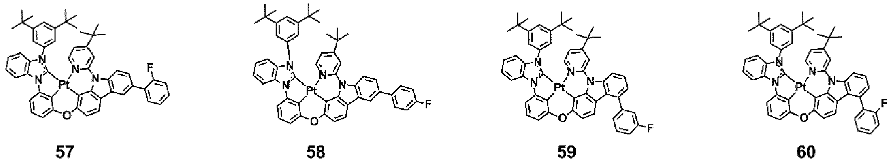

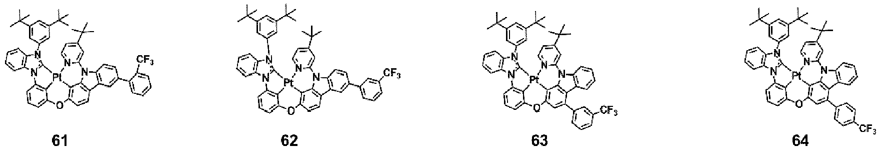

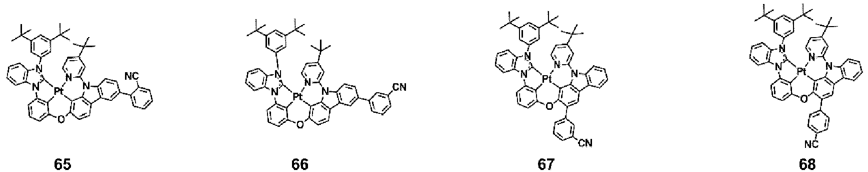

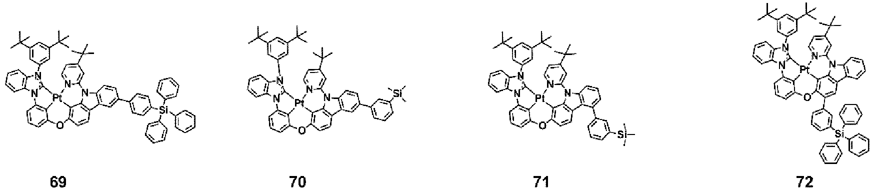

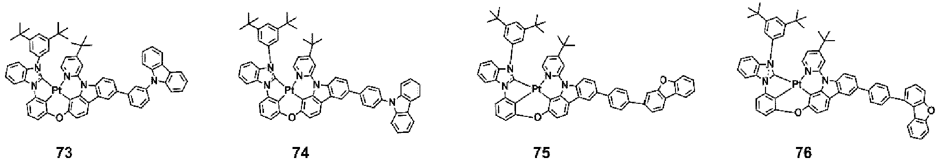

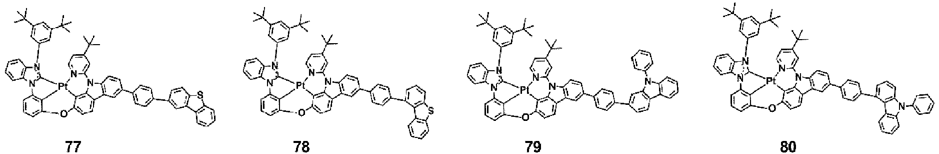

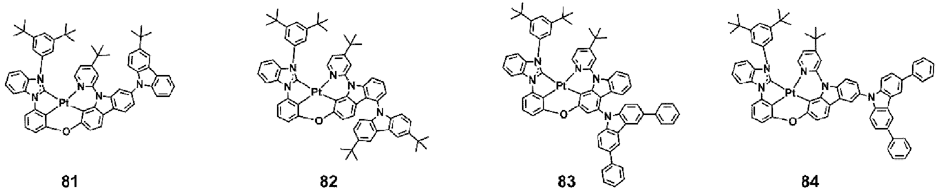

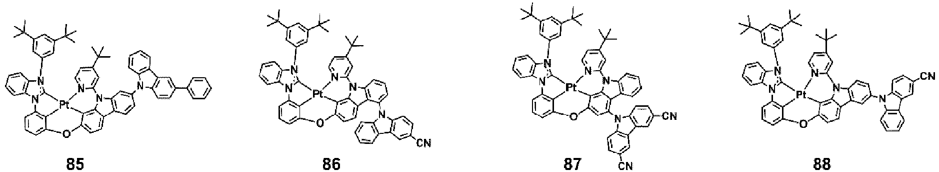

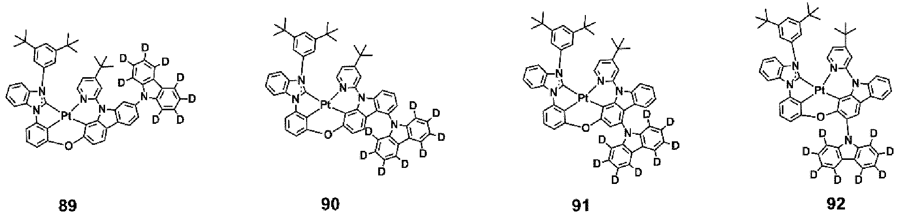

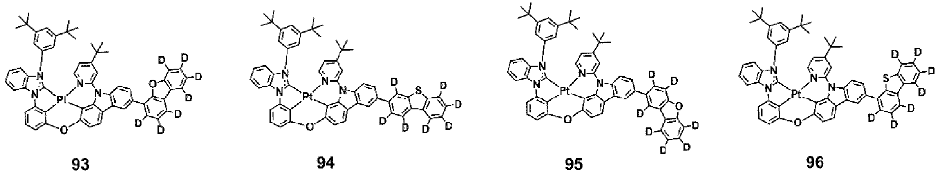

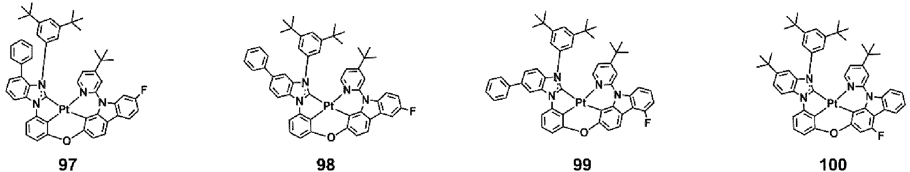

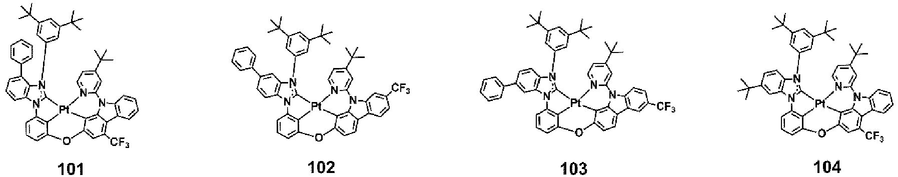

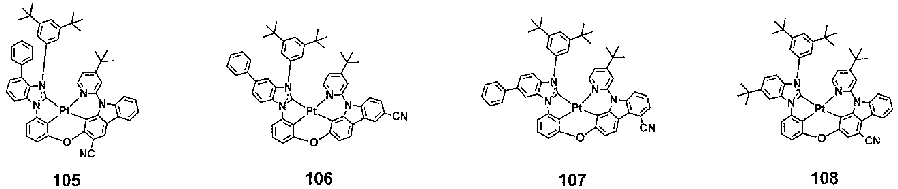

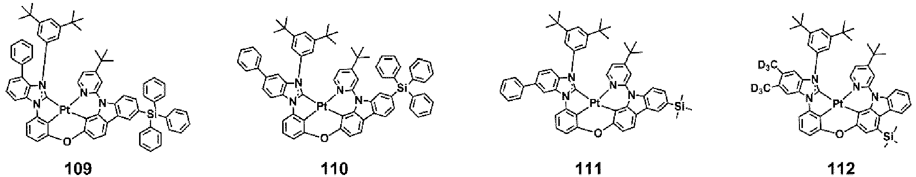

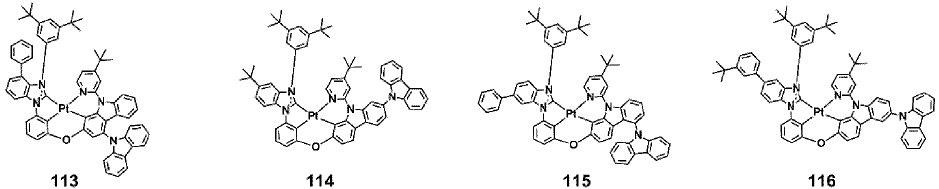

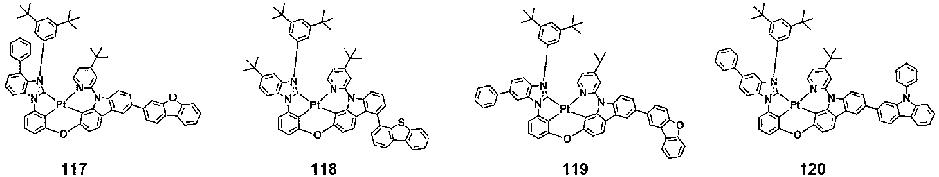

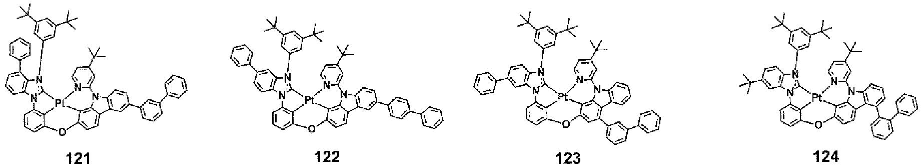

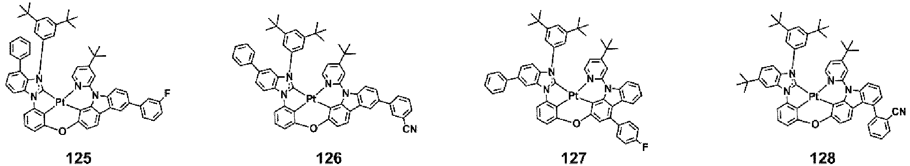

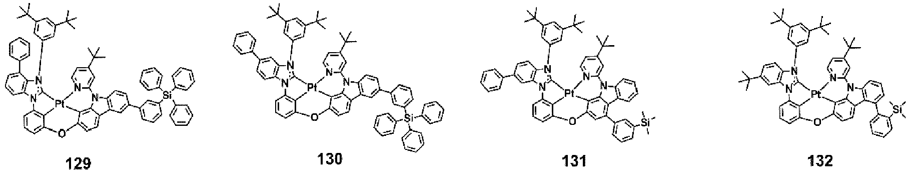

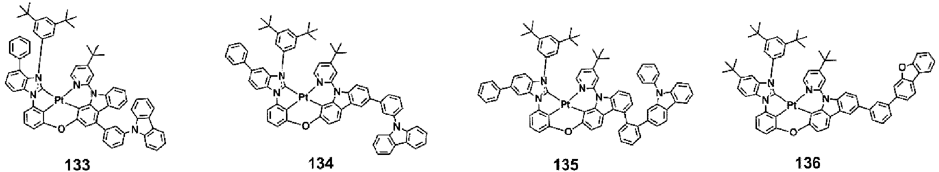

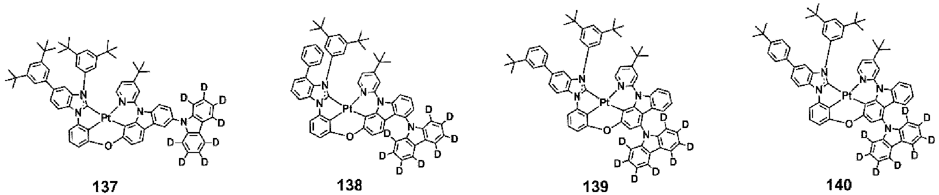

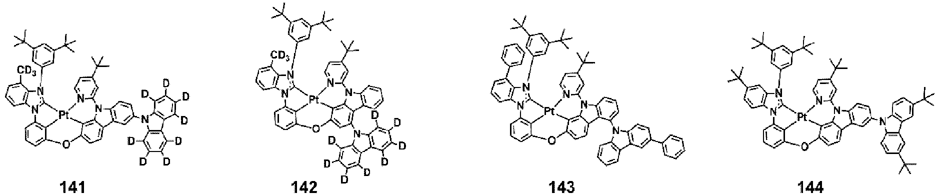

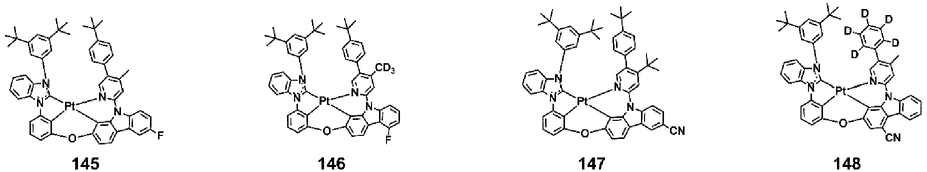

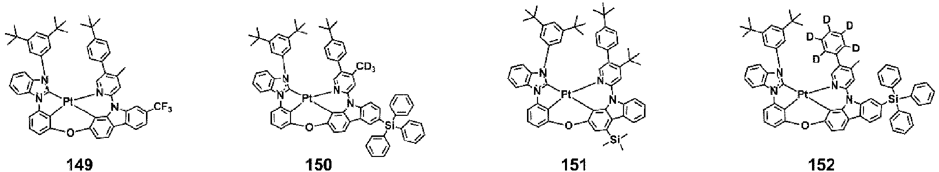

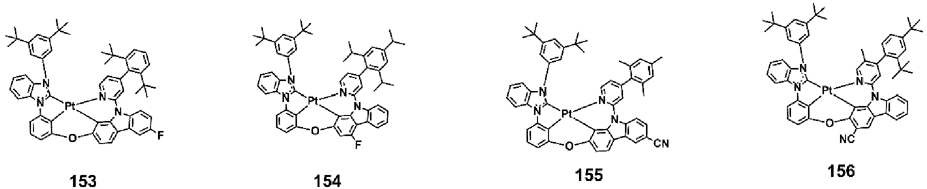

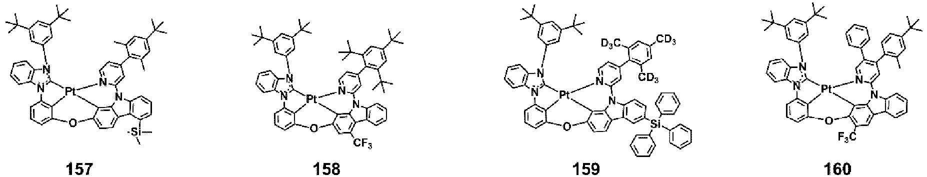

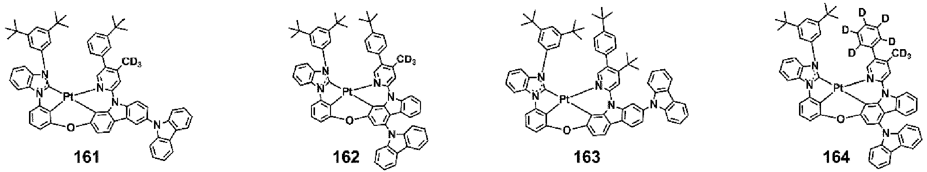

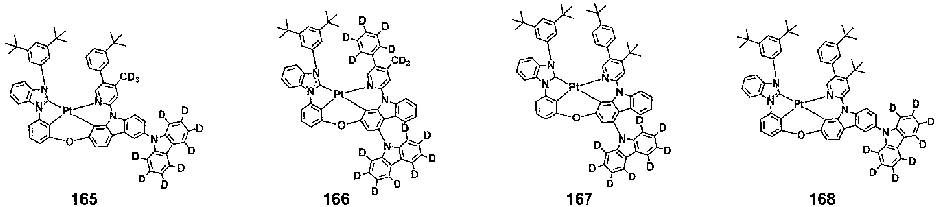

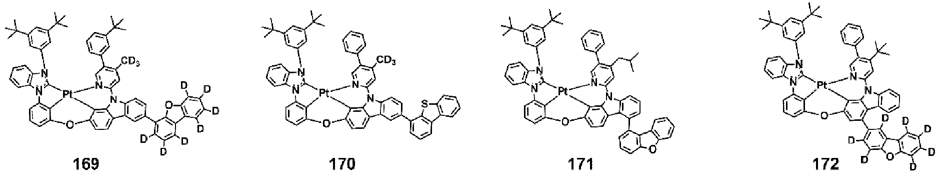

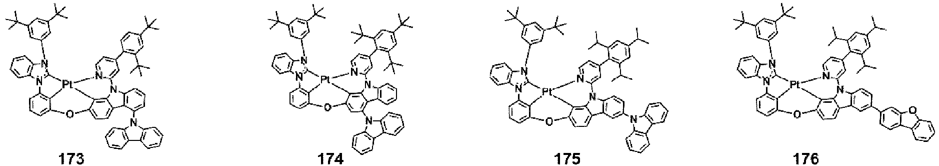

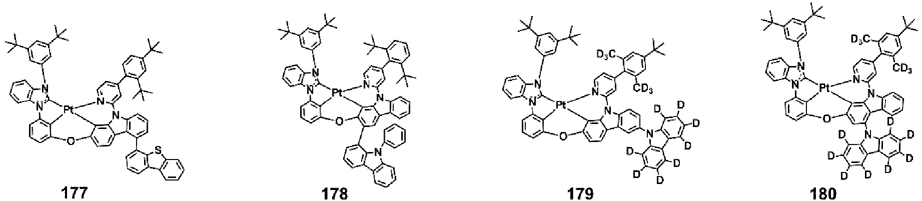

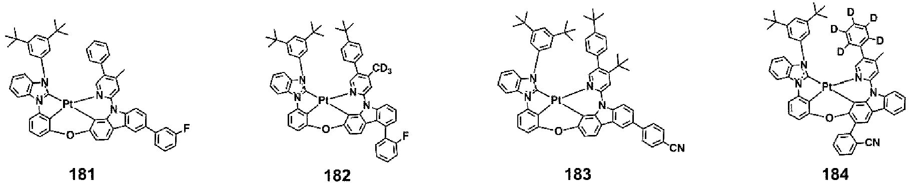

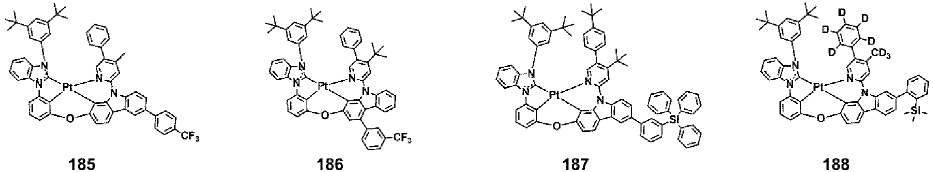

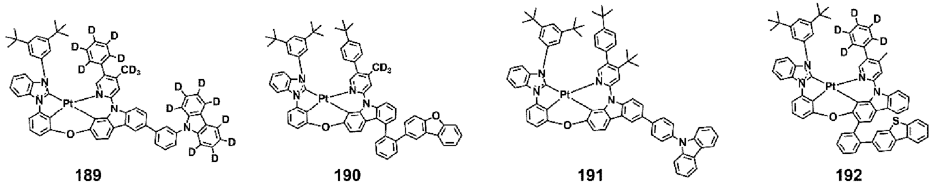

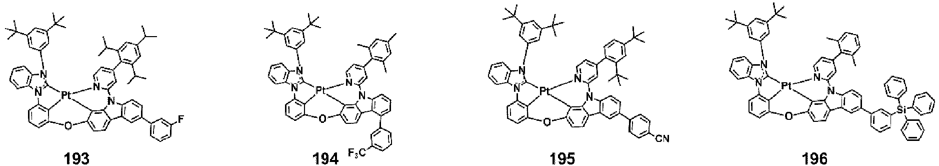

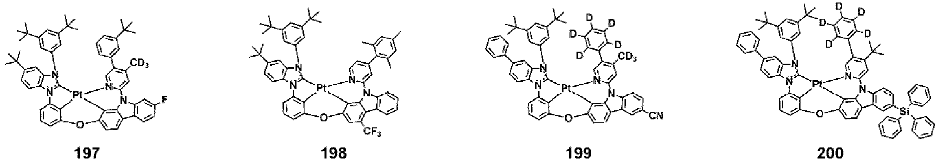

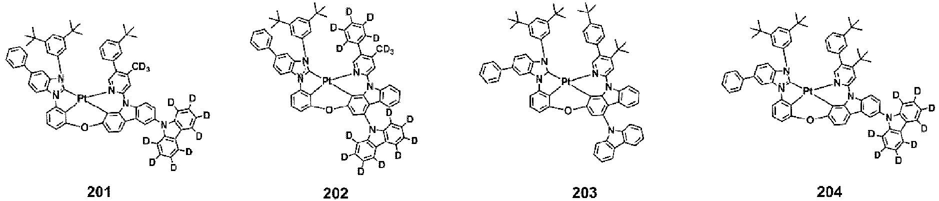

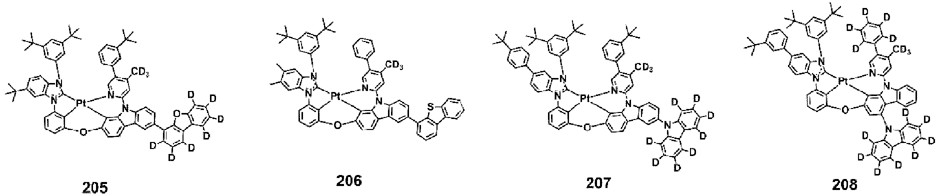

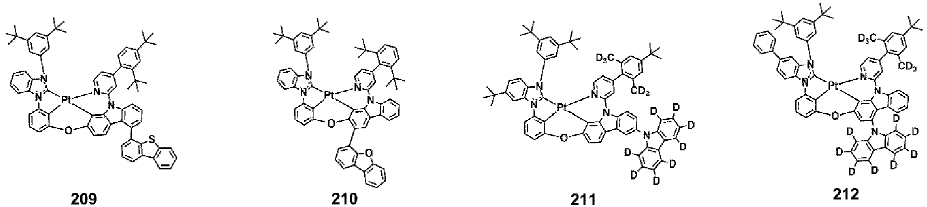

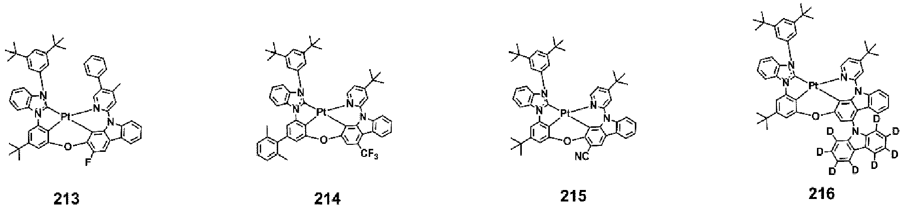

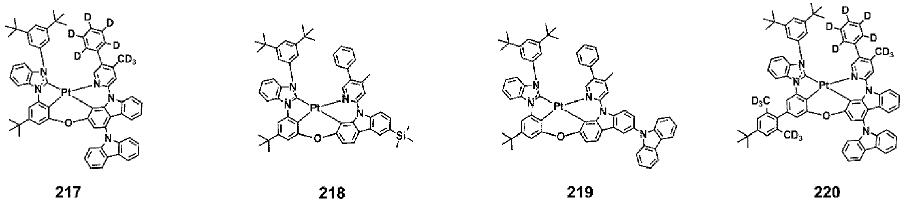

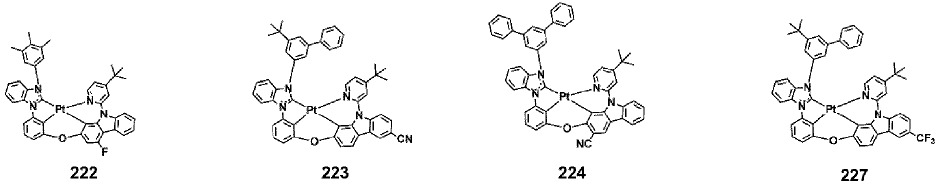

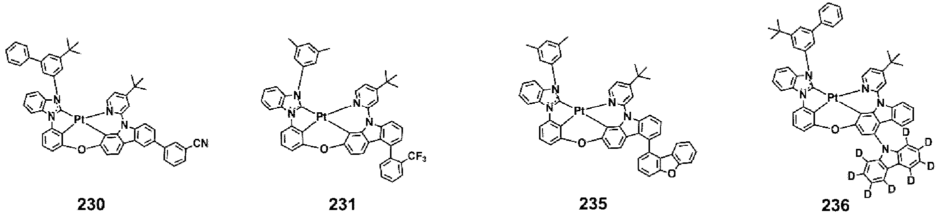

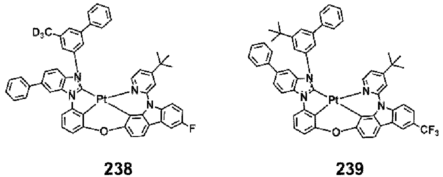

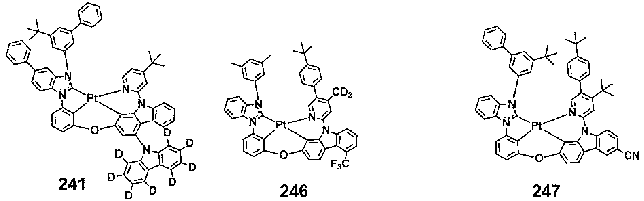

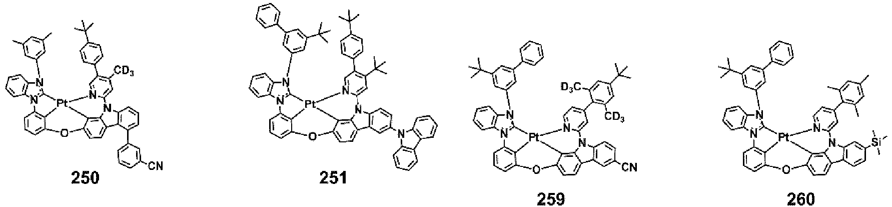

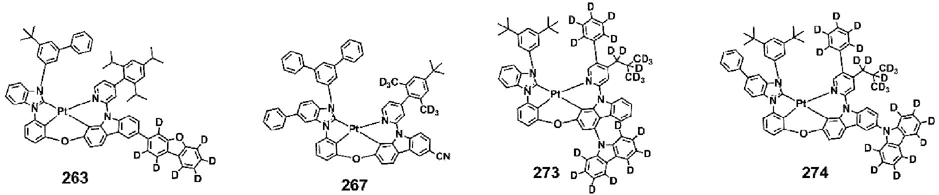

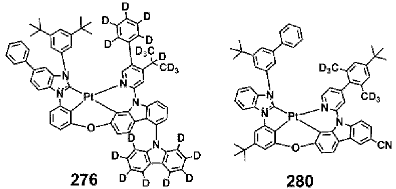

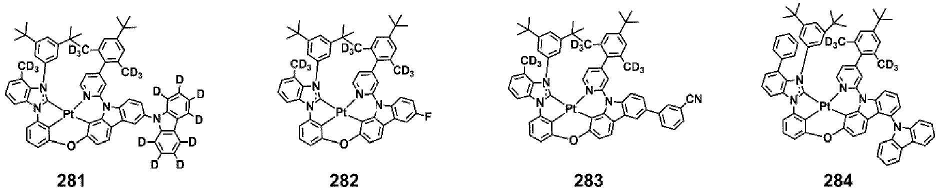

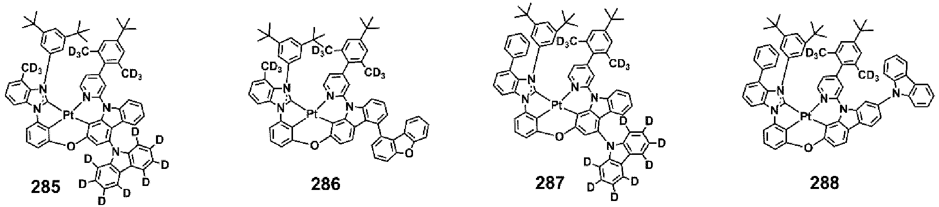

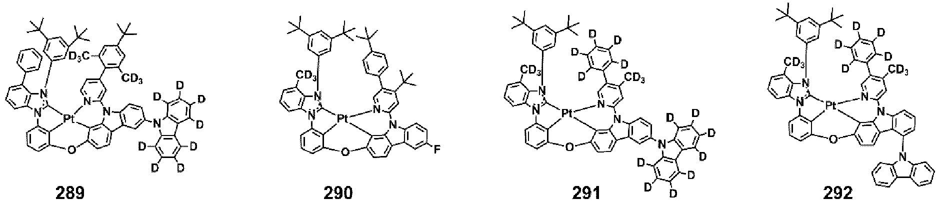

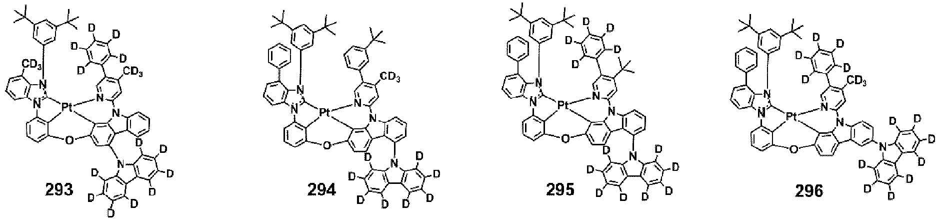

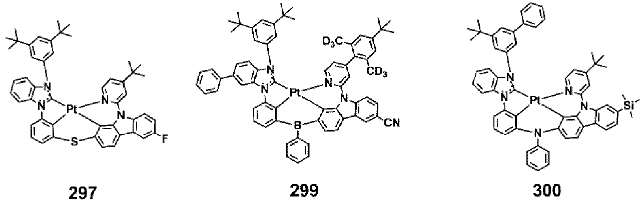

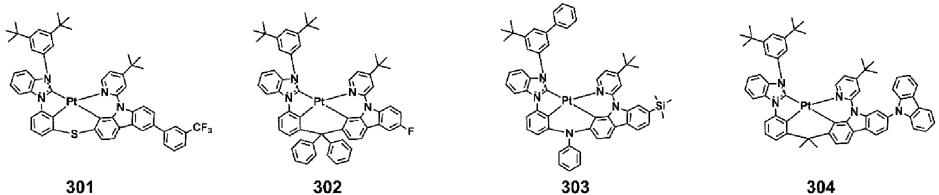

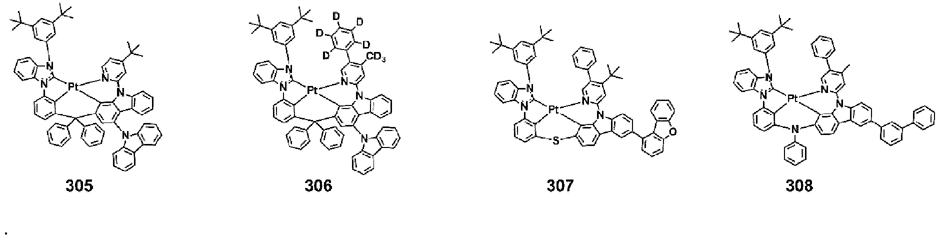

8. An organic light-emitting device, comprising:
a first electrode;
a second electrode; and
an organic layer located between the first electrode and the second electrode,
wherein the organic layer comprises an emission layer, and
wherein the organic layer further comprises at least one organometallic compound of any of claims 1-7.

9. The organic light-emitting device of claim 8, wherein the emission layer comprises the at least one organometallic compound.

10. The organic light-emitting device of claim 9, wherein the emission layer further comprises a host, and a content of the host in the emission layer is greater than a content of the at least one organometallic compound in the emission layer; and/or
wherein the emission layer emits blue light having a maximum emission wavelength in a range of 410 nanometers to 490 nanometers.

11. The organic light-emitting device of claims 9 or 10, wherein
the emission layer further comprises a fluorescent dopant,
wherein the fluorescent dopant is different from the at least one organometallic compound, and
at least 80 % or greater of total emission from the emission layer is emitted from the fluorescent dopant;
preferably wherein the fluorescent dopant comprises a compound represented by Formula 503-1 or Formula 503-2: 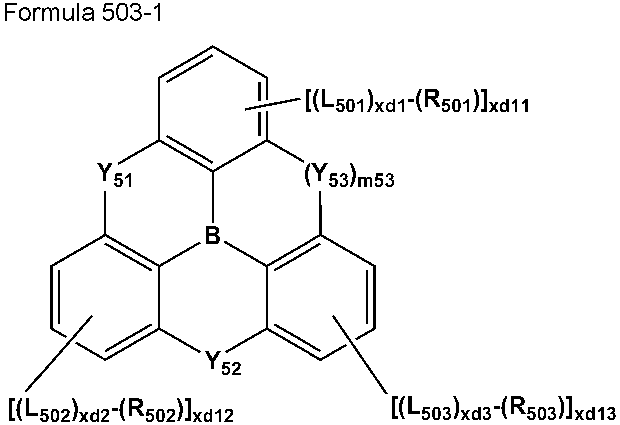 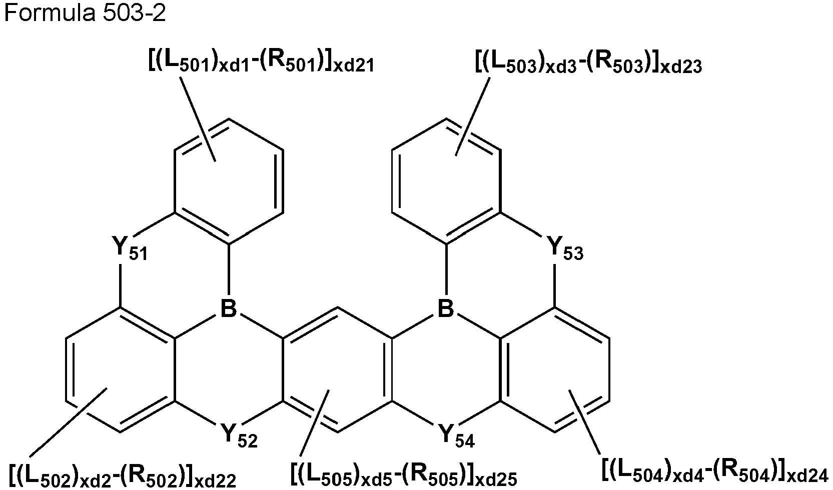
wherein, in Formulae 503-1 and 503-2,
Y₅₁ to Y₅₄ are each independently a single bond, O, S, N[(L₅₀₆)_{xd6}-R₅₀₆], C[(L₅₀₆)_{xd6}-R₅₀₆][(L₅₀₇)_{xd7}-R₅₀₇], or Si[(L₅₀₆)_{xd6}-R₅₀₆][(L₅₀₇)_{xd7}-R₅₀₇],
m53 is 0 or 1,
L₅₀₁ to L₅₀₇ are each independently a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, or a substituted or unsubstituted divalent non-aromatic condensed heteropolycyclic group,
xd1 to xd7 are each independently 0, 1, 2, or 3,
R₅₀₁ to R₅₀₇ are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
when m53 is 0, xd11 and xd13 are each independently 0, 1, 2, 3, or 4,
when m53 is 1, xd11 and xd13 are each independently 0, 1, 2, or 3,
xd21 and xd23 are each independently 0, 1, 2, 3, or 4,
xd12, xd22, and xd24 are each independently 0, 1, 2, or 3,
xd25 is 0, 1, or 2, and
two or more of R₅₀₁ to R₅₀₇ are optionally bonded to each other to form a substituted or unsubstituted C₅-C₃₀ carbocyclic group or a substituted or unsubstituted C₁-C₃₀ heterocyclic group.

12. An electronic apparatus, comprising the organic light-emitting device of any of claims 8-11.

## Patentansprüche

1. Organometallische Verbindung, dargestellt durch Formel 1: 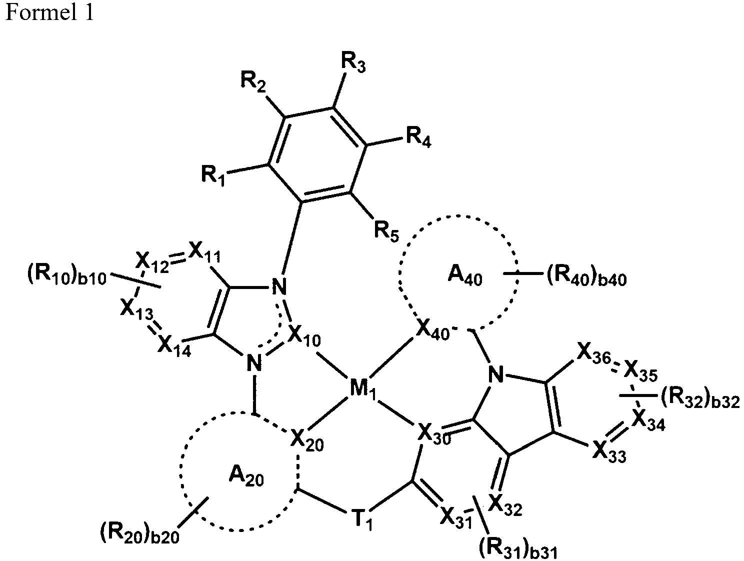 wobei, in Formel 1,
M₁ Iridium (Ir), Platin (Pt), Osmium (Os), Titan (Ti), Zirconium (Zr), Hafnium (Hf), Europium (Eu), Terbium (Tb), Thulium (Tm), Rhodium (Rh), Palladium (Pd) oder Gold (Au) ist,
X₁₀ C ist,
X₁₁ bis X₁₄, X₂₀, X₃₀ bis X₃₆ und X₄₀ jeweils unabhängig C oder N sind,
Ring A₂₀ und Ring A₄₀ jeweils unabhängig eine carbocyclische C₅-C₃₀-Gruppe oder eine heterocyclische C₁-C₃₀-Gruppe sind,
T₁ *-N(R₅₁)-*', *-B(R₅₁)-*', *-P(R₅₁)-*', *-C(R₅₁)(R₅₂)-*', *-Si(R₅₁)(R₅₂)-*', *-Ge(R₅₁)(R₅₂)-*', *-S-*', *-Se-*', *-O-*', *-C(=O)-*', *-S(=O)-*', *-S(=O)₂-*', *-C(R₅₁)=C(R₅₂)-*', *-C(=S)-*' oder *-C≡C-*' ist, wobei * und *' jeweils eine Bindungsstelle zu einem benachbarten Atom angeben,
R₂ und R₄ jeweils unabhängig eine substituierte oder unsubstituierte C₁-C₆₀-Alkylgruppe oder eine substituierte oder unsubstituierte C₆-C₆₀-Arylgruppe sind,
R₁, R₃, R₅, R₁₀, R₂₀, R₃₁, R₃₂, R₄₀, R₅₁ und R₅₂ jeweils unabhängig Wasserstoff, Deuterium, -F, -Cl, -Br, -I, -SF₅, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nicht-aromatische kondensierte polycyclische Gruppe, eine substituierte oder unsubstituierte einwertige nicht-aromatische kondensierte heteropolycyclische Gruppe, -N(Q₁)(Q₂), - Si(Q₃)(Q₄)(Q₅), -B(Q₆)(Q₇), -P(Q₈)(Q₉) oder -P(=O)(Q₈)(Q₉) sind,
zwei oder mehr von R₁₀, R₂₀, R₃₁, R₃₂, R₄₀, R₅₁ und R₅₂ optional aneinander gebunden sind, um eine substituierte oder unsubstituierte carbocyclische C₅-C₃₀-Gruppe oder eine substituierte oder unsubstituierte heterocyclische C₁-C₃₀-Gruppe zu bilden,
b10 und b32 jeweils unabhängig eine ganze Zahl von 1 bis 4 sind,
b20 und b40 jeweils unabhängig eine ganze Zahl von 1 bis 10 sind,
b31 1 oder 2 ist,
vorausgesetzt, dass mindestens eines von R₃₁(s) in der Anzahl von b31 oder R₃₂(s) in der Anzahl von b32 Folgendes ist:
-F, eine Cyanogruppe, -CF₃, -CF₂H, -CFH₂, -Si(Q₃)(Q₄)(Q₅) oder eine Gruppe, die durch eine der Formeln 3-1 bis 3-55 dargestellt ist,
wobei Q₃ bis Q₅ jeweils unabhängig eine Methylgruppe, eine Ethylgruppe, eine n-Propylgruppe, eine Isopropylgruppe, eine n-Butylgruppe, eine sec-Butylgruppe, eine Isobutylgruppe, eine tert-Butylgruppe, eine n-Pentylgruppe, eine tert-Pentylgruppe, eine Neopentylgruppe, eine Isopentylgruppe, eine sec-Pentylgruppe, eine 3-Pentylgruppe, eine sec-Isopentylgruppe, eine Phenylgruppe, eine Biphenylgruppe oder eine Naphthylgruppe sind, jeweils unsubstituiert oder substituiert mit mindestens einem von Deuterium, -F, einer C₁-C₁₀-Alkylgruppe, einer Phenylgruppe oder einer Kombination davon: 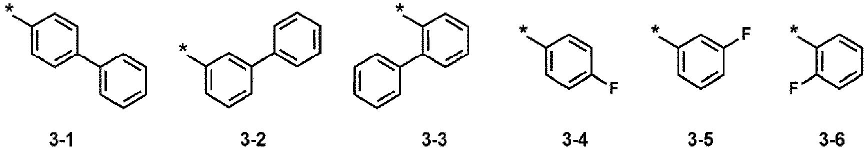 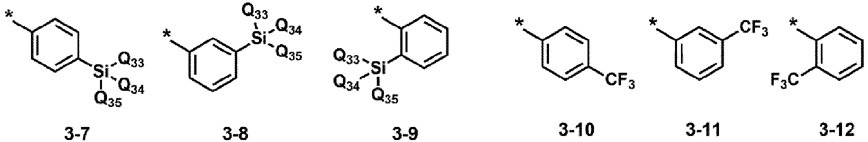 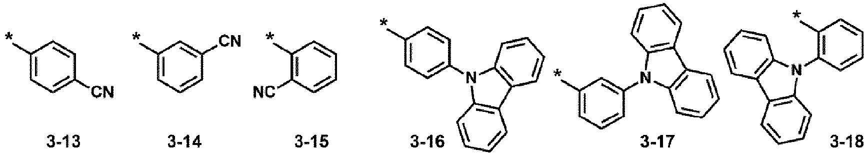 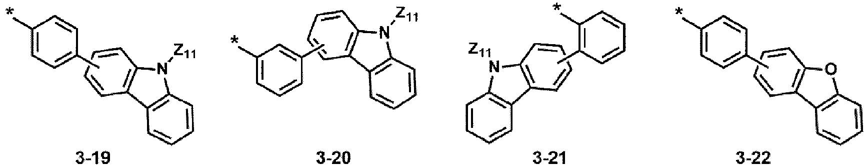 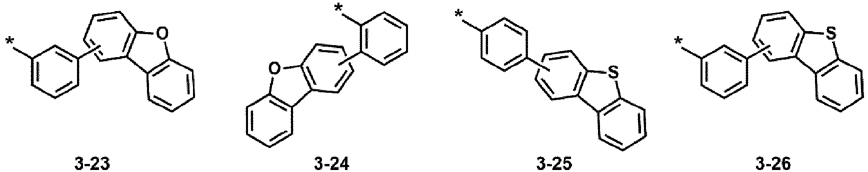 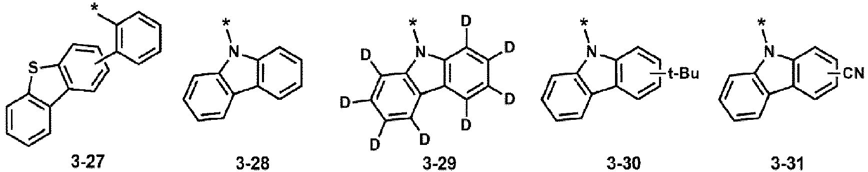 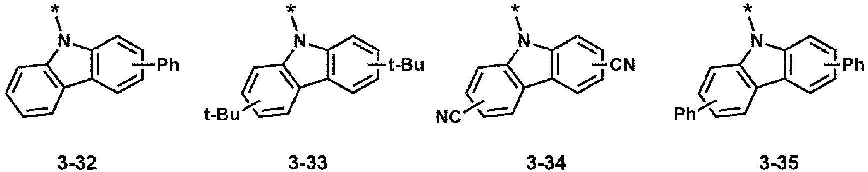 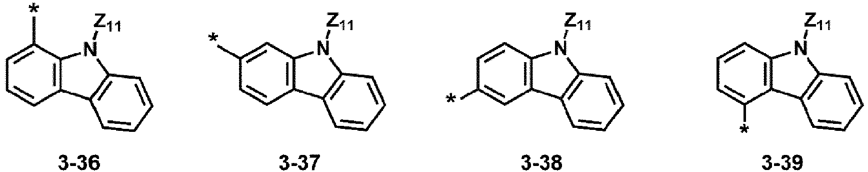 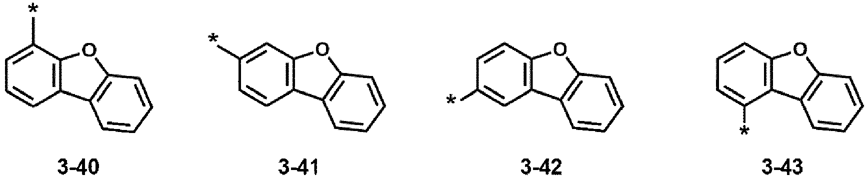 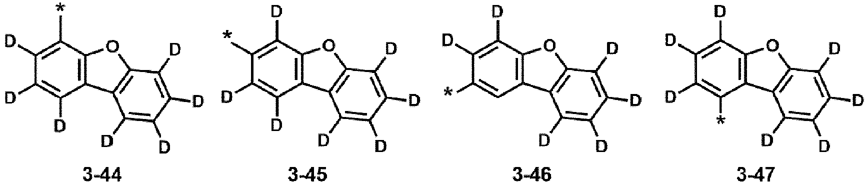 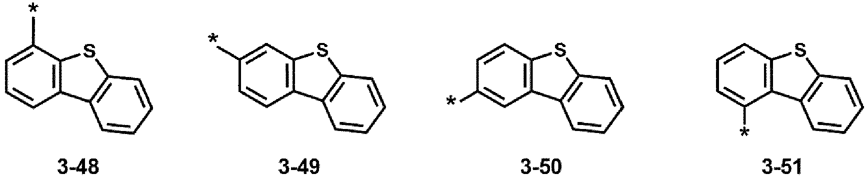 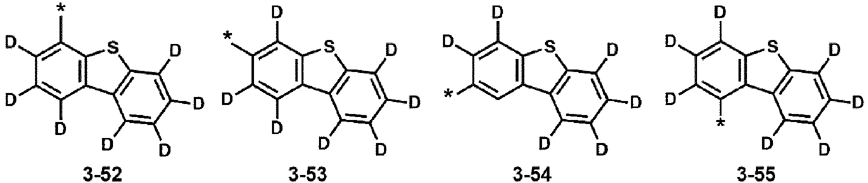
wobei, in Formel 3-1 bis 3-55,
Q₃₃ bis Q₃₅ und Z₁₁ jeweils unabhängig eine Methylgruppe, eine Ethylgruppe, eine n-Propylgruppe, eine Isopropylgruppe, eine n-Butylgruppe, eine sec-Butylgruppe, eine Isobutylgruppe, eine tert-Butylgruppe, eine n-Pentylgruppe, eine tert-Pentylgruppe, eine Neopentylgruppe, eine Isopentylgruppe, eine sec-Pentylgruppe, eine 3-Pentylgruppe, eine sec-Isopentylgruppe, eine Phenylgruppe, eine Biphenylgruppe oder eine Naphthylgruppe sind, jeweils unsubstituiert oder substituiert mit mindestens einem von Deuterium, -F, einer C₁-C₁₀-Alkylgruppe, einer Phenylgruppe oder einer Kombination davon,
t-Bu eine tert-Butylgruppe darstellt, Ph eine Phenylgruppe darstellt und
* eine Bindungsstelle zu einem benachbarten Atom angibt und
ein Substituent jeder der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₁-C₆₀-Heteroaryloxygruppe, der substituierten C₁-C₆₀-Heteroarylthiogruppe, der substituierten einwertigen nicht-aromatischen kondensierten polycyclischen Gruppe, der substituierten einwertigen nicht-aromatischen kondensierten heteropolycyclischen Gruppe, der substituierten carbocyclischen C₅-C₃₀-Gruppe und der substituierten heterocyclischen C₁-C₃₀-Gruppe Folgendes ist:
Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils unsubstituiert oder substituiert mit mindestens einem von Deuterium, -F, -Cl, -Br, -I, -SF₅, -CD₃, -CD₂H, -CDH₂, -CF₃, -CF₂H, - CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₁-C₆₀-Heteroaryloxygruppe, einer C₁-C₆₀-Heteroarylthiogruppe, einer einwertigen nicht-aromatischen kondensierten polycyclischen Gruppe, einer einwertigen nicht-aromatischen kondensierten heteropolycyclischen Gruppe, - N(Q₁₁)(Q₁₂), -Si(Q₁₃)(Q₁₄)(Q₁₅), -B(Q₁₆)(Q₁₇), -P(Q₁₈)(Q₁₉), -P(=O)(Q₁₈)(Q₁₉) oder einer Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nicht-aromatische kondensierte polycyclische Gruppe oder eine einwertige nicht-aromatische kondensierte heteropolycyclische Gruppe, jeweils unsubstituiert oder substituiert mit mindestens einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer einwertigen nicht-aromatischen kondensierten polycyclischen Gruppe, einer einwertigen nicht-aromatischen kondensierten heteropolycyclischen Gruppe, - N(Q₂₁)(Q₂₂), -Si(Q₂₃)(Q₂₄)(Q₂₅), -B(Q₂₆)(Q₂₇), -P(Q₂₈)(Q₂₉), -P(=O)(Q₂₈)(Q₂₉) oder einer Kombination davon;
-N(Q₃₁)(Q₃₂), -Si(Q₃₃)(Q₃₄)(Q₃₅), -B(Q₃₆)(Q₃₇), -P(Q₃₈)(Q₃₉) oder -P(=O)(Q₃₈)(Q₃₉); oder
einer Kombination davon,
wobei Q₁ bis Q₉, Q₁₁ bis Q₁₉, Q₂₁ bis Q₂₉ und Q₃₁ bis Q₃₉ jeweils unabhängig Folgendes sind: Wasserstoff, Deuterium, -F, -Cl, -Br, -I, -SF₅, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe.

2. Organometallische Verbindung nach Anspruch 1, wobei M₁ in Formel 1 Platin (Pt), Palladium (Pd) oder Gold (Au) ist; und/oder
wobei Ring A₂₀ und Ring A₄₀ in Formel 1 jeweils unabhängig eine Cyclopentangruppe, eine Cyclopentengruppe, eine Cyclohexangruppe, eine Cyclohexengruppe, eine Cyclohexadiengruppe, eine Benzolgruppe, eine Naphthalengruppe, eine Anthracengruppe, eine Phenanthrengruppe, eine Triphenylengruppe, eine Pyrengruppe, eine Chrysengruppe, eine Cyclopentadiengruppe, eine 1,2,3,4-Tetrahydronaphthalengruppe, eine Thiophengruppe, eine Furangruppe, eine Borolgruppe, eine Phospholgruppe, eine Germolgruppe, eine Selenophengruppe, eine Indolgruppe, eine Benzoborolgruppe, eine Benzophospholgruppe, eine Indengruppe, eine Benzosilolgruppe, eine Benzogermolgruppe, eine Benzothiophengruppe, eine Benzoselenophengruppe, eine Benzofurangruppe, eine Carbazolgruppe, eine Dibenzoborolgruppe, eine Dibenzophospholgruppe, eine Fluorengruppe, eine Dibenzosilolgruppe, eine Dibenzogermolgruppe, eine Dibenzothiophengruppe, eine Dibenzoselenophengruppe, eine Dibenzofurangruppe, eine Dibenzothiophen-5-Oxidgruppe, eine 9H-Fluoren-9-on-Gruppe, eine Dibenzothiophen-5,5-Dioxidgruppe, eine Azaindolgruppe, eine Azabenzoborolgruppe, eine Azabenzophospholgruppe, eine Azaindengruppe, eine Azabenzosilolgruppe, eine Azabenzogermolgruppe, eine Azabenzothiophengruppe, eine Azabenzoselenophengruppe, eine Azabenzofurangruppe, eine Azacarbazolgruppe eine Azadibenzoborolgruppe, eine Azadibenzophospholegruppe, eine Azafluorengruppe, eine Azadibenzosilolgruppe, eine Azadibenzogermolgruppe, eine Azadibenzothiophengruppe, eine Azadibenzoselenophengruppe, eine Azadibenzofurangruppe, eine Azadibenzothiophen-5-Oxidgruppe, eine Aza-9H-fluoren-9-on-Gruppe, eine Azadibenzothiophen-5,5-Dioxidgruppe, eine Pyridingruppe, eine Pyrimidingruppe, eine Pyrazingruppe, eine Pyridazingruppe, eine Triazingruppe, eine Chinolingruppe, eine Isochinolingruppe, eine Chinoxalingruppe, eine Chinazolingruppe, eine Phenanthrolingruppe, eine Pyrrolgruppe, eine Pyrazolgruppe, eine Imidazolgruppe, eine Triazolgruppe, eine Oxazolgruppe, eine Isoxazolgruppe, eine Thiazolgruppe, eine Isothiazolgruppe, eine Oxadiazolgruppe, eine Thiadiazolgruppe, eine Thiadiazolgruppe, eine Benzopyrazolgruppe, eine Benzimidazolgruppe, eine Benzoxazolgruppe, eine Benzothiazolgruppe, eine Benzoxadiazolgruppe, eine Benzothiadiazolgruppe, eine 5,6,7,8-Tetrahydroisochinolingruppe, eine 5,6,7,8-Tetrahydrochinolingruppe, eine Adamantangruppe, eine Norbomangruppe oder eine Norbornengruppe sind.

3. Organometallische Verbindung nach Anspruch 1 oder 2, wobei Ring A₂₀ in Formel 1 durch eine von Formel A20(1) bis A20(15) dargestellt ist: 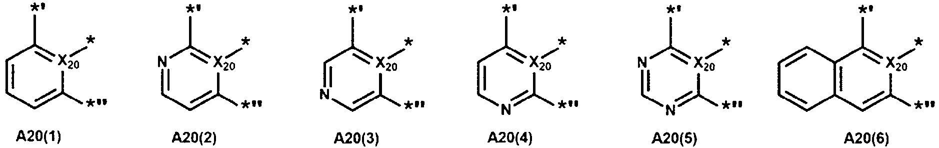 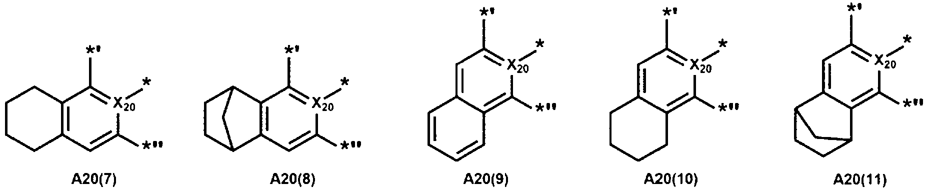 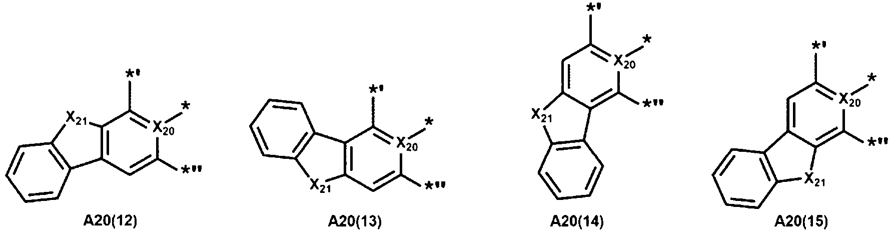
wobei, in Formel A20(1) bis A20(15),
X₂₀ C oder N ist,
X₂₁ O, S, N(R₂₁), C(R₂₁)(R₂₂) oder Si(R₂₁)(R₂₂) ist,
R₂₁ und R₂₂ jeweils unabhängig wie für R₂₀ in Anspruch 1 definiert sind,
* eine Bindungsstelle zu M₁ in Formel 1 angibt,
*' eine Bindungsstelle zu N in Formel 1 angibt und
*" eine Bindungsstelle zu T₁ in Formel 1 angibt; und/oder
wobei Ring A₄₀ in Formel 1 durch eine von Formel A40(1) bis A40(34) dargestellt ist: 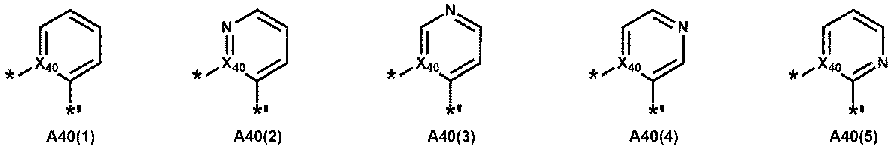 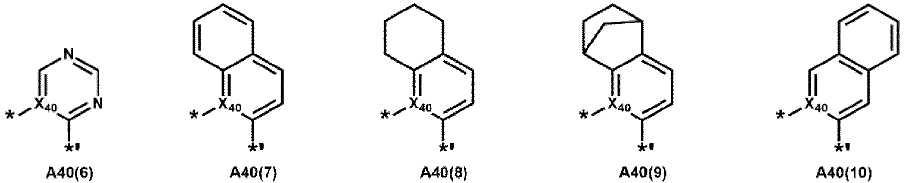 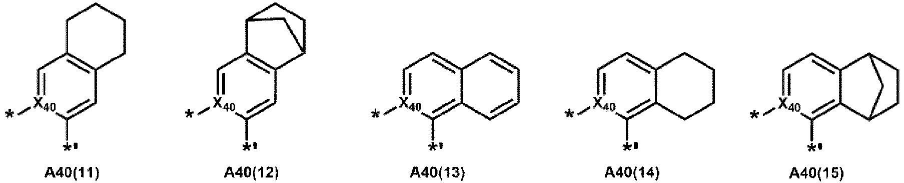 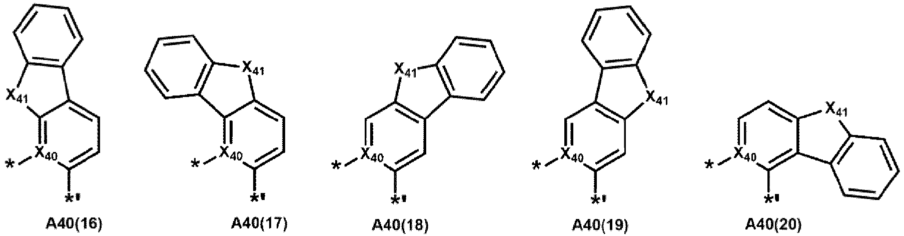 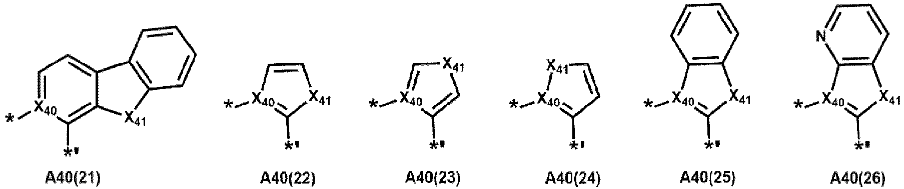 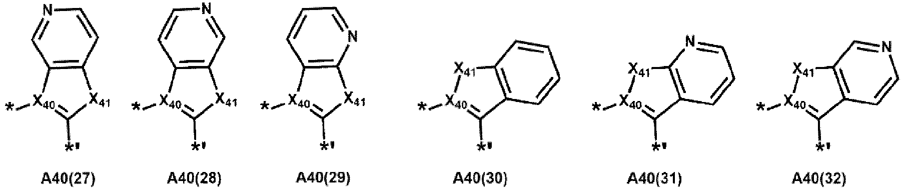 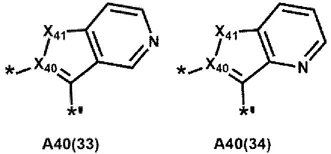
wobei, in Formel A40(1) bis A40(34),
X₄₀ C oder N ist,
X₄₁ O, S, N(R₄₁), C(R₄₁)(R₄₂) oder Si(R₄₁)(R₄₂) ist,
R₄₁ und R₄₂ jeweils unabhängig wie für R₄₀ in Anspruch 1 definiert sind,
* eine Bindungsstelle zu M₁ in Formel 1 angibt und
*' eine Bindungsstelle zu N in Formel 1 angibt.

4. Organometallische Verbindung nach einem der Ansprüche 1-3, wobei R₂ in Formel 1 Folgendes ist:
eine Methylgruppe, eine Ethylgruppe, eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine n-Hexylgruppe, eine Isohexylgruppe, eine sec-Hexylgruppe, eine tert-Hexylgruppe, eine n-Heptylgruppe, eine Isoheptylgruppe, eine sec-Heptylgruppe, eine tert-Heptylgruppe, eine n-Octylgruppe, eine Isooctylgruppe, eine sec-Octylgruppe, eine tert-Octylgruppe, eine n-Nonylgruppe, eine Isononylgruppe, eine sec-Nonylgruppe, eine tert-Nonylgruppe, eine n-Decylgruppe, eine Isodecylgruppe, eine sec-Decylgruppe oder eine tert-Decylgruppe, jeweils unsubstituiert oder substituiert mit mindestens einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon oder einer Kombination davon; oder
eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe oder eine Chrysenylgruppe, jeweils unsubstituiert oder substituiert mit mindestens einem von Deuterium, -F, -Cl, -Br, -I, -SF₅, -CD₃, -CD₂H, -CDH₂, CF₃, CF₂H, CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe oder einer Kombination davon.

5. Organometallische Verbindung nach einem der Ansprüche 1-4, wobei, in Formel 1,
i) R₁ und R₃ bis R₅ jeweils Wasserstoff sind,
ii) R₁, R₃ und R₅ jeweils Wasserstoff sind und
R₄ Folgendes ist:
eine Methylgruppe, eine Ethylgruppe, eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine n-Hexylgruppe, eine Isohexylgruppe, eine sec-Hexylgruppe, eine tert-Hexylgruppe, eine n-Heptylgruppe, eine Isoheptylgruppe, eine sec-Heptylgruppe, eine tert-Heptylgruppe, eine n-Octylgruppe, eine Isooctylgruppe, eine sec-Octylgruppe, eine tert-Octylgruppe, eine n-Nonylgruppe, eine Isononylgruppe, eine sec-Nonylgruppe, eine tert-Nonylgruppe, eine n-Decylgruppe, eine Isodecylgruppe, eine sec-Decylgruppe oder eine tert-Decylgruppe, jeweils unsubstituiert oder substituiert mit mindestens einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon oder einer Kombination davon; oder
eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe oder eine Chrysenylgruppe, jeweils unsubstituiert oder substituiert mit mindestens einem von Deuterium, -F, -Cl, -Br, -I, -SF₅, -CD₃, -CD₂H, -CDH₂, CF₃, CF₂H, CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe oder einer Kombination davon, oder
iii) R₁ und R₅ jeweils Wasserstoff sind und
R₃ und R₄ jeweils unabhängig Folgendes sind:
eine Methylgruppe, eine Ethylgruppe, eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine n-Hexylgruppe, eine Isohexylgruppe, eine sec-Hexylgruppe, eine tert-Hexylgruppe, eine n-Heptylgruppe, eine Isoheptylgruppe, eine sec-Heptylgruppe, eine tert-Heptylgruppe, eine n-Octylgruppe, eine Isooctylgruppe, eine sec-Octylgruppe, eine tert-Octylgruppe, eine n-Nonylgruppe, eine Isononylgruppe, eine sec-Nonylgruppe, eine tert-Nonylgruppe, eine n-Decylgruppe, eine Isodecylgruppe, eine sec-Decylgruppe oder eine tert-Decylgruppe, jeweils unsubstituiert oder substituiert mit mindestens einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon oder einer Kombination davon; oder
eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe oder eine Chrysenylgruppe, jeweils unsubstituiert oder substituiert mit mindestens einem von Deuterium, -F, -Cl, -Br, -I, -SF₅, -CD₃, -CD₂H, -CDH₂, CF₃, CF₂H, CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe oder einer Kombination davon.

6. Organometallische Verbindung nach einem der Ansprüche 1-5, wobei eine Einheit, dargestellt durch 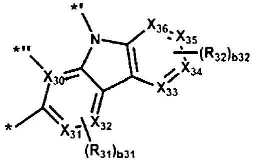
in Formel 1, durch eine der Formeln A30(1) bis A30(6) dargestellt ist: 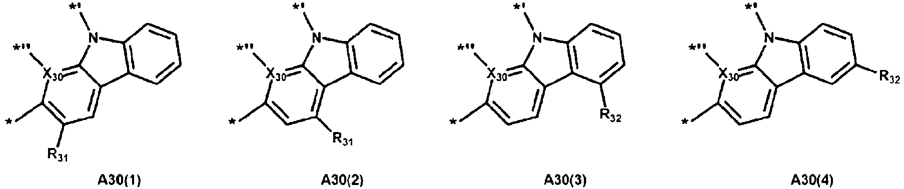 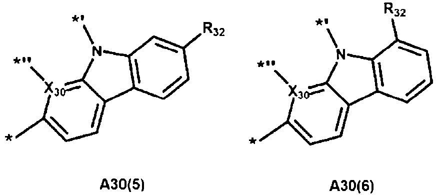
wobei, in Formel A30(1) bis A30(6),
R₃₁, R₃₂, X₃₀, Q₃ bis Q₅ und Q₃₃ bis Q₃₅ wie in Anspruch 1 definiert sind,
* und *' jeweils eine Bindungsstelle zu einem benachbarten Atom angeben und
*" eine Bindungsstelle zu M₁ angibt; und/oder
wobei die organometallische Verbindung dargestellt ist durch Formel 1A: 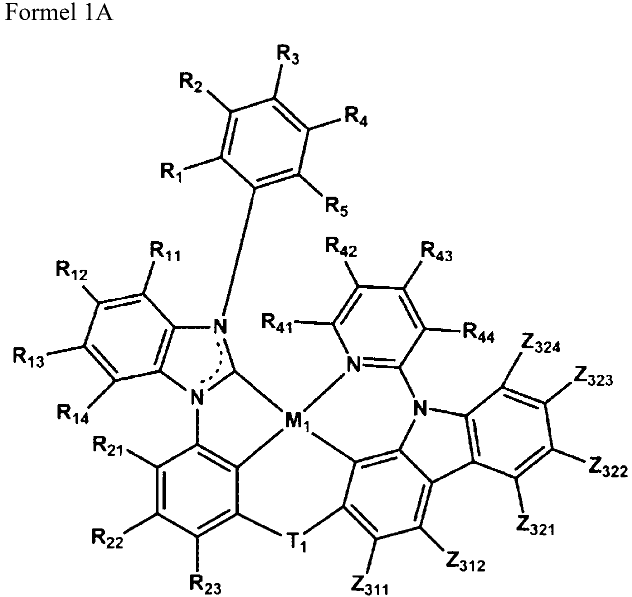
wobei, in Formel 1A,
M₁, T₁ und R₁ bis R₅ wie in Anspruch 1 definiert sind,
R₁₁ bis R₁₄ jeweils unabhängig wie für R₁₀ in Anspruch 1 definiert sind,
R₂₁ bis R₂₃ jeweils unabhängig wie für R₂₀ in Anspruch 1 definiert sind,
Z₃₁₁ und Z₃₁₂ jeweils unabhängig wie für R₃₁ in Anspruch 1 definiert sind,
Z₃₂₁ bis Z₃₂₄ jeweils unabhängig wie für R₃₂ in Anspruch 1 definiert sind,
R₄₁ bis R₄₄ jeweils unabhängig wie für R₄₀ in Anspruch 1 definiert sind.

7. Organometallische Verbindung nach Anspruch 1, wobei die organometallische Verbindung dargestellt ist durch eine oder mehrere der Verbindungen 1 bis 220, 222 bis 224, 227, 230, 231, 235, 236, 238, 239, 241, 246, 247, 250, 251, 259, 260, 263, 267, 273, 274, 276, 280 bis 297 und 299 bis 308:

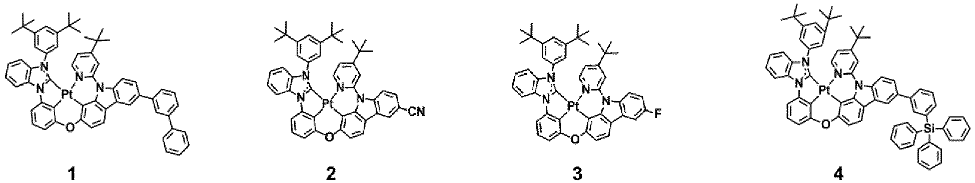

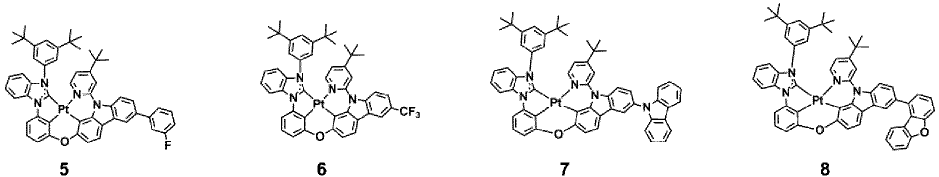

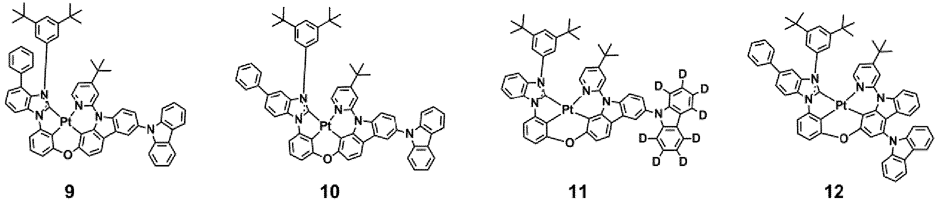

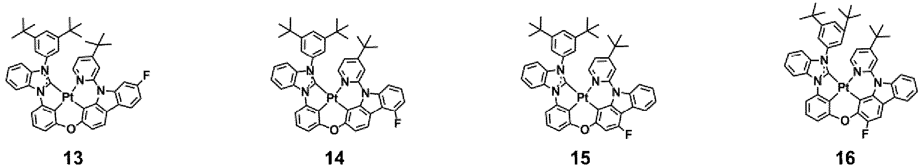

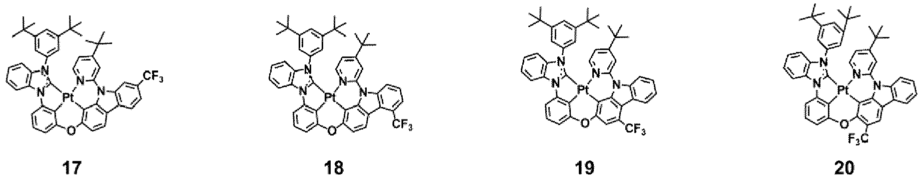

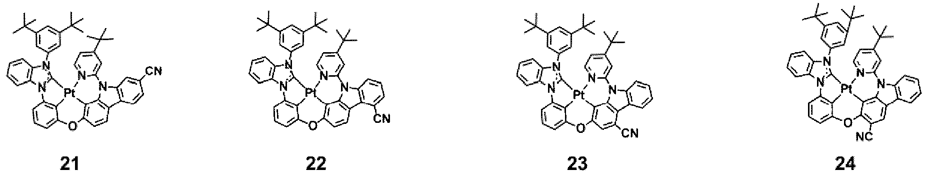

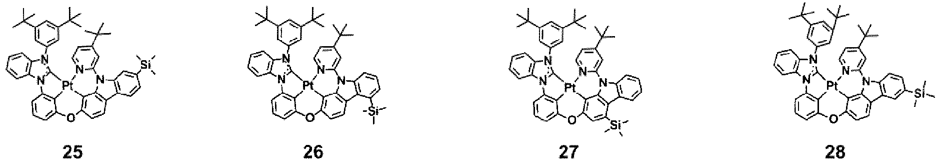

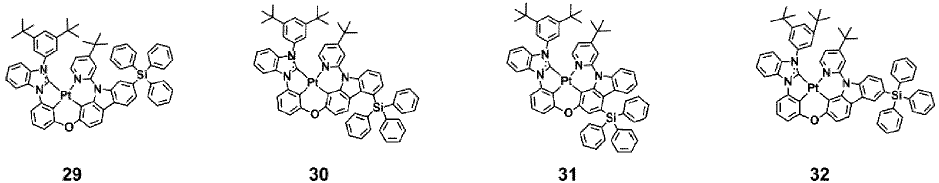

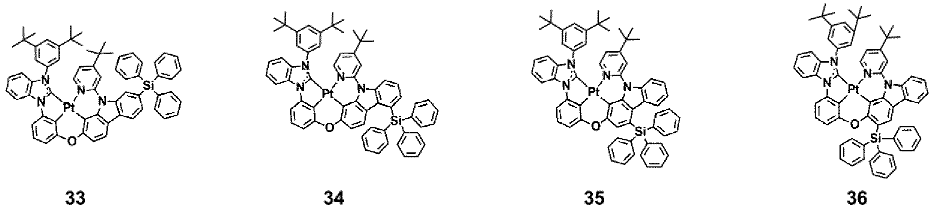

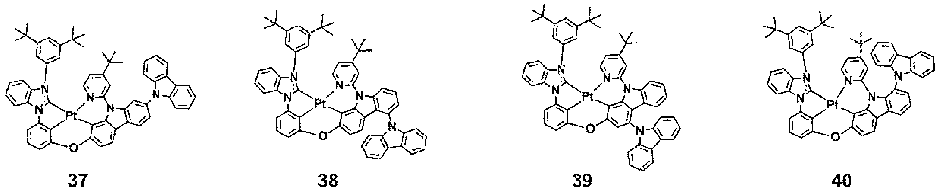

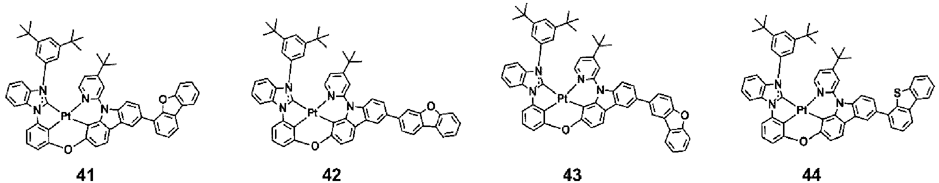

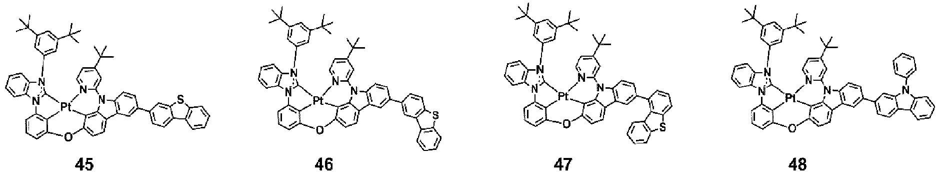

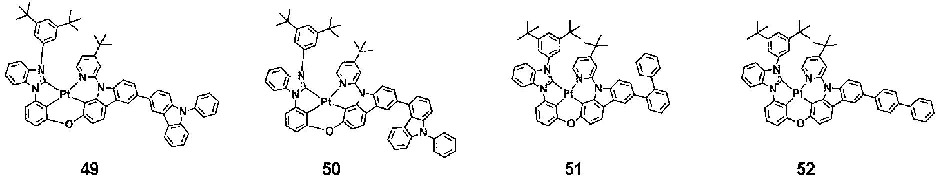

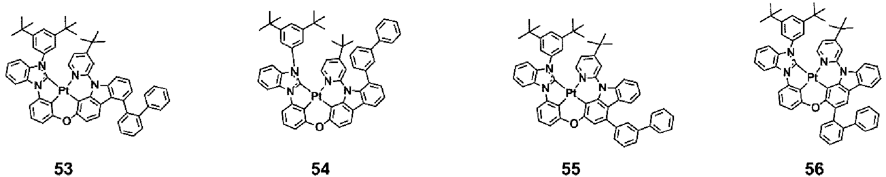

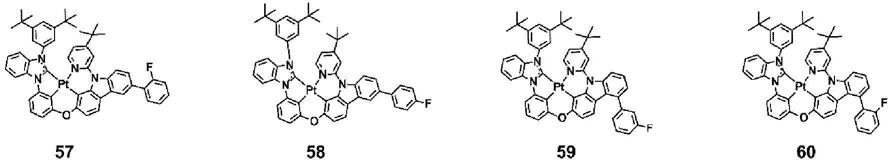

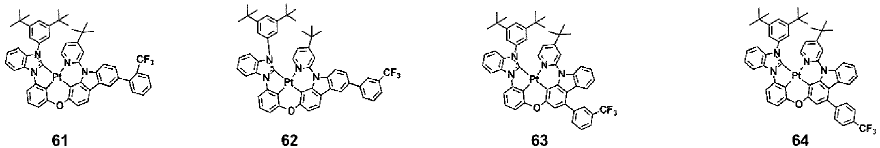

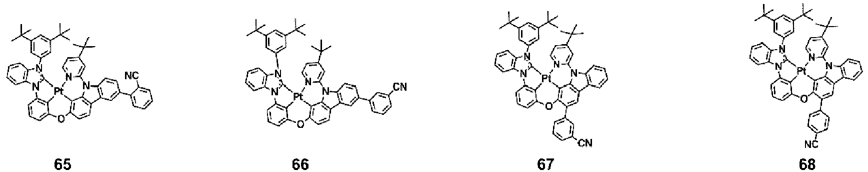

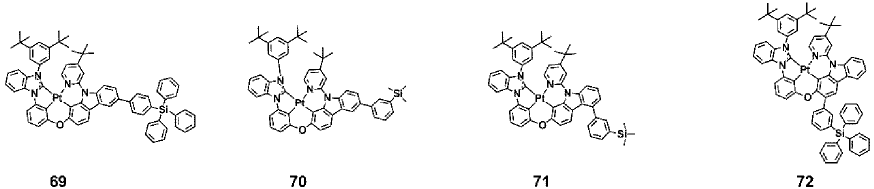

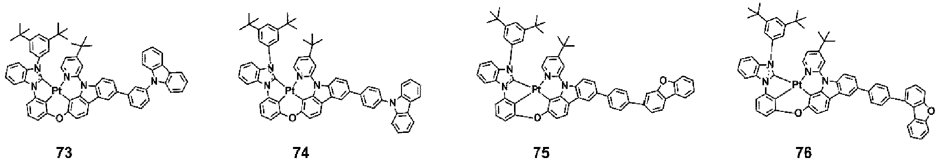

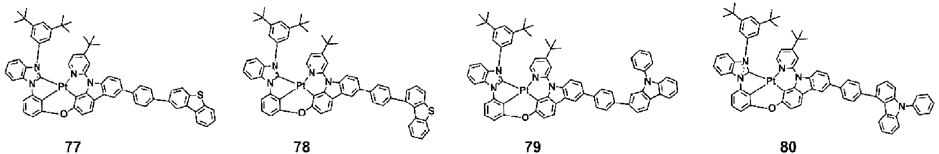

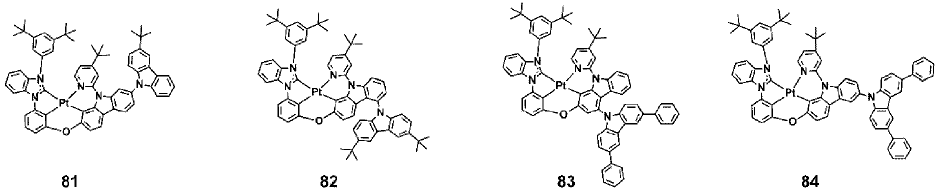

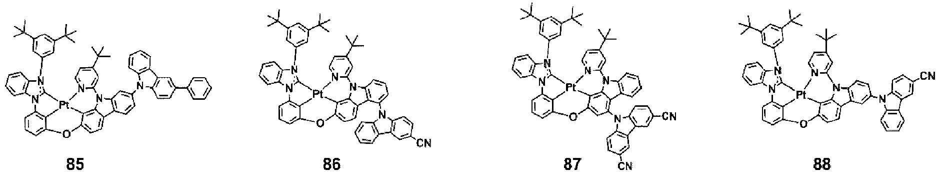

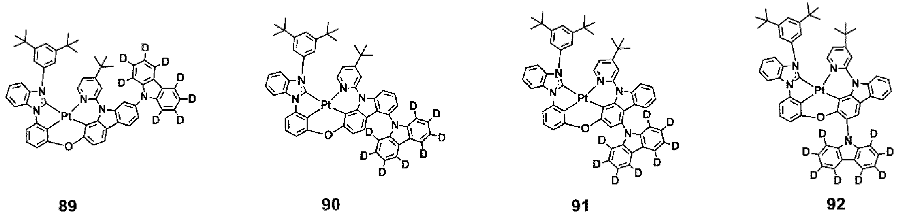

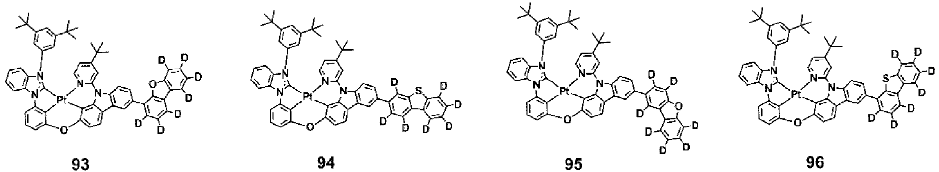

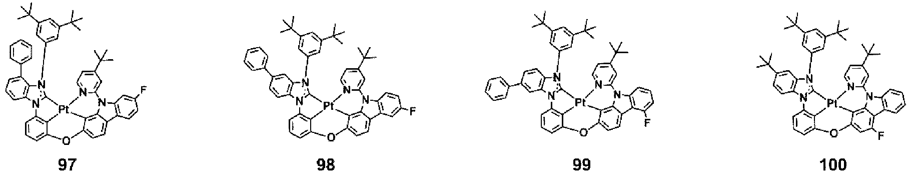

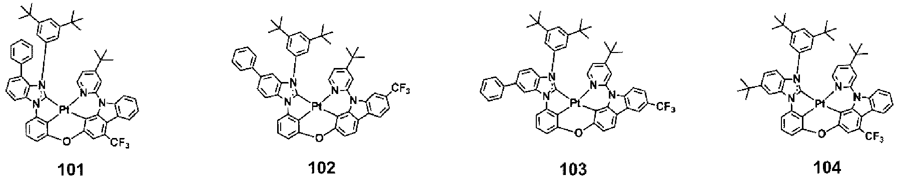

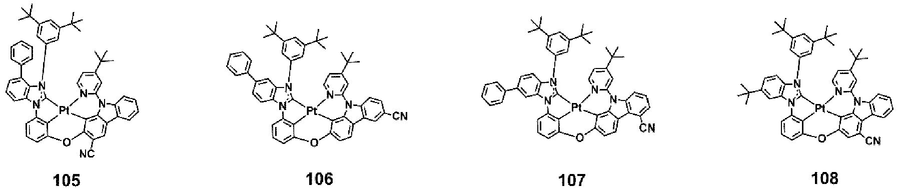

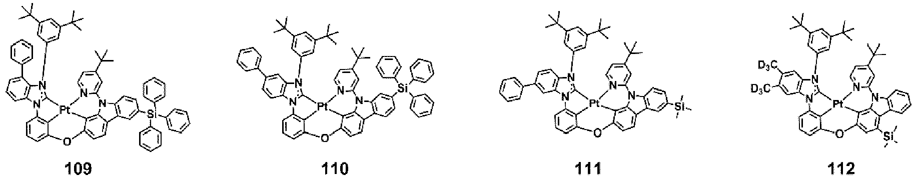

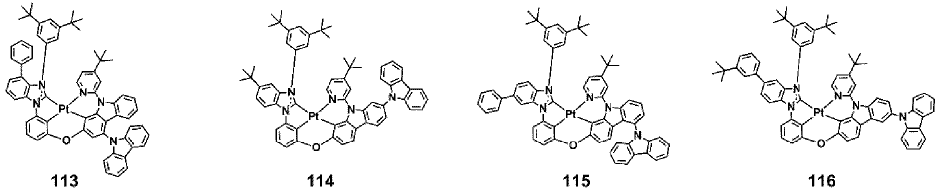

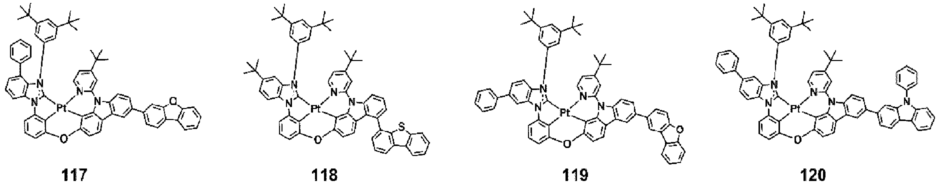

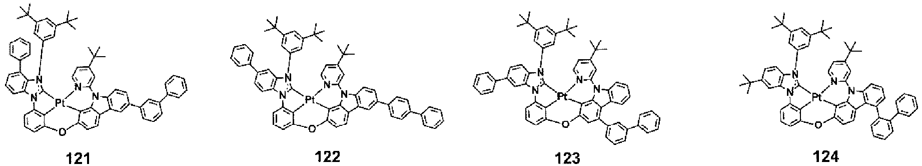

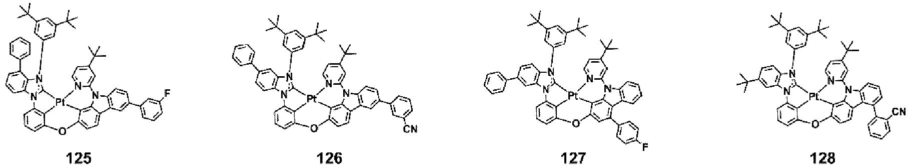

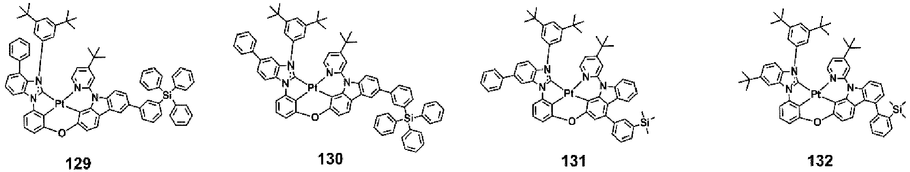

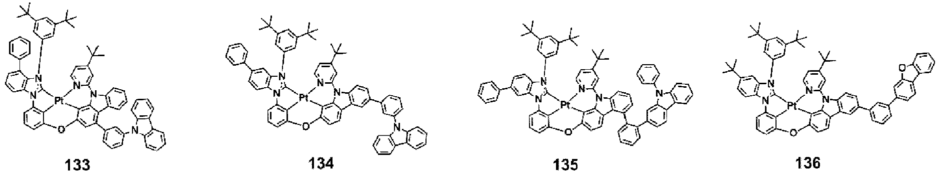

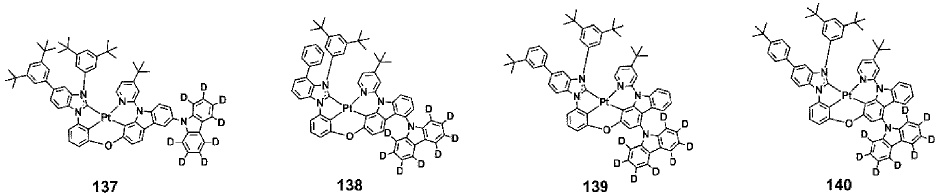

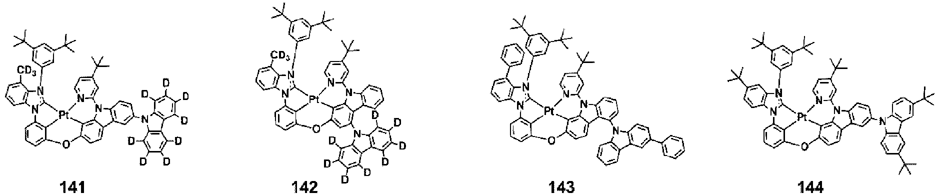

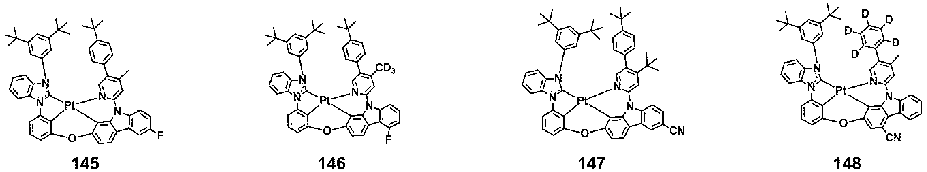

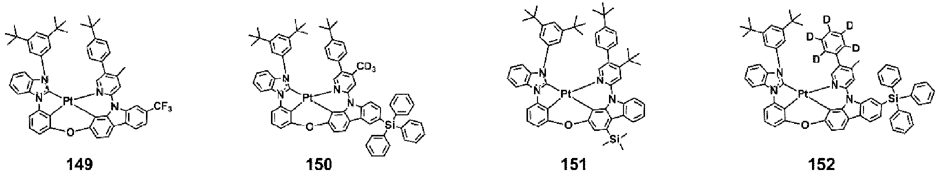

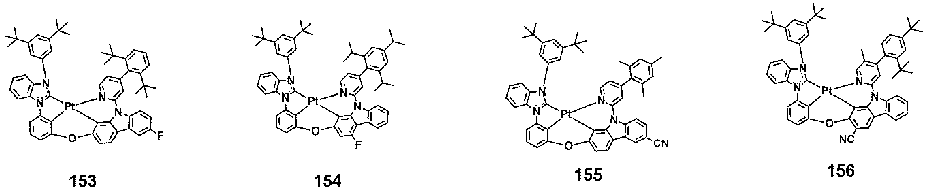

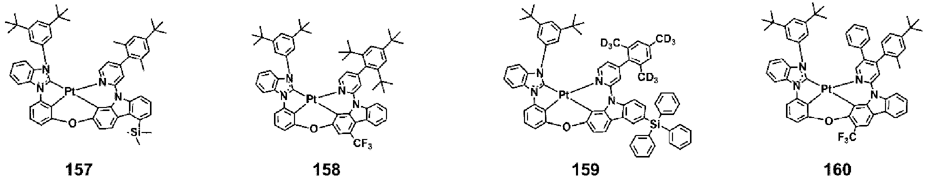

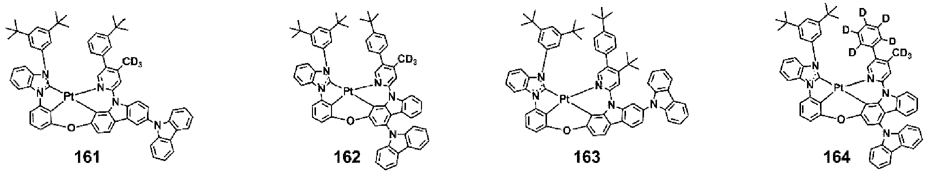

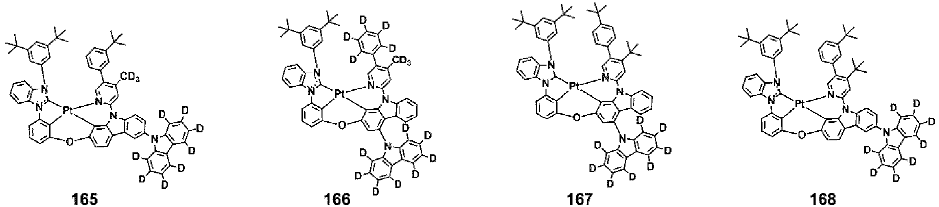

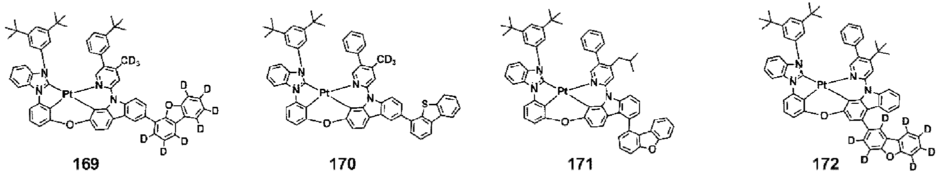

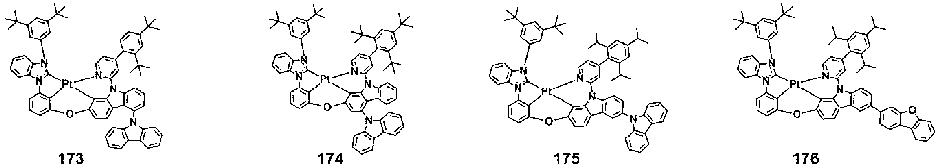

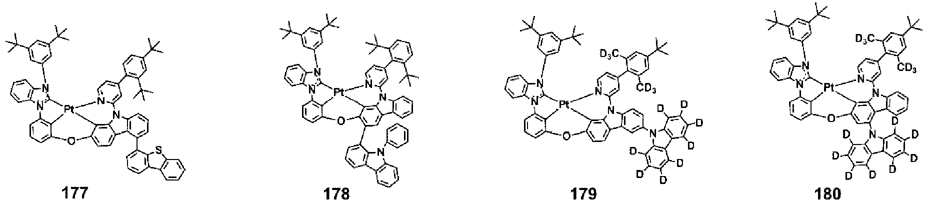

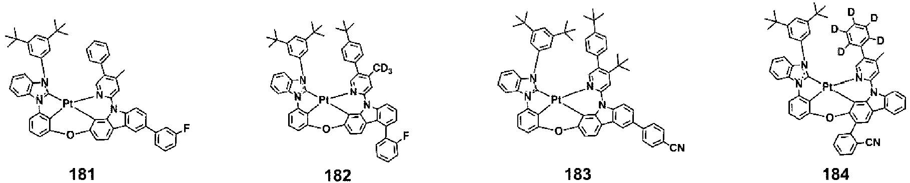

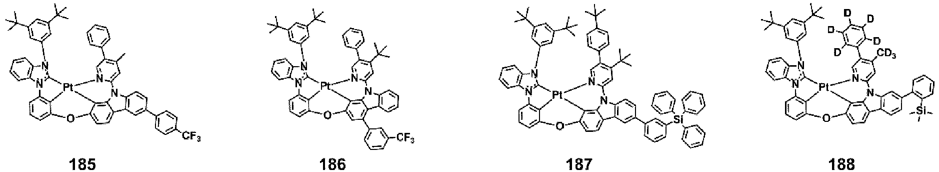

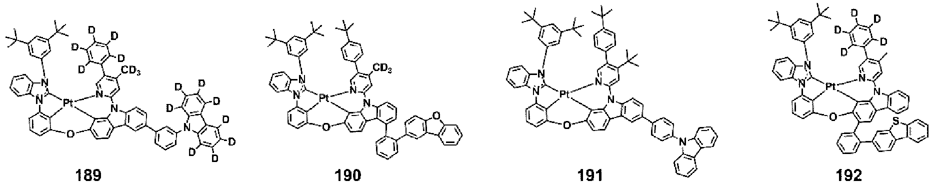

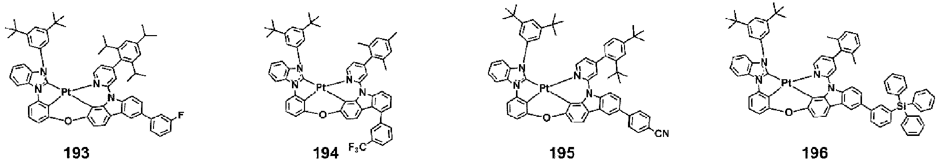

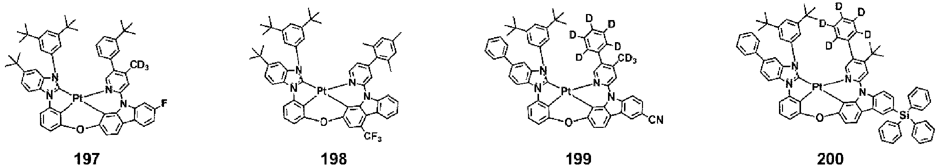

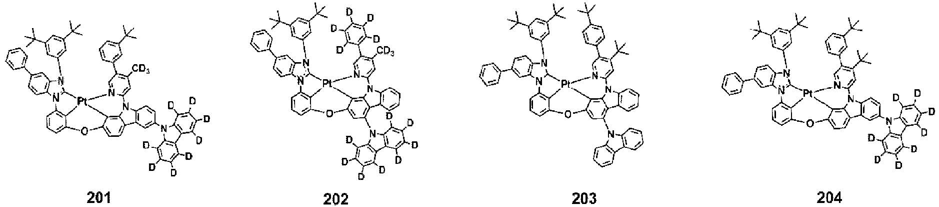

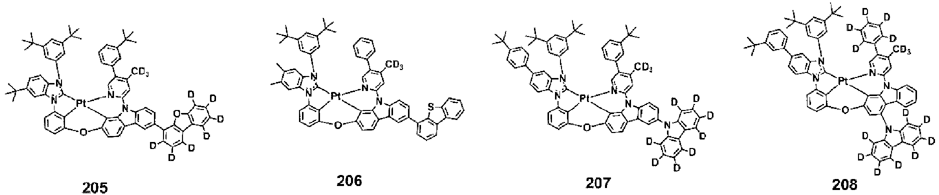

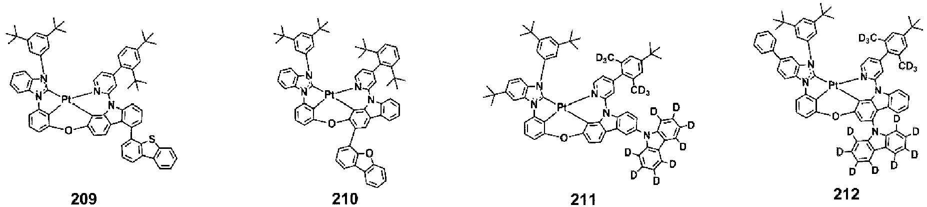

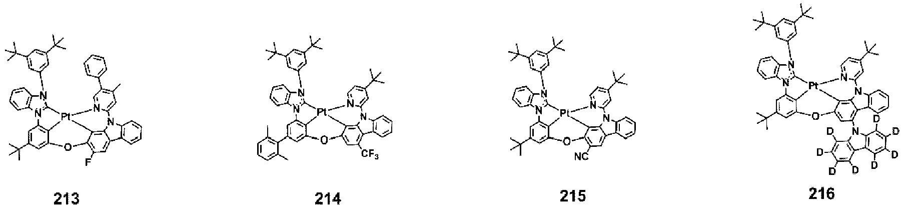

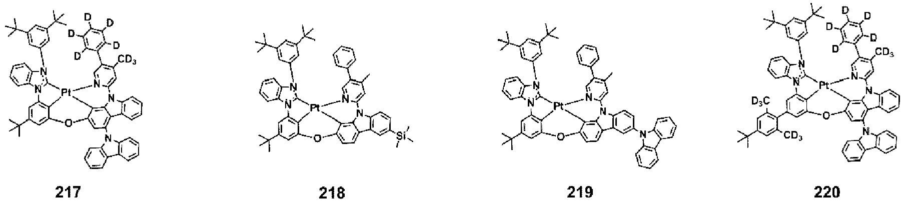

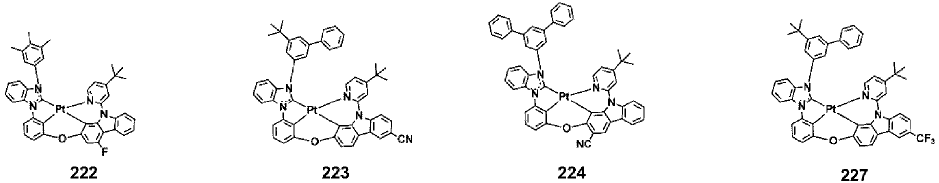

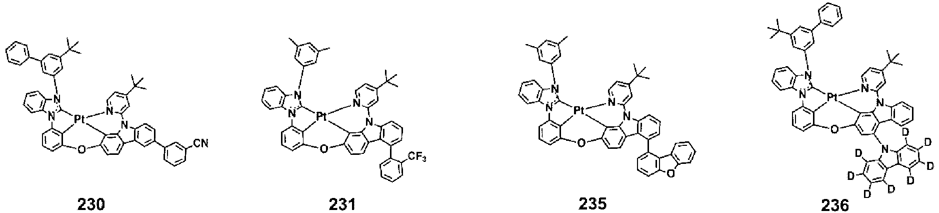

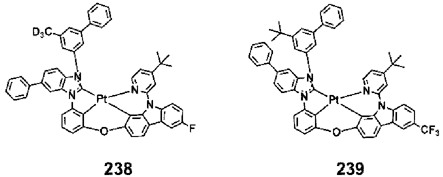

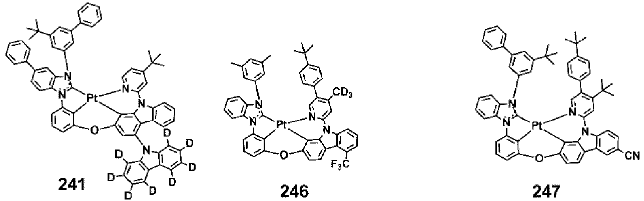

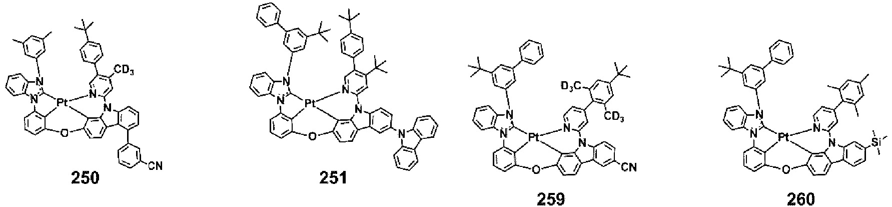

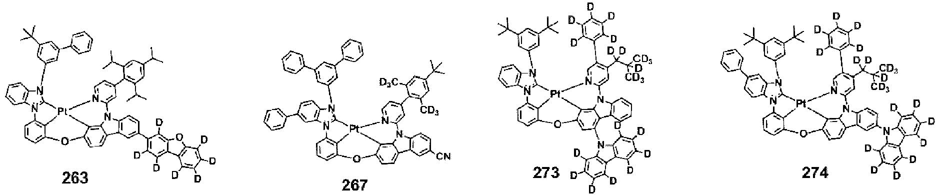

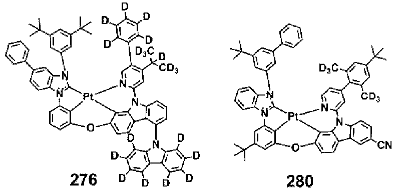

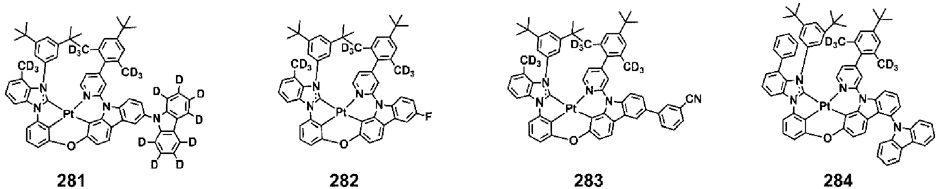

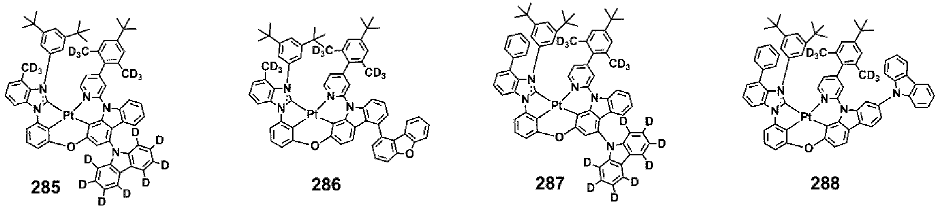

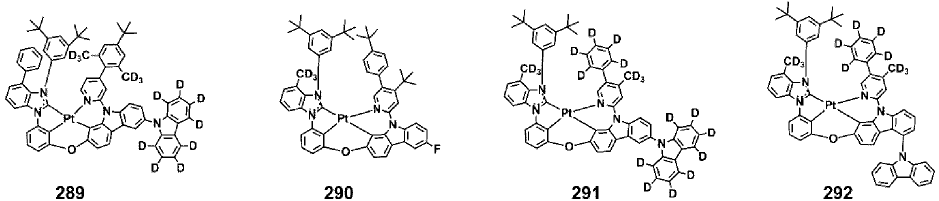

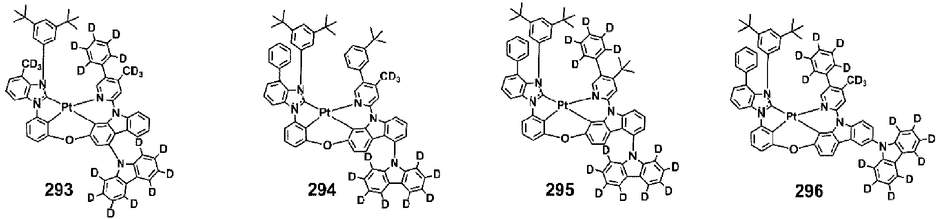

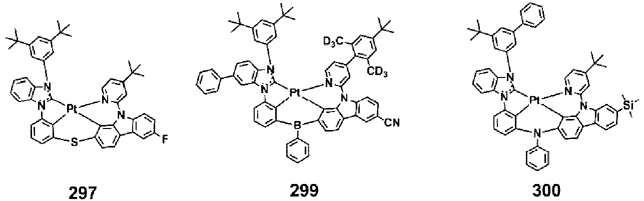

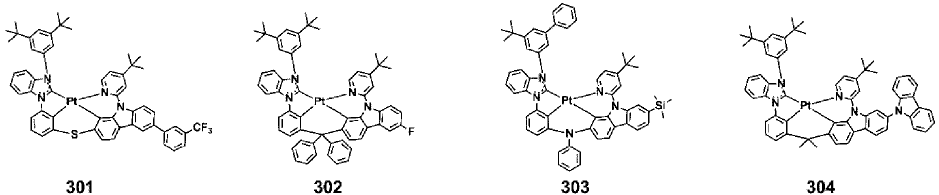

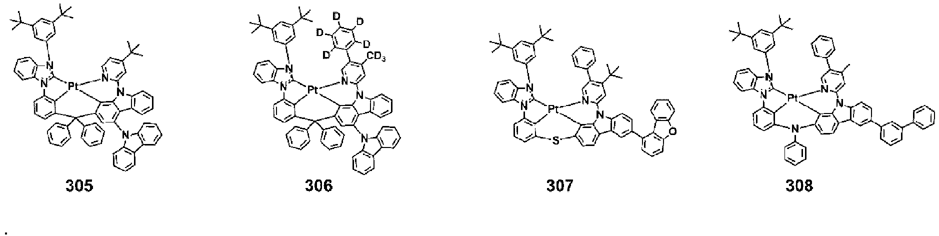

8. Organische lichtemittierende Vorrichtung, umfassend:
eine erste Elektrode;
eine zweite Elektrode; und
eine organische Schicht, die sich zwischen der ersten Elektrode und der zweiten Elektrode befindet,
wobei die organische Schicht eine Emissionsschicht umfasst und
wobei die organische Schicht ferner mindestens eine organometallische Verbindung nach einem der Ansprüche 1-7 umfasst.

9. Organische lichtemittierende Vorrichtung nach Anspruch 8, wobei die Emissionsschicht die mindestens eine organometallische Verbindung umfasst.

10. Organische lichtemittierende Vorrichtung nach Anspruch 9, wobei die Emissionsschicht ferner einen Wirt umfasst und ein Gehalt des Wirts in der Emissionsschicht größer ist als ein Gehalt der mindestens einen organometallischen Verbindung in der Emissionsschicht; und/oder
wobei die Emissionsschicht blaues Licht mit einer maximalen Emissionswellenlänge in einem Bereich von 410 Nanometer bis 490 Nanometer emittiert.

11. Organische lichtemittierende Vorrichtung nach Anspruch 9 oder 10, wobei
die Emissionsschicht ferner einen fluoreszierenden Dotierstoff umfasst,
wobei sich der fluoreszierende Dotierstoff von der mindestens einen organometallischen Verbindung unterscheidet und
mindestens 80 % oder mehr der Gesamtemission aus der Emissionsschicht von dem fluoreszierenden Dotierstoff emittiert werden;
bevorzugt, wobei der fluoreszierende Dotierstoff eine Verbindung umfasst, die durch Formel 503-1 oder Formel 503-2 dargestellt ist: 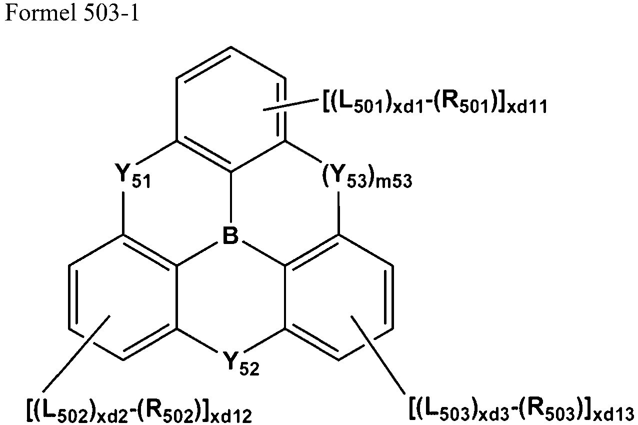 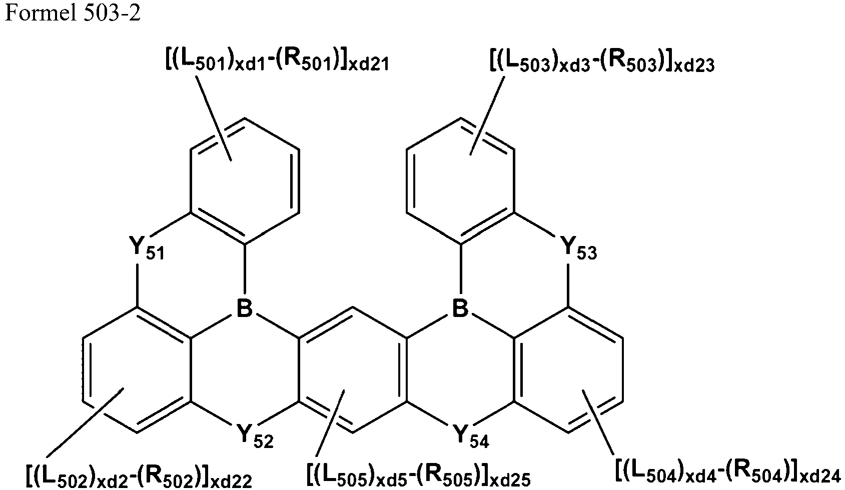
wobei, in Formel 503-1 und 503-2,
Y₅₁ bis Y₅₄ jeweils unabhängig eine Einfachbindung, O, S, N[(L₅₀₆)_{xd6}-R₅₀₆], C[(L₅₀₆)_{xd6}-R₅₀₆][(L₅₀₇)ₓₐ₇-R₅₀₇] oder Si[(L₅₀₆)_{xd6}-R₅₀₆][(L₅₀₇)_{xd7}-R₅₀₇] sind,
m53 0 oder 1 ist,
L₅₀₁ bis L₅₀₇ jeweils unabhängig eine substituierte oder unsubstituierte C₃-C₁₀-Cycloalkylengruppe, eine substituierte oder unsubstituierte C₁-C₁₀-Heterocycloalkylengruppe, eine substituierte oder unsubstituierte C₃-C₁₀-Cycloalkenylengruppe, eine substituierte oder unsubstituierte C₁-C₁₀-Heterocycloalkenylengruppe, eine substituierte oder unsubstituierte C₆-C₆₀-Arylengruppe, eine substituierte oder unsubstituierte C₁-C₆₀-Heteroarylengruppe, eine substituierte oder unsubstituierte zweiwertige nicht-aromatische kondensierte polycyclische Gruppe oder eine substituierte oder unsubstituierte zweiwertige nicht-aromatische kondensierte heteropolycyclische Gruppe sind,
xd1 bis xd7 jeweils unabhängig 0, 1, 2 oder 3 sind,
R₅₀₁ bis R₅₀₇ jeweils unabhängig Folgendes sind:
Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, einer Carbonsäuregruppe oder ein Salz davon, eine Sulfonsäuregruppe oder ein Salz davon, eine Phosphorsäuregruppe oder ein Salz davon, eine C₁-C₂₀-Alkylgruppe, eine C₁-C₂₀-Alkoxygruppe oder eine C₁-C₂₀-Alkylthiogruppe;
eine Phenylgruppe, eine Biphenylgruppe, eine Terphenylgruppe, eine Naphthylgruppe, eine Fluorenylgruppe, eine Spiro-Bifluorenylgruppe, eine Benzofluorenylgruppe, eine Dibenzofluorenylgruppe, eine Phenanthrenylgruppe, eine Anthracenylgruppe, eine Pyrenylgruppe, eine Chrysenylgruppe, eine Pyridinylgruppe, eine Pyrazinylgruppe, eine Pyrimidinylgruppe, eine Pyridazinylgruppe, eine Chinolinylgruppe, eine Isochinolinylgruppe, eine Chinoxalinylgruppe, eine Chinazolinylgruppe, eine Carbazolgruppe, eine Triazinylgruppe, eine Dibenzofuranylgruppe oder eine Dibenzothiophenylgruppe; oder
eine Phenylgruppe, eine Biphenylgruppe, eine Terphenylgruppe, eine Naphthylgruppe, eine Fluorenylgruppe, eine Spiro-Bifluorenylgruppe, eine Benzofluorenylgruppe, eine Dibenzofluorenylgruppe, eine Phenanthrenylgruppe, eine Anthracenylgruppe, eine Pyrenylgruppe, eine Chrysenylgruppe, eine Pyridinylgruppe, eine Pyrazinylgruppe, eine Pyrimidinylgruppe, eine Pyridazinylgruppe, eine Chinolinylgruppe, eine Isochinolinylgruppe, eine Chinoxalinylgruppe, eine Chinazolinylgruppe, eine Carbazolylgruppe, eine Triazinylgruppe, eine Dibenzofuranylgruppe oder eine Dibenzothiophenylgruppe, jeweils substituiert mit mindestens einem von Deuterium, -F, -Cl, -Br, -I, -SF₅, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer C₁-C₂₀-Alkylthiogruppe, einer Phenylgruppe, einer Biphenylgruppe, einer Terphenylgruppe, einer Naphthylgruppe, einer Fluorenylgruppe, einer Spiro-Bifluorenylgruppe, einer Benzofluorenylgruppe, einer Dibenzofluorenylgruppe, einer Phenanthrenylgruppe, einer Anthracenylgruppe, einer Pyrenylgruppe, einer Chrysenylgruppe, einer Pyridinylgruppe, einer Pyrazinylgruppe, einer Pyrimidinylgruppe, einer Pyridazinylgruppe, einer Chinolinylgruppe, einer Isochinolinylgruppe, einer Chinoxalinylgruppe, einer Chinazolinylgruppe, einer Carbazolylgruppe, einer Triazinylgruppe, einer Dibenzofuranylgruppe, einer Dibenzothiophenylgruppe oder einer Kombination davon,
wenn m53 0 ist, xd11 und xd13 jeweils unabhängig 0, 1, 2, 3 oder 4 sind,
wenn m53 1 ist, xd11 und xd13 jeweils unabhängig 0, 1, 2 oder 3 sind,
xd21 und xd23 jeweils unabhängig 0, 1, 2, 3 oder 4 sind,
xd12, xd22 und xd24 jeweils unabhängig 0, 1, 2 oder 3 sind,
xd25 0, 1 oder 2 ist und
zwei oder mehr von R₅₀₁ bis R₅₀₇ optional aneinander gebunden sind, um eine substituierte oder unsubstituierte carbocyclische C₅-C₃₀-Gruppe oder eine substituierte oder unsubstituierte heterocyclische C₁-C₃₀-Gruppe zu bilden.

12. Elektronisches Gerät, umfassend die organische lichtemittierende Vorrichtung nach einem der Ansprüche 8-11.

## Revendications

1. Composé organométallique, représenté par la formule 1 : 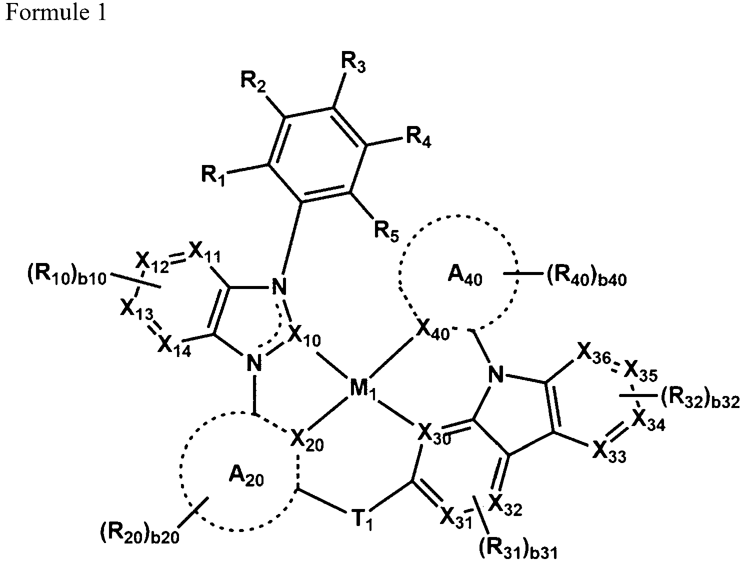 dans lequel, dans la Formule 1,
M₁ est l'iridium (Ir), le platine (Pt), l'osmium (Os), le titane (Ti), le zirconium (Zr), le hafnium (Hf), l'europium (Eu), le terbium (Tb), le thulium (Tm), le rhodium (Rh), le palladium (Pd) ou l'or (Au),
X₁₀ est C,
X₁₁ à X₁₄, X₂₀, X₃₀ à X₃₆ et X₄₀ sont chacun indépendamment C ou N,
le cycle A₂₀ et le cycle A₄₀ sont chacun indépendamment un groupe carbocyclique en C₅ à C₃₀ ou un groupe hétérocyclique en C₁ à C₃₀,
T₁ est *-N(R₅₁)-*', -B(R₅₁)-*', *-P(R₅₁)-*', *-C(R₅₁)(R₅₂)-*', *-Si(R₅₁)(R₅₂)-*', *-Ge(R₅₁)(R₅₂)-*', *-S-*', *-Se-*', *-O-*', *-C(=O)-*', *-S(=O)-*', *-S(=O)₂-*', *-C(R₅₁)=C(R₅₂)-*', *-C(=S)-*', ou *-C=C-*', dans lequel * et *' indiquent chacun un site de liaison à un atome adjacent,
R₂ et R₄ sont chacun indépendamment un groupe alkyle en C₁ à C₆₀ substitué ou non substitué ou un groupe aryle en C₆ à C₆₀ substitué ou non substitué,
R₁, R₃, R₅, R₁₀, R₂₀, R₃₁, R₃₂, R₄₀, R₅₁, et R₅₂ sont chacun indépendamment un hydrogène, un deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe alkylthio en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe alkylaryle en C₇ à C₆₀ substitué ou non substitué, un groupe arylalkyle en C₇ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe alkylhétéroaryle en C₂ à C₆₀ substitué ou non substitué, un groupe hétéroarylalkyle en C₂ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇), -P(Q₈)(Q₉), ou - P(=O)(Q₈)(Q₉),
deux parmi R₁₀, R₂₀, R₃₁, R₃₂, R₄₀, R₅₁ et R₅₂ ou plus sont éventuellement liés l'un à l'autre pour former un groupe carbocyclique en C₅ à C₃₀ substitué ou non substitué ou un groupe hétérocyclique en C₁ à C₃₀ substitué ou non substitué,
b10 et b32 sont chacun indépendamment un nombre entier de 1 à 4,
b20 et b40 sont chacun indépendamment un nombre entier de 1 à 10,
b31 est 1 ou 2,
à condition qu'au moins l'un parmi un ou plusieurs R₃₁ au nombre de b31, ou un ou plusieurs R₃₂ au nombre de b32 est :
-F, un groupe cyano, -CF₃, -CF₂H, -CFH₂, -Si(Q₃)(Q₄)(Q₅), ou un groupe représenté par l'une des formules 3-1 à 3-55,
dans lequel Q₃ à Q₅ sont chacun indépendamment un groupe méthyle, un groupe éthyle, un groupe n-propyle, un groupe iso-propyle, un groupe n-butyle, un groupe sec-butyle, un groupe isobutyle, un groupe tert-butyle, un groupe n-pentyle, un groupe tert-pentyle, un groupe néopentyle, un groupe isopentyle, un groupe sec-pentyle, un groupe 3-pentyle, un groupe sec-isopentyle, un groupe phényle, un groupe biphényle ou un groupe naphtyle, chacun non substitué ou substitué par au moins l'un parmi le deutérium, -F, un groupe alkyle en C₁ à C₁₀, un groupe phényle, ou une combinaison de ceux-ci : 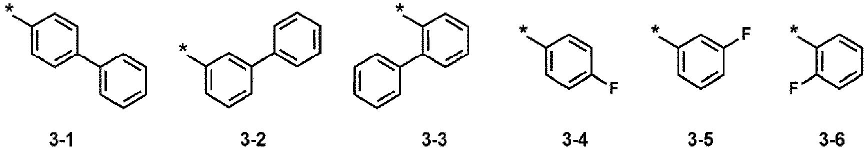 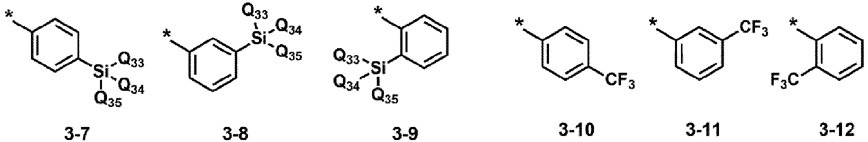 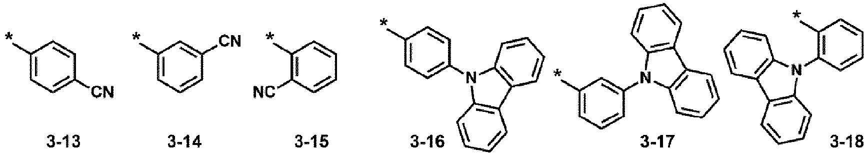 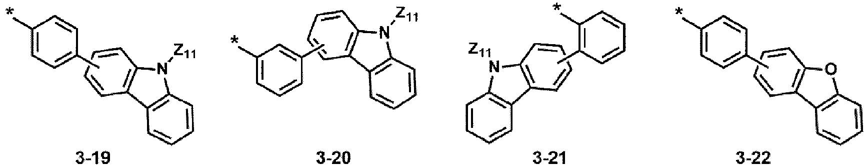 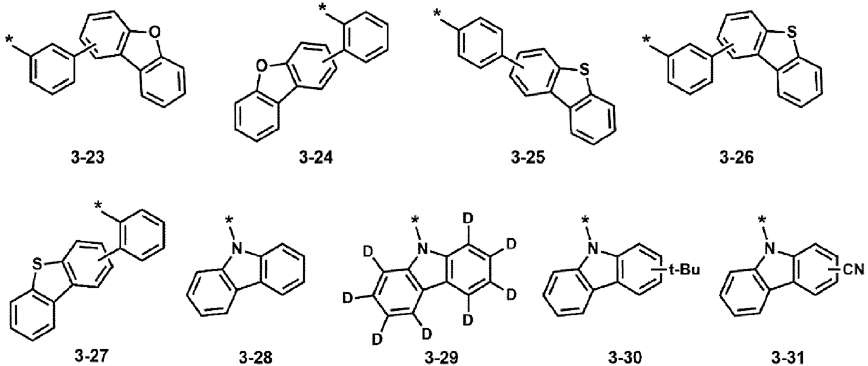 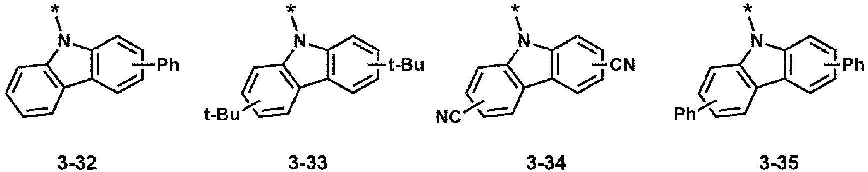 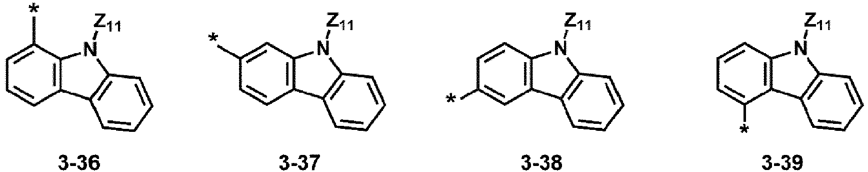 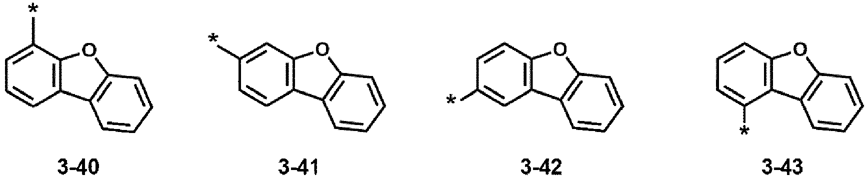 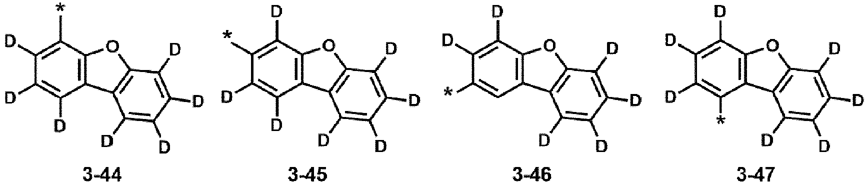 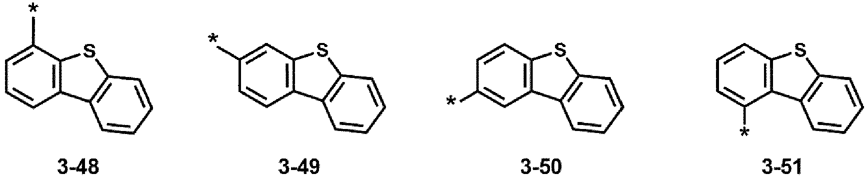 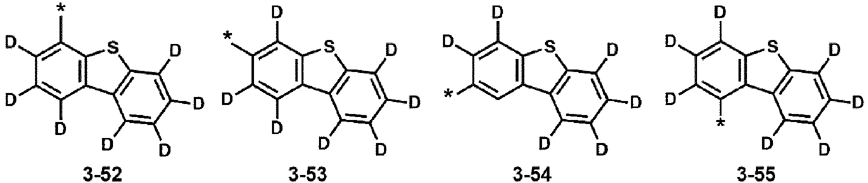
dans lequel, dans les formules 3-1 à 3-55,
Q₃₃ à Q₃₅ et Z₁₁ sont chacun indépendamment un groupe méthyle, un groupe éthyle, un groupe n-propyle, un groupe iso-propyle, un groupe n-butyle, un groupe sec-butyle, un groupe isobutyle,
un groupe tert-butyle, un groupe n-pentyle, un groupe tert-pentyle, un groupe néopentyle, un groupe isopentyle, un groupe sec-pentyle, un groupe 3-pentyle, un groupe sec-isopentyle, un groupe phényle, un groupe biphényle ou un groupe naphtyle, chacun non substitué ou substitué par au moins l'un parmi le deutérium, -F, un groupe alkyle en C₁ à C₁₀, un groupe phényle, ou une combinaison de ceux-ci,
t-Bu représente un groupe tert-butyle, Ph représente un groupe phényle et
* indique un site de liaison à un atome adjacent, et
un substituant de chacun du groupe alkyle en C₁ à C₆₀ substitué, du groupe alcényle en C₂ à C₆₀ substitué, du groupe alcynyle en C₂ à C₆₀ substitué, du groupe alcoxy en C₁ à C₆₀ substitué, du groupe alkylthio en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe alkylaryle en C₇ à C₆₀ substitué, du groupe arylalkyle en C₇ à C₆₀ substitué, du groupe aryloxy en C₆ à C₆₀ substitué, du groupe arylthio en C₆ à C₆₀ substitué, du groupe hétéroaryle en C₁ à C₆₀ substitué, du groupe alkylhétéroaryle en C₂ à C₆₀ substitué, du groupe hétéroarylalkyle en C₂ à C₆₀ substitué, du groupe hétéroaryloxy en C₁ à C₆₀ substitué, du groupe hétéroarylthio en C₁ à C₆₀ substitué, du groupe polycyclique condensé non aromatique monovalent substitué et du groupe hétéropolycyclique condensé non aromatique monovalent substitué, du groupe carbocyclique en C₅ à C₃₀ substitué et du groupe hétérocyclique en C₁ à C₃₀ substitué est :
un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀, ou un groupe alkylthio en C₁ à C₆₀ ;
un groupe alkyle en C₁ à C₆₀, un groupe alcényle en C₂ à C₆₀, un groupe alcynyle en C₂ à C₆₀, un groupe alcoxy en C₁ à C₆₀, ou un groupe alkylthio n C₁ à C₆₀, chacun non substitué ou substitué par au moins l'un parmi un deutérium -F, -Cl, -Br, -I, -SF₅, -CD₃, -CD₂H, -CDH₂, -CF₃, -CF₂H, -CFH₂,un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy C₁ à C₆₀, un groupe hétéroarylthio en C₁ à C₆₀,_{,}un groupe polycyclique condensé non aromatique monovalent, un groupe hétéropolycyclique condensé non aromatique monovalent, -N(Q₁₁)(Q₁₂), - Si(Q₁₃)(Q₁₄)(Q₁₅), -B(Q₁₆)(Q₁₇), -P(Q₁₈)(Q₁₉), -P(=O)(Q₁₈)(Q₁₉), ou une combinaison de ceux-ci ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy en C₁ à C₆₀, un groupe hétéroarylthio en C₁ à C₆₀, un groupe polycyclique condensé non aromatique monovalent ou un groupe hétéropolycyclique condensé non aromatique monovalent, chacun étant non substitué ou substitué par au moins l'un parmi un deutérium, -F, -Cl, -Br, -I, - SF₅, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀, un groupe alkylthio en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe arylalkyle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroarylalkyle en C₂ à C₆₀, un groupe hétéroaryloxy en C₁ à C₆₀, un groupe hétéroarylthio en C₁ à C₆₀, un groupe polycyclique condensé non aromatique monovalent, un groupe hétéropolycyclique condensé non aromatique monovalent, -N(Q₂₁)(Q₂₂), - Si(Q₂₃)(Q₂₄)(Q₂₅), -B(Q₂₆)(Q₂₇), -P(Q₂₈)(Q₂₉), -P(=O)(Q₂₈)(Q₂₉), ou une combinaison de ceux-ci ;
-N(Q₃₁)(Q₃₂), -Si(Q₃₃)(Q₃₄)(Q₃₅), -B(Q₃₆)(Q₃₇), -P(Q₃₈)(Q₃₉), ou -P(=O)(Q₃₈)(Q₃₉) ; ou
une combinaison de ceux-ci,
dans lequel Q₁ à Q₉, Q₁₁ à Q₁₉, Q₂₁ à Q₂₉ et Q₃₁ à Q₃₉ sont chacun indépendamment un hydrogène, un deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe alkylthio en C₁ à C₆₀ substitué ou non substitué,un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe alkylaryle en C₇ à C₆₀ substitué ou non substitué, un groupe arylalkyle en C₇ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe alkylhétéroaryl en C₂ à C₆₀ substitué ou non substitué, un groupe hétéroarylalkyle en C₂ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe polycyclique condensé non-aromatique monovalent substitué ou non substitué, un groupe hétéropolycyclique condensé non-aromatique monovalent substitué ou non substitué.

2. Composé organométallique de la revendication 1, dans lequel M₁ dans la formule 1 est le platine (Pt), le palladium (Pd) ou l'or (Au) ; et/ou
dans lequel le cycle A₂₀ et le cycle A₄₀ dans la formule 1 sont chacun indépendamment un groupe cyclopentane, un groupe cyclopentène, un groupe cyclohexane, un groupe cyclohexène, un groupe cyclohexadiène, un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe thiophène, un groupe furane, un groupe borole, un groupe phosphole, un groupe germole, un groupe sélénophène, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofurane, un groupe dibenzothiophène 5-oxyde, un groupe 9H-fluorène-9-un, un groupe dibenzothiophène 5,5-dioxyde, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe azadibenzothiophène 5-oxyde, un groupe aza-9H-fluorène-9-un, un groupe azadibenzothiophène 5,5-dioxyde, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe triazole, un groupe oxazole, un groupe isooxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoléine, un groupe 5,6,7,8-tétrahydroquinoléine, un groupe adamantane, un groupe norbornane ou un groupe norbornène.

3. Composé organométallique des revendications 1 ou 2, dans lequel le cycle A₂₀ dans la formule 1 est représenté par l'une des formules A20(1) à A20(15) : 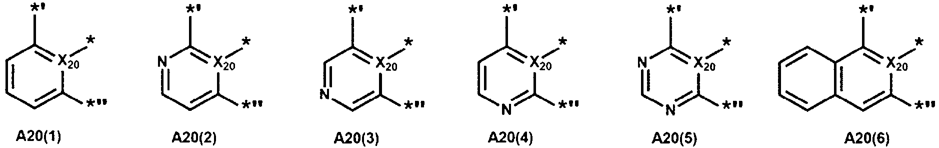 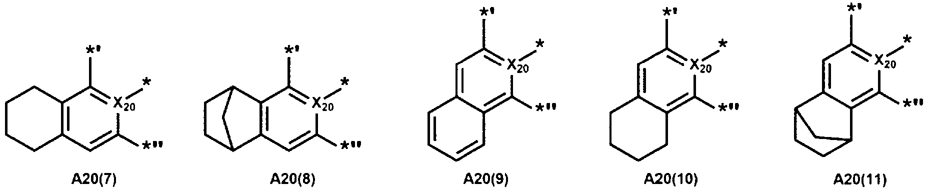 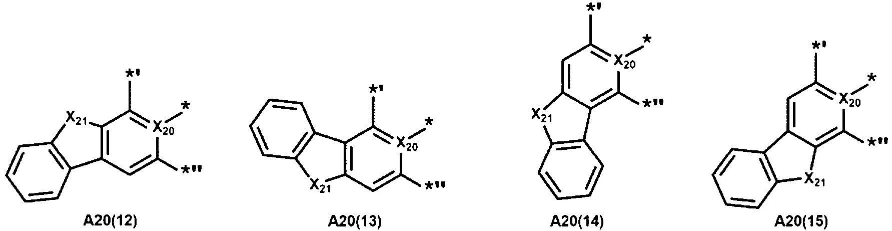
dans lequel, dans les formules A20(1) à A20(15),
X₂₀ est C ou N,
X₂₁ est O, S, N(R₂₁), C(R₂₁)(R₂₂) ou Si(R₂₁)(R₂₂),
R₂₁ et R₂₂ sont chacun indépendamment tels que définis pour R₂₀ dans la revendication 1, * indique un site de liaison à M₁ dans la formule 1,
*' indique un site de liaison à N dans la formule 1, et
*" indique un site de liaison à T₁ dans la formule 1 ; et/ou
dans lequel le cycle A₄₀ dans la formule 1 est représenté par l'une des formules A40(1) à A40(34) : 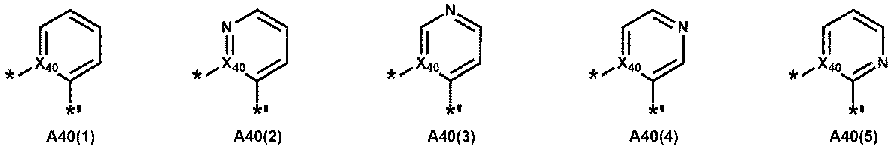 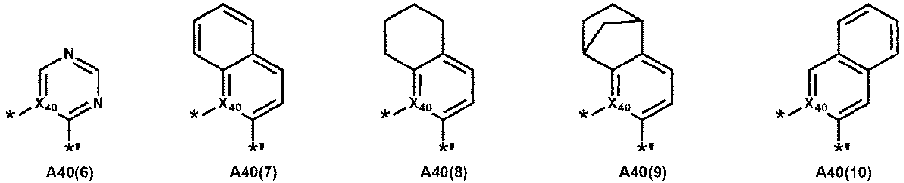 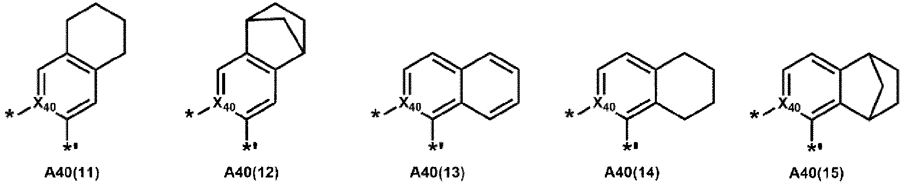 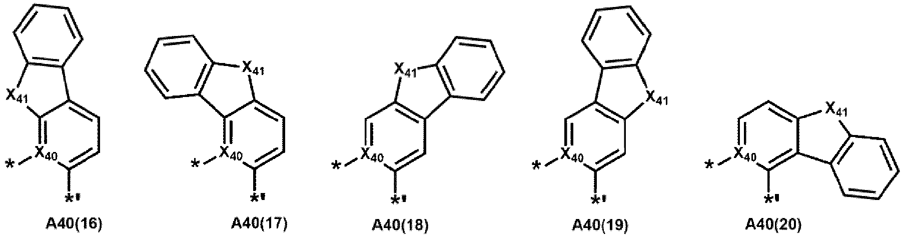 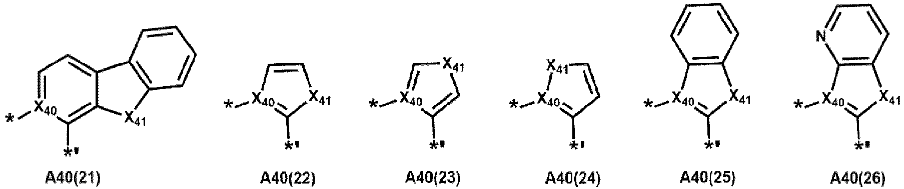 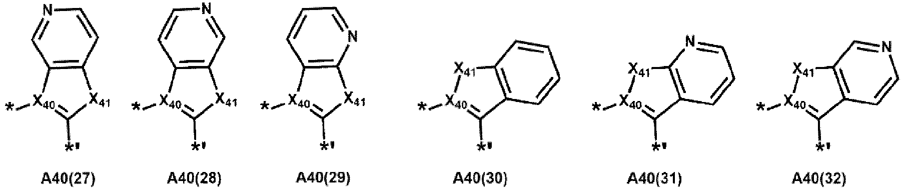 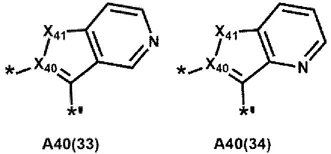
dans lequel, dans les formules A40(1) à A40(34),
X₄₀ est C ou N,
X₄₁ est O, S, N(R₄₁), C(R₄₁)(R₄₂) ou Si(R₄₁)(R₄₂),
R₄₁ et R₄₂ sont chacun indépendamment tels que définis pour R₄₀ dans la revendication 1, * indique un site de liaison à M₁ dans la formule 1, et
*' indique un site de liaison à N dans la formule 1.

4. Composé organométallique de l'une quelconque des revendications 1 à 3, dans lequel R₂ dans la formule 1 est :
un groupe méthyle, un groupe éthyle, un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle ou un groupe tert-décyle, chacun non substitué ou substitué avec au moins un élément parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, ou une combinaison de ceux-ci ; ou
un groupe phényle, un groupe naphtyle, un groupe fluorényle, un groupe phénanthrényle, un groupe anthracényle, un groupe fluoranthényle, un groupe triphénylényle, un groupe pyrényle ou un groupe chrysényle, chacun non substitué ou substitué avec au moins un élément parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe méthyle, un groupe éthyle, un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle, un groupe tert-décyle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle ou une combinaison de ceux-ci.

5. Composé organométallique de l'une quelconque des revendications 1 à 4, dans lequel, dans la formule 1,
i) R₁ et R₃ à R₅ sont chacun un hydrogène,
ii) R₁, R₃ et R₅ sont chacun un hydrogène, et
R₄ est :
un groupe méthyle, un groupe éthyle, un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle ou un groupe tert-décyle, chacun non substitué ou substitué avec au moins un élément parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, ou une combinaison de ceux-ci ; ou
un groupe phényle, un groupe naphtyle, un groupe fluorényle, un groupe phénanthrényle, un groupe anthracényle, un groupe fluoranthényle, un groupe triphénylényle, un groupe pyrényle ou un groupe chrysényle, chacun non substitué ou substitué avec au moins un élément parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe méthyle, un groupe éthyle, un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle, un groupe tert-décyle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle ou une combinaison de ceux-ci, ou
iii) R₁ et R₅ sont chacun un hydrogène, et
R₃ et R₄ sont chacun indépendamment :
un groupe méthyle, un groupe éthyle, un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle ou un groupe tert-décyle, chacun non substitué ou substitué avec au moins un élément parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, ou toute combinaison de ceux-ci ; ou
un groupe phényle, un groupe naphtyle, un groupe fluorényle, un groupe phénanthrényle, un groupe anthracényle, un groupe fluoranthényle, un groupe triphénylényle, un groupe pyrényle ou un groupe chrysényle, chacun non substitué ou substitué avec au moins un élément parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe méthyle, un groupe éthyle, un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle, un groupe tert-décyle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle ou une combinaison de ceux-ci.

6. Composé organométallique de l'une quelconque des revendications 1 à 5, dans lequel une fraction représentée par 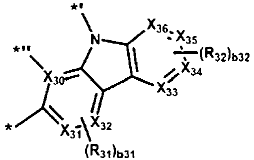
dans la formule 1 est représentée par l'une des formules A30(1) à A30(6) : 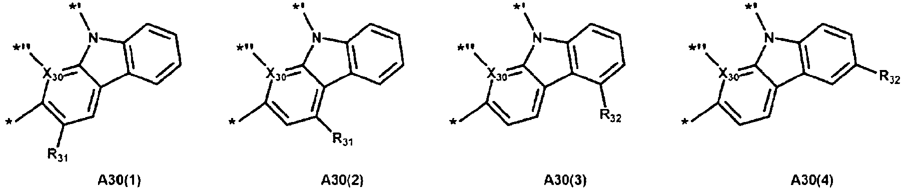 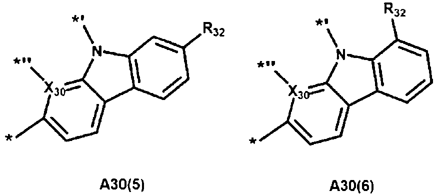
dans lequel, dans les formules A30(1) à A30(6),
R₃₁, R₃₂, X₃₀, Q₃ à Q₅, et Q₃₃ à Q₃₅ sont tels que définis dans la revendication 1,
* et *' indiquent chacun un site de liaison à un atome adjacent, et
* indique un site de liaison à M₁ ; et/ou
dans lequel le composé organométallique est représenté par la formule 1A : 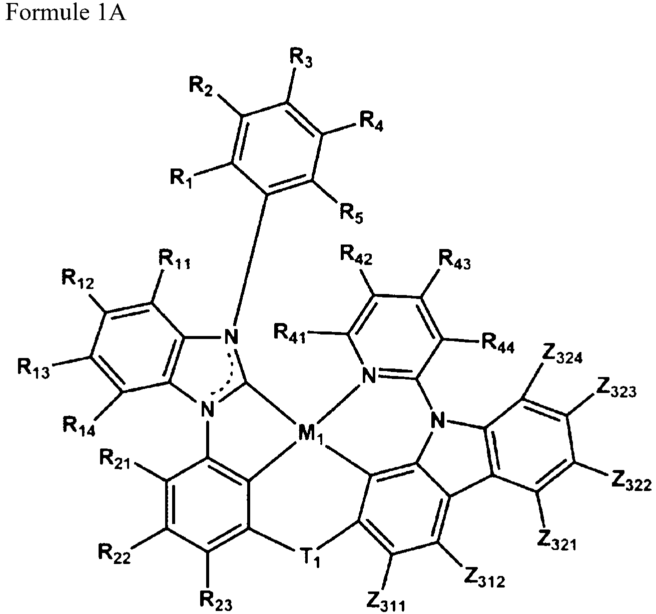
dans lequel, dans la formule 1A,
M₁, T₁ et R₁ à R₅ sont tels que définis dans la revendication 1,
R₁₁ à R₁₄ sont chacun indépendamment tels que définis pour R₁₀ dans la revendication 1,
R₂₁ à R₂₃ sont chacun indépendamment tels que définis pour R₂₀ dans la revendication 1,
Z₃₁₁ et Z₃₁₂ sont chacun indépendamment tels que définis pour R₃₁ dans la revendication 1,
Z₃₂₁ à Z₃₂₄ sont chacun indépendamment tels que définis pour R₃₂ dans la revendication 1,
R₄₁ à R₄₄ sont chacun indépendamment tels que définis pour R₄₀ dans la revendication 1.

7. Composé organométallique de la revendication 1, dans lequel le composé organométallique est représenté par un ou plusieurs des composés 1 à 220, 222 à 224, 227, 230, 231, 235, 236, 238, 239, 241, 246, 247, 250, 251, 259, 260, 263, 267, 273, 274, 276, 280 à 297 et 299 à 308 :

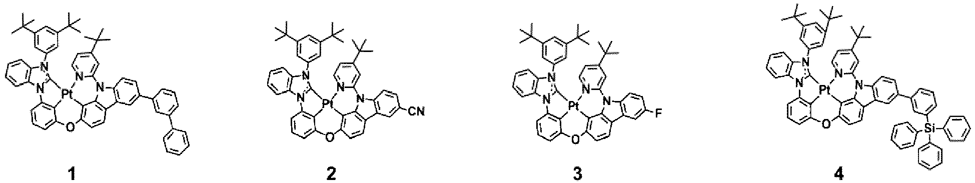

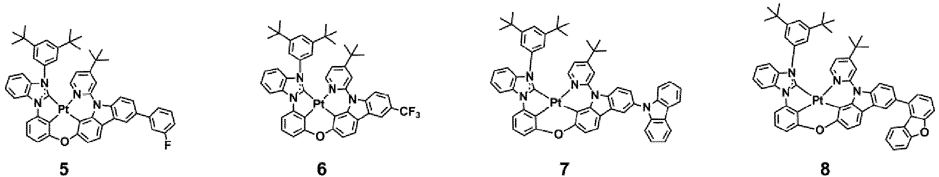

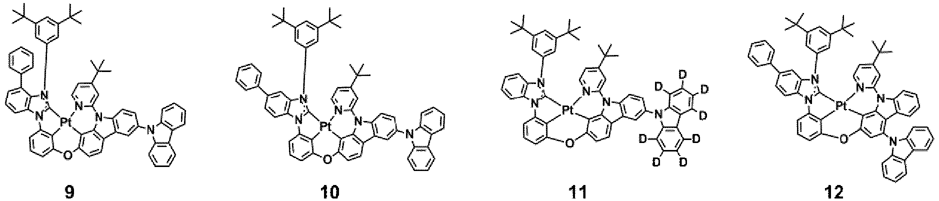

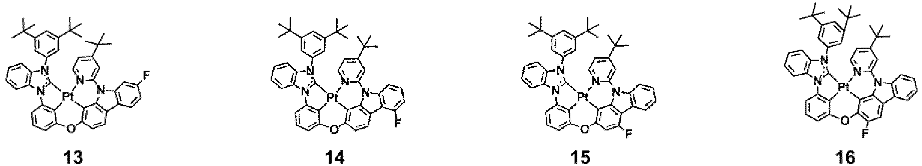

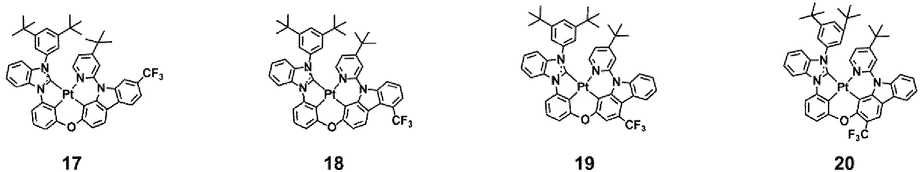

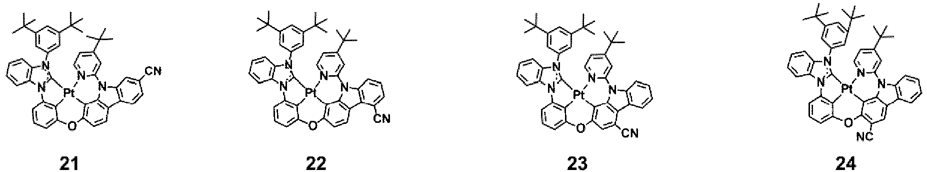

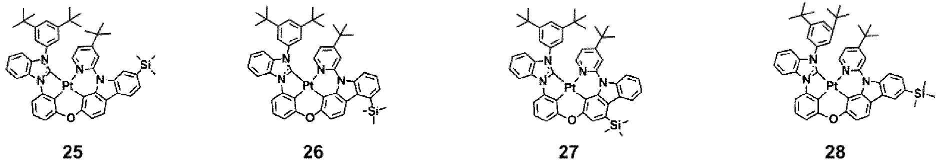

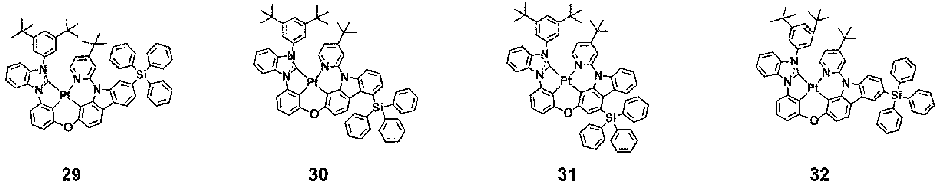

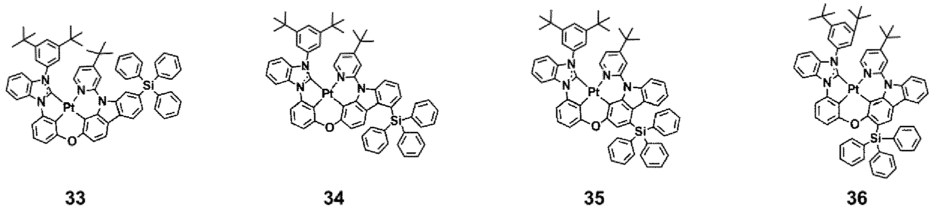

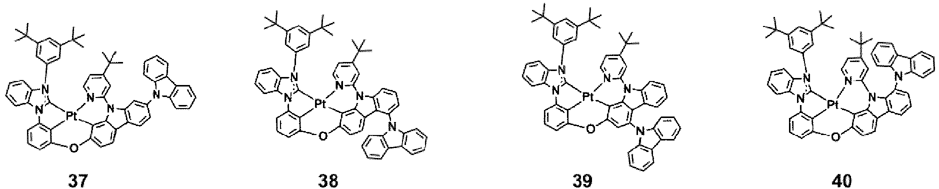

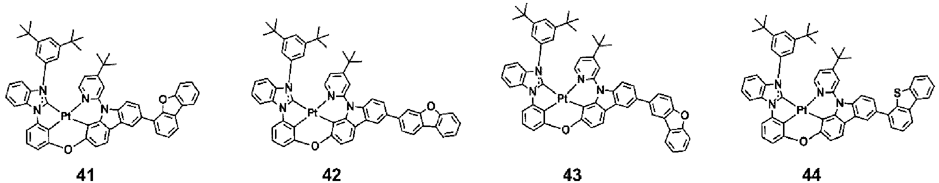

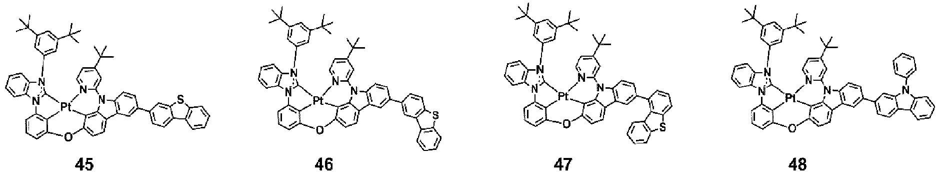

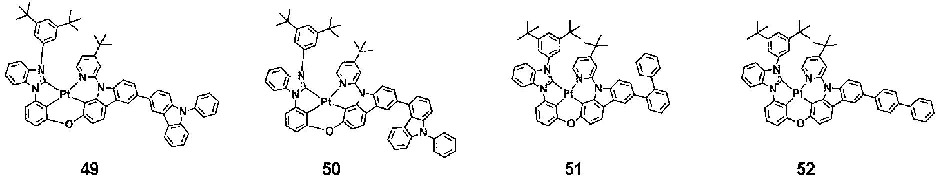

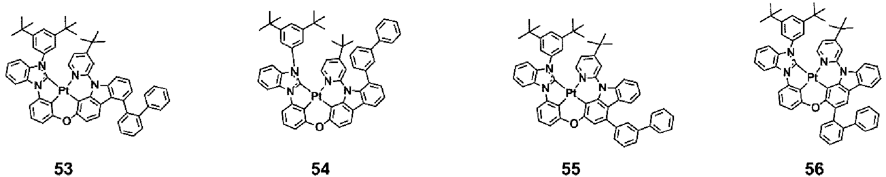

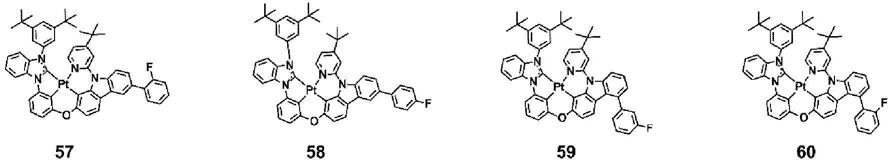

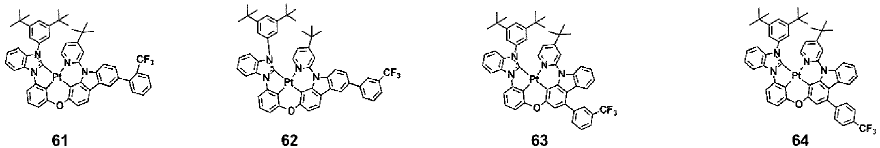

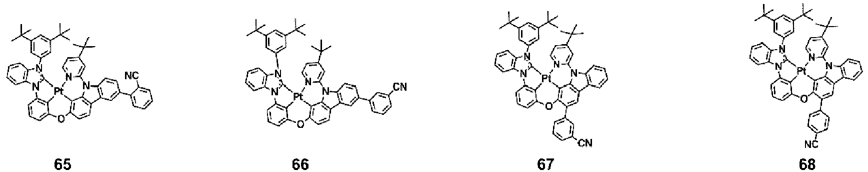

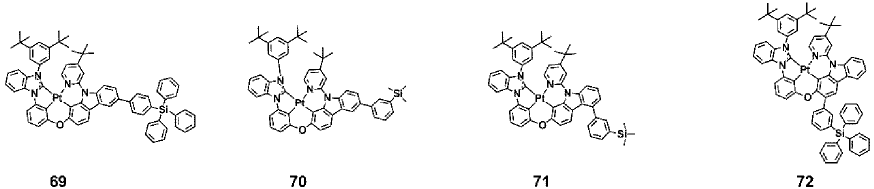

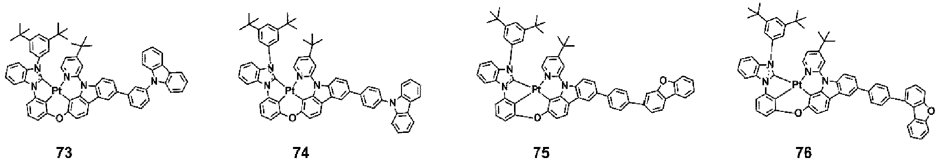

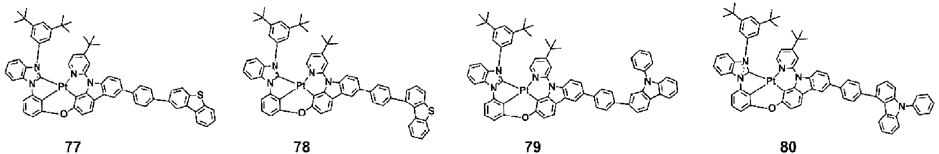

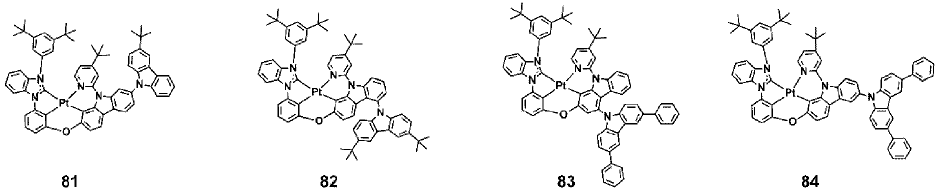

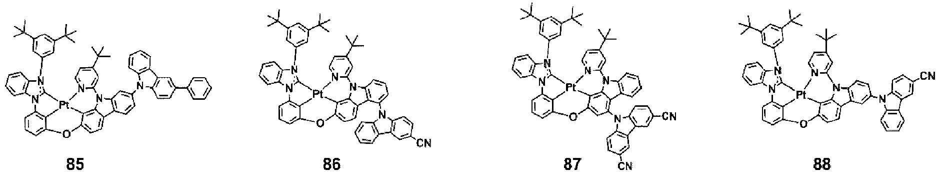

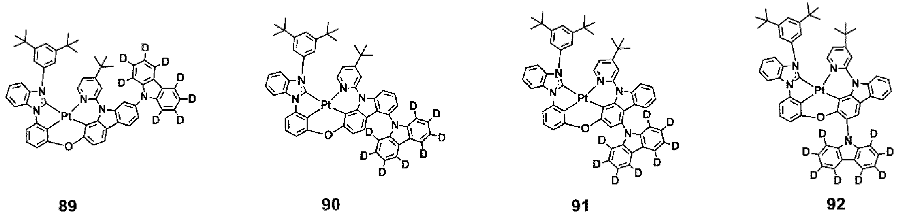

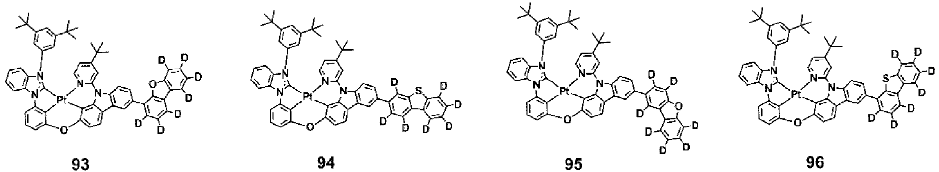

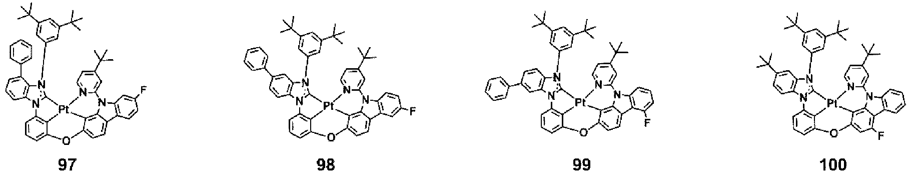

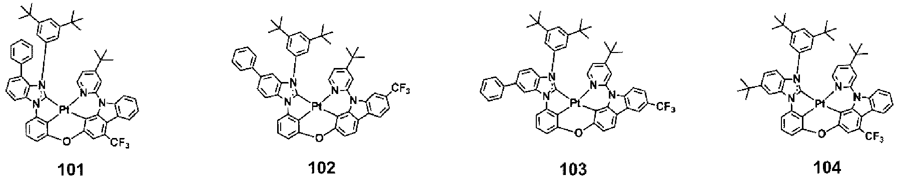

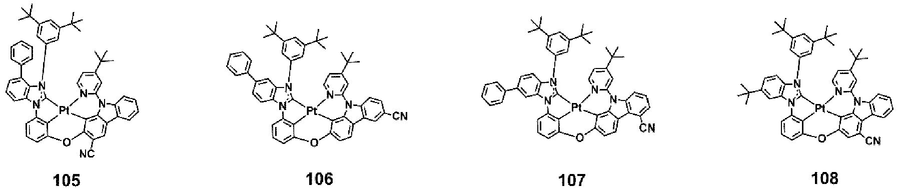

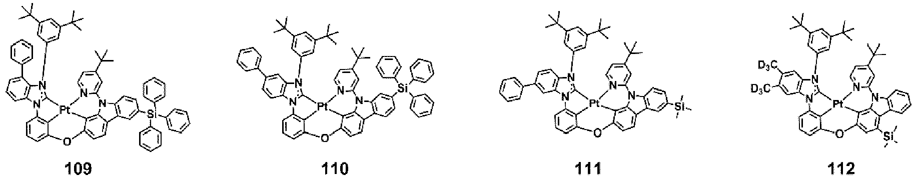

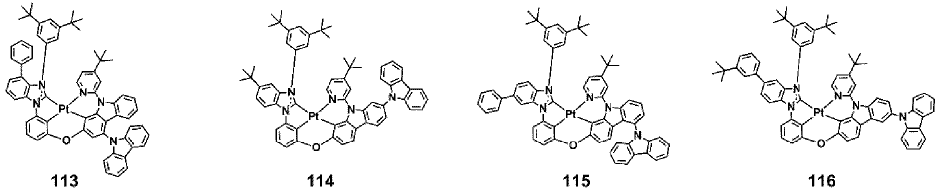

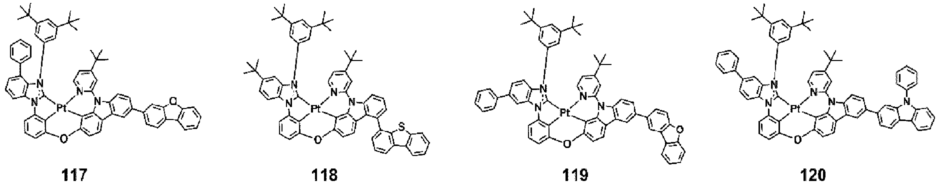

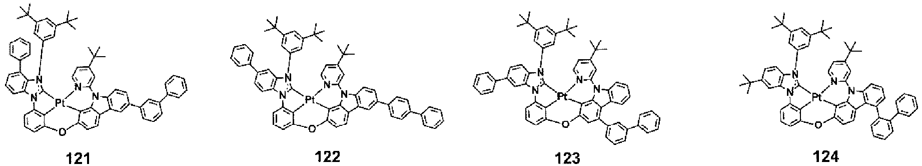

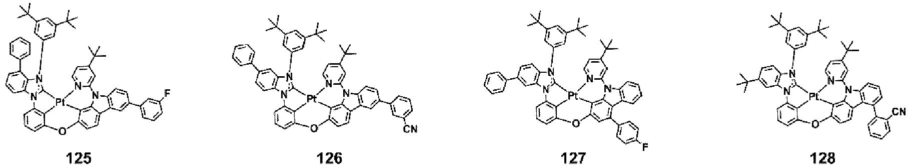

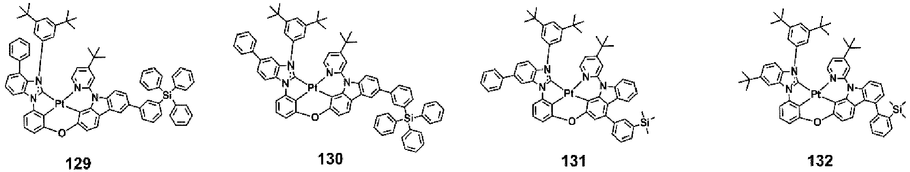

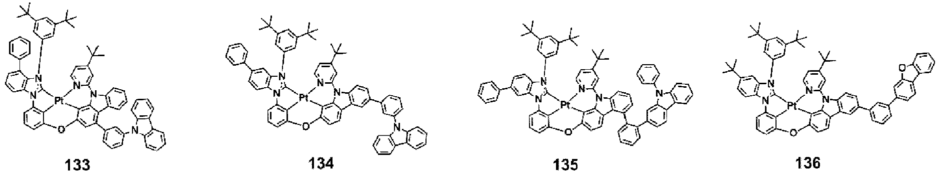

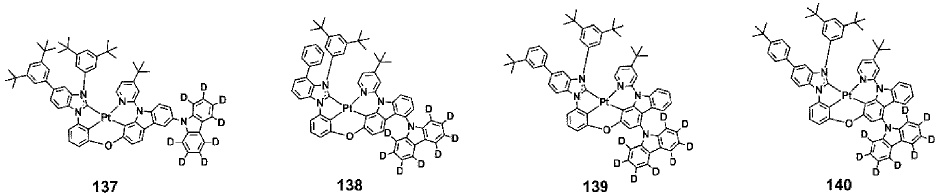

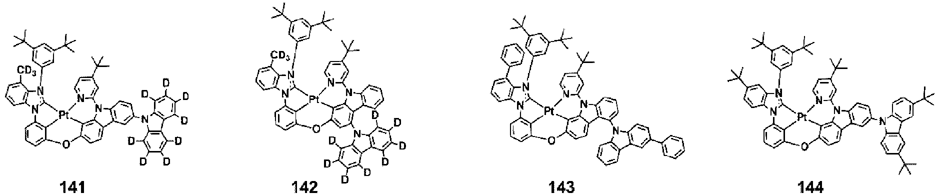

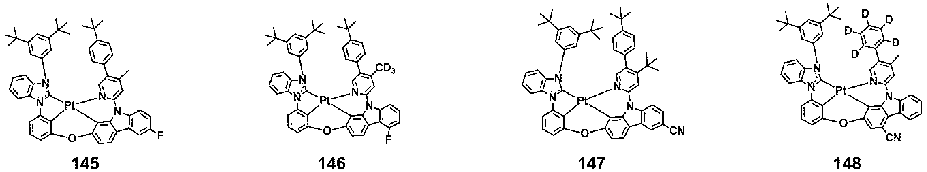

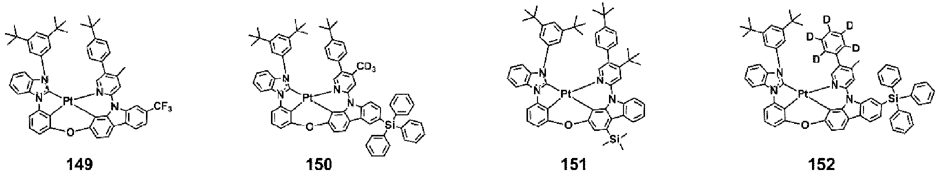

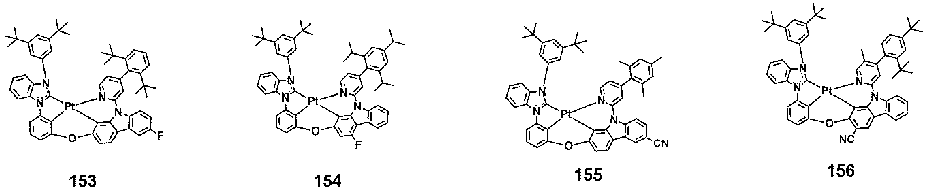

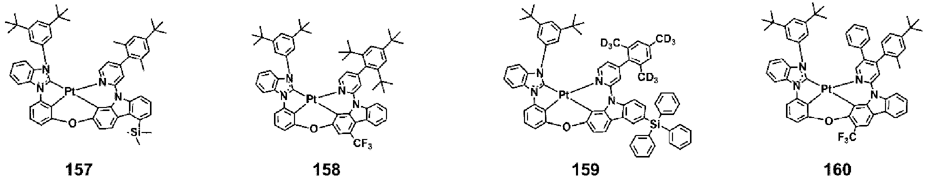

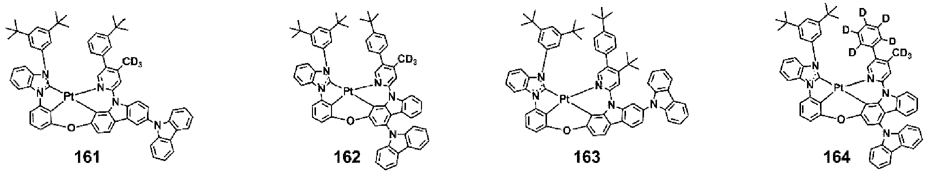

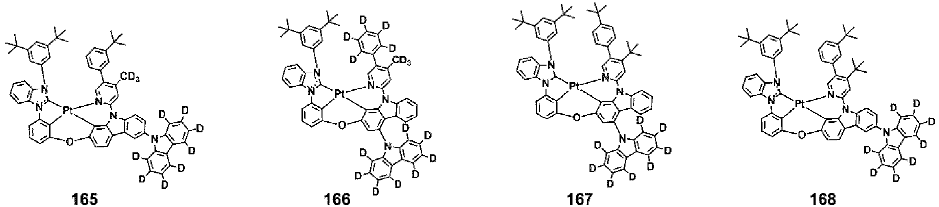

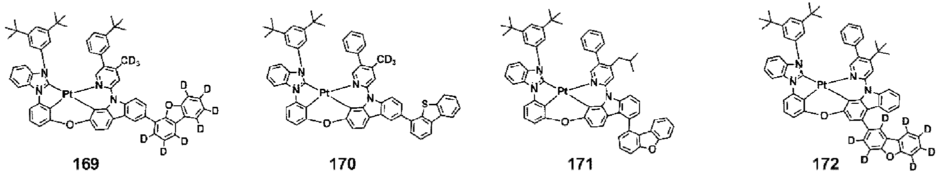

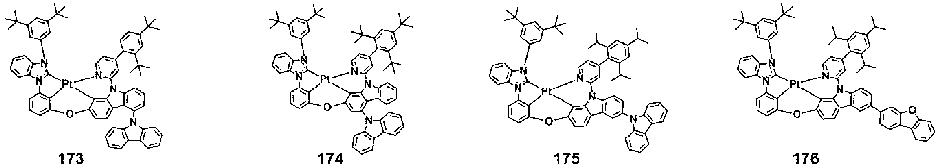

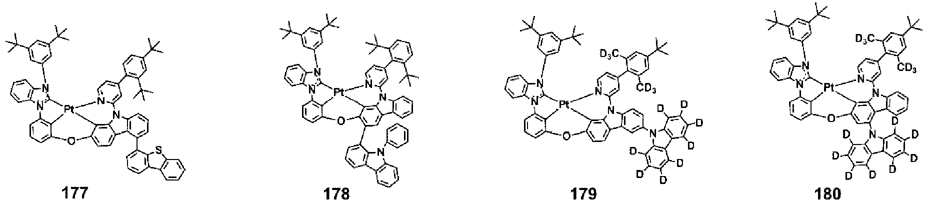

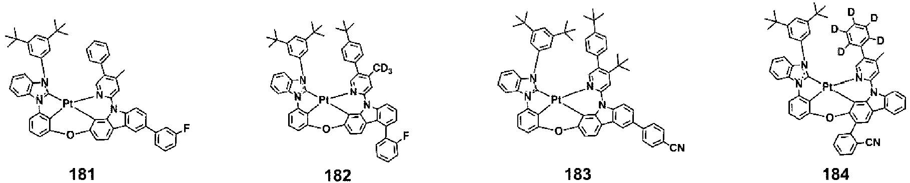

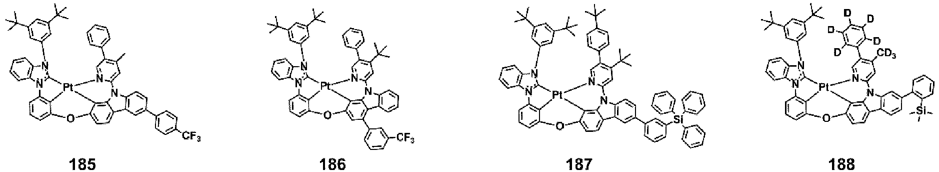

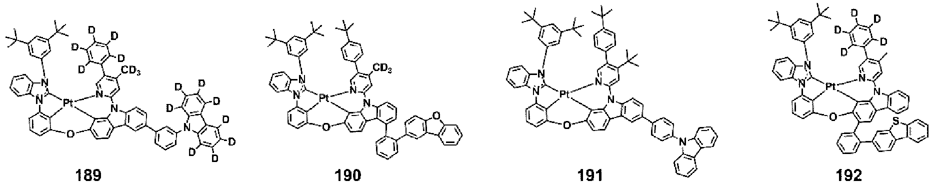

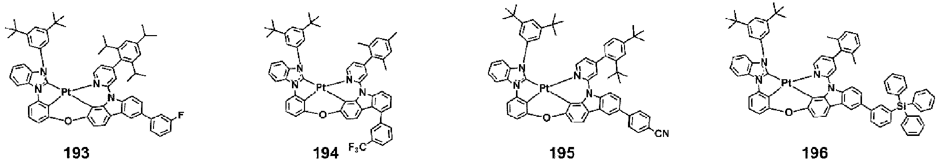

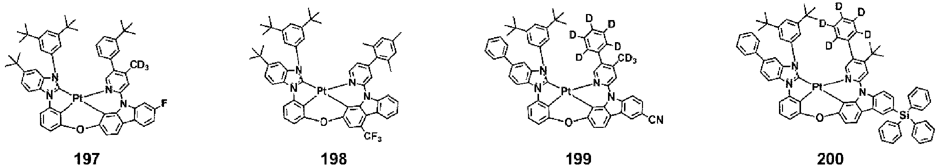

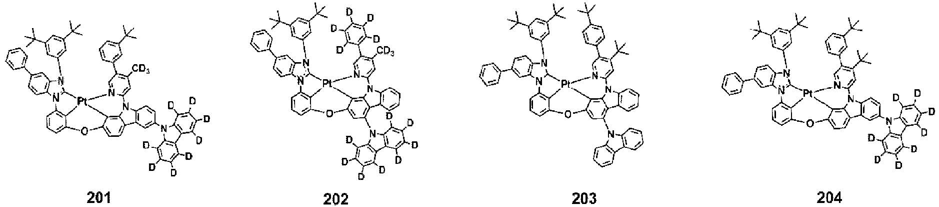

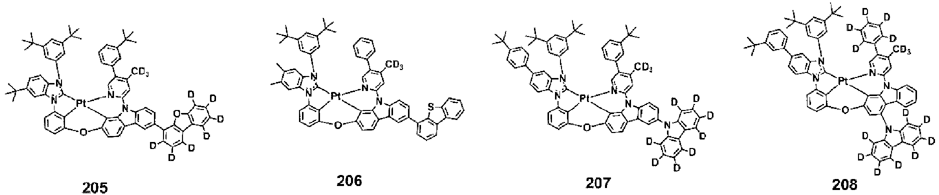

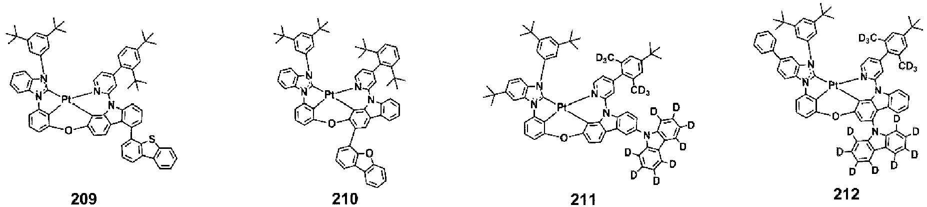

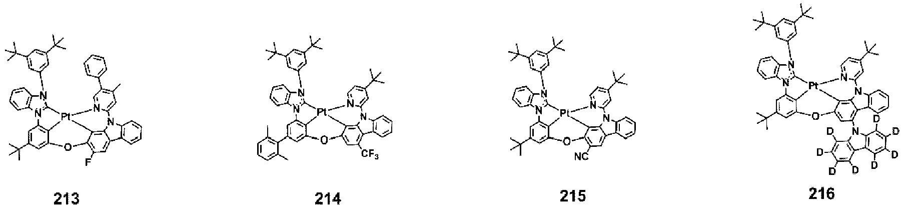

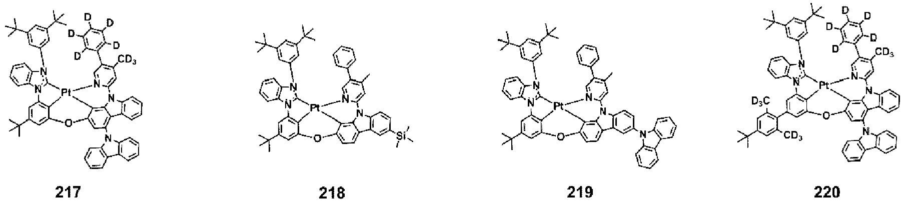

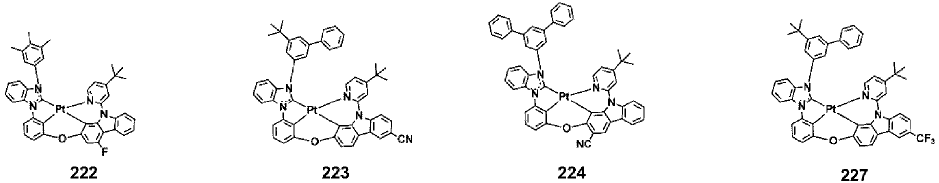

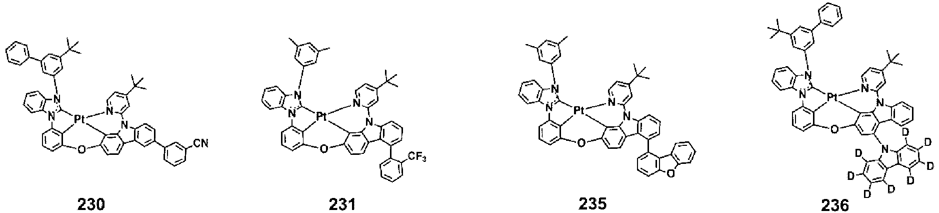

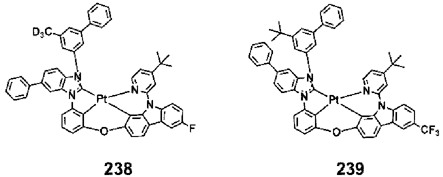

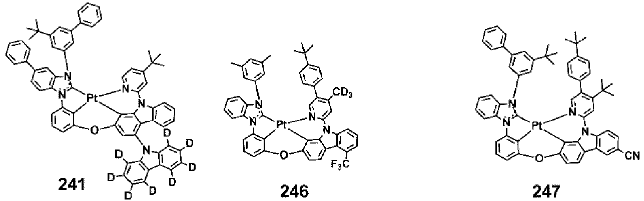

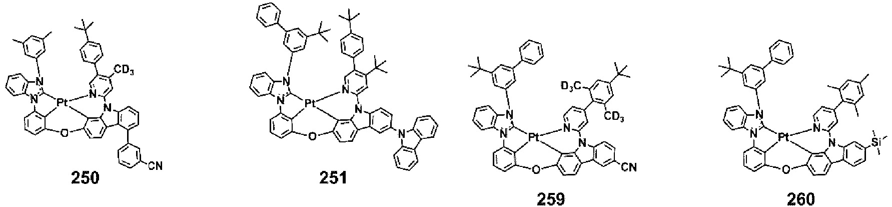

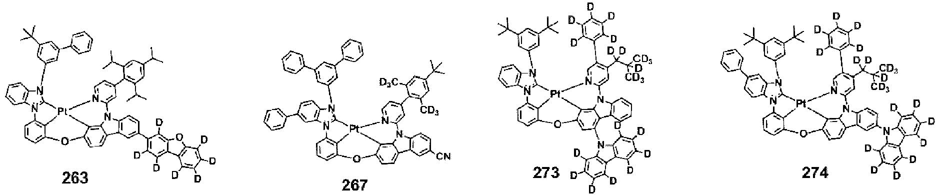

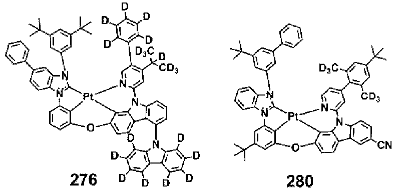

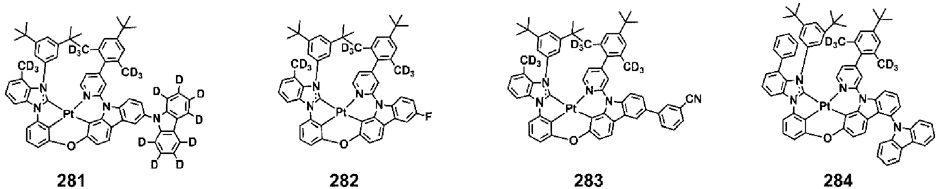

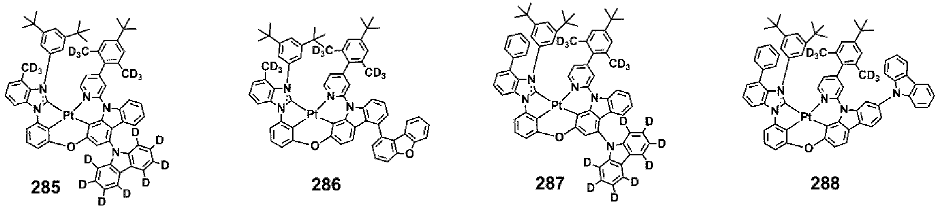

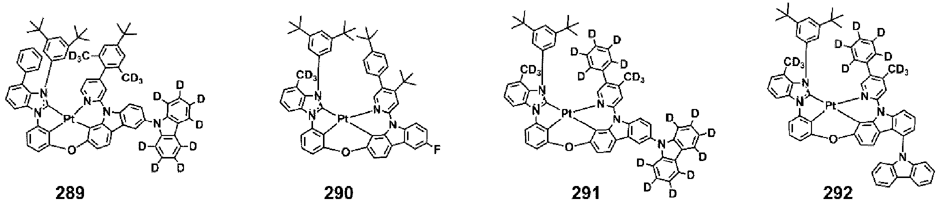

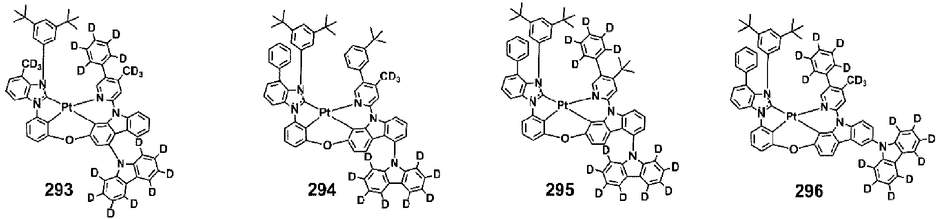

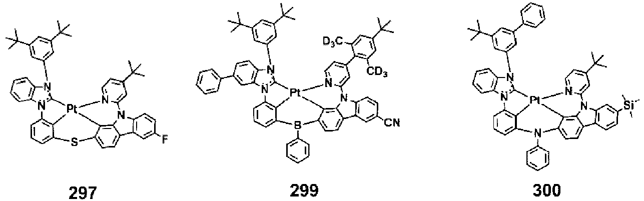

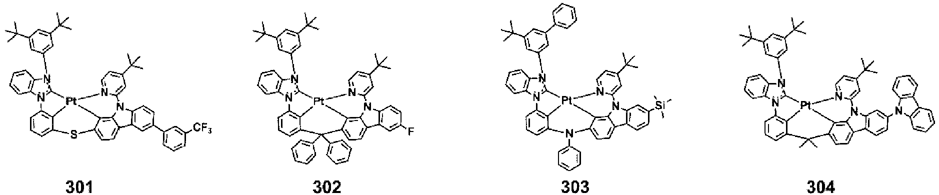

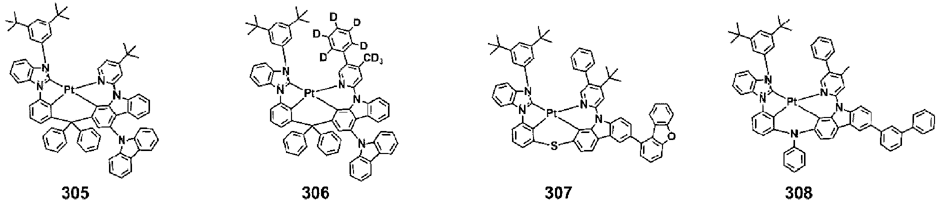

8. Dispositif électroluminescent organique, comprenant :
une première électrode ;
une seconde électrode ; et
une couche organique située entre la première électrode et la seconde électrode,
dans lequel la couche organique comprend une couche d'émission ; et
dans lequel la couche organique comprend en outre au moins un composé organométallique de l'une quelconque des revendications 1 à 7 ;

9. Dispositif électroluminescent organique de la revendication 8, dans lequel la couche d'émission comprend l'au moins un composé organométallique.

10. Dispositif électroluminescent organique de la revendication 9, dans lequel la couche d'émission comprend en outre un hôte, et une teneur de l'hôte dans la couche d'émission est supérieure à une teneur de l'au moins un composé organométallique dans la couche d'émission ; et/ou
dans lequel la couche d'émission émet une lumière bleue présentant une longueur d'onde d'émission maximale dans une plage de 410 nanomètres à 490 nanomètres.

11. Dispositif électroluminescent organique des revendications 9 ou 10, dans lequel
la couche d'émission comprend en outre un dopant fluorescent,
dans lequel le dopant fluorescent est différent de l'au moins un composé organométallique, et
au moins 80 % ou plus de l'émission totale de la couche d'émission est émise par le dopant fluorescent ;
de préférence dans lequel le dopant fluorescent comprend un composé représenté par la formule 503-1 ou la formule 503-2 : 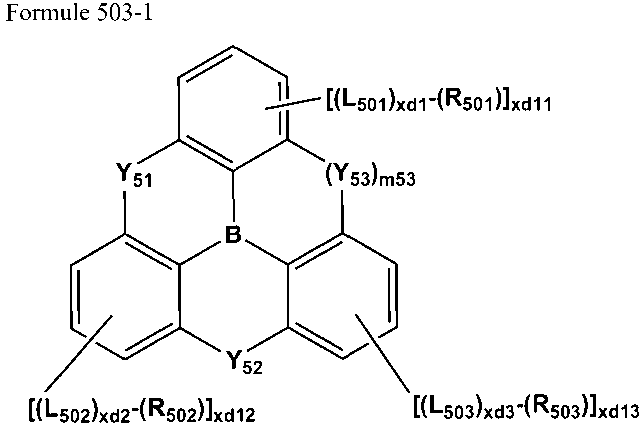 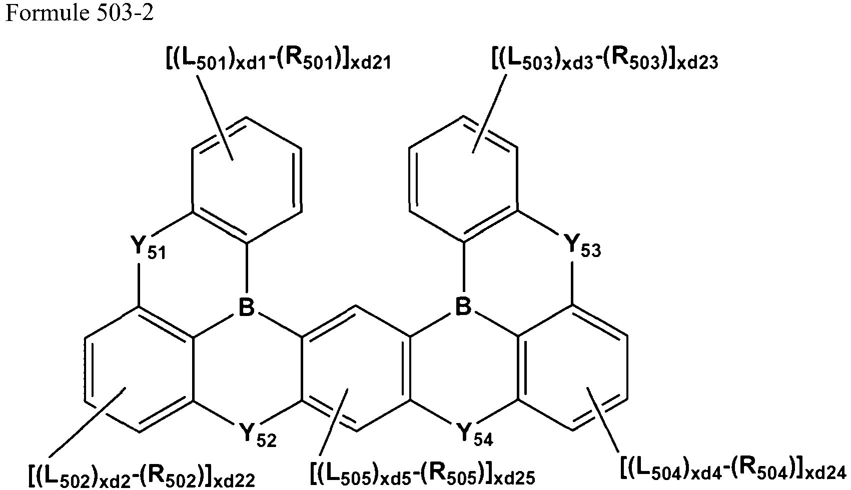
dans lequel, dans les Formules 503-1 et 503-2,
Y₅₁ à Y₅₄ sont chacun indépendamment une liaison simple, O, S, N[(L₅₀₆)_{xd6} -R₅₀₆], C[(L₅₀₆)_{xd6}-R₅₀₆][(L₅₀₇)_{xd7}-R₅₀₇] ou Si[(L₅₀₆)_{xd6}-R₅₀₆][(L₅₀₇)_{xd7}-R₅₀₇],
m53 est 0 ou 1,
L₅₀₁ à L₅₀₇ sont chacun indépendamment un groupe cycloalkylène en C₃ à C₁₀ substitué ou non substitué, un groupe hétérocycloalkylène en C₁ à C₁₀ substitué ou non substitué, un groupe cycloalcénylène en C₃ à C₁₀ substitué ou non substitué, un groupe hétérocycloalcénylène en C₁ à C₁₀ substitué ou non substitué, un groupe arylène en C₆ à C₆₀ substitué ou non substitué, un groupe hétéroarylène en C₁ à C₆₀ substitué ou non substitué, un groupe polycyclique condensé non aromatique divalent substitué ou non substitué ou un groupe hétéropolycyclique condensé non aromatique divalent substitué ou non substitué,
xd1 à xd7 sont chacun indépendamment 0, 1, 2 ou 3,
R₅₀₁ à R₅₀₇ sont chacun indépendamment :
un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₂₀, un groupe alcoxy en C₁-C₂₀ ou un groupe alkylthio en C₁-C₂₀ ;
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazole, un groupe triazinyle, un groupe dibenzofuranyle ou un groupe dibenzothiophényle ; ou
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, un groupe triazinyle, un groupe dibenzofuranyle ou un groupe dibenzothiophényle, chacun substitué par au moins un élément parmi un deutérium, -F, - Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci ; un groupe alkyle en C₁ à C₂₀, un groupe alcoxy en C₁ à C₂₀, un groupe alkylthio en C₁ à C₂₀, un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénanthrényle, un groupe anthracényle, un groupe pyrényle, un groupe chrysényle, un groupe pyridinyle, un groupe pyrazinyle, un groupe pyrimidinyle, un groupe pyridazinyle, un groupe quinolinyle, un groupe isoquinolinyle, un groupe quinoxalinyle, un groupe quinazolinyle, un groupe carbazolyle, un groupe triazinyle, un groupe dibenzofuranyle, un groupe dibenzothiophényle, ou une combinaison de ceux-ci,
lorsque m53 est 0, xd11 et xd13 sont chacun indépendamment 0, 1, 2, 3 ou 4,
lorsque m53 est 1, xd11 et xd13 sont chacun indépendamment 0, 1, 2, ou 3,
xd21 et xd23 sont chacun indépendamment 0, 1, 2, 3 ou 4,
xd12, xd22 et xd24 sont chacun indépendamment 0, 1, 2 ou 3,
xd25 est 0, 1 ou 2, et
deux parmi R₅₀₁ à R₅₀₇ ou plus sont éventuellement liés l'un à l'autre pour former un groupe carbocyclique en C₅ à C₃₀ substitué ou non substitué ou un groupe hétérocyclique en C₁ à C₃₀ substitué ou non substitué.

12. Appareil électronique, comprenant le dispositif électroluminescent organique de l'une quelconque des revendications 8 à 11.
